# EUROPEAN PATENT APPLICATION

(11) **EP 4 239 409 A1**
(43) Date of publication of application: **06.09.2023**
(21) Application number: 23156935.1
(22) Date of filing: 15.02.2023
(51) Int. Cl.: G03F 7/09

(54) **COMPOSITION FOR FORMING METAL OXIDE FILM, PATTERNING PROCESS, AND METHOD FOR FORMING METAL OXIDE FILM**

(30) Priority: 03.03.2022 JP 2022032998
(71) Applicant: Shin-Etsu Chemical Co., Ltd., Tokyo 100-0005 (JP)
(72) Inventor: Kobayashi, Naoki, Niigata (JP); Kori, Daisuke, Niigata (JP); Yano, Toshiharu, Niigata (JP)
(74) Representative: Sonnenhauser, Thomas Martin

(57) **Abstract**

The present invention is a composition for forming a metal oxide film, comprising (A) a metal oxide nanoparticle, (B) a flowability accelerator, which is a compound and/or a polymer having a molecular weight of 5000 or less represented by one or more selected from the following general formulae (I), (II) and (III), and (C) an organic solvent, wherein a weight ratio of the (A) metal oxide nanoparticle to the (B) flowability accelerator is 10/90 to 90/10. This makes it possible to provide a composition for forming a metal oxide film having excellent dry etching resistance relative to a previously-known organic underlayer film composition and also has high filling and planarizing properties, a patterning process using the composition, and a method for forming a metal oxide film (resist underlayer film).

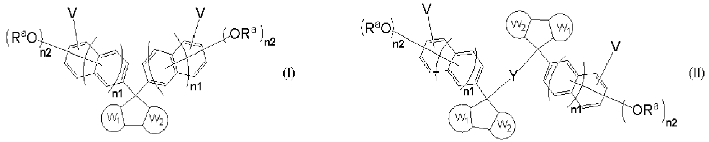

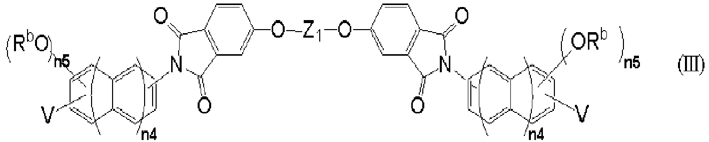

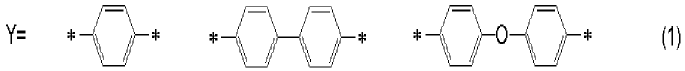

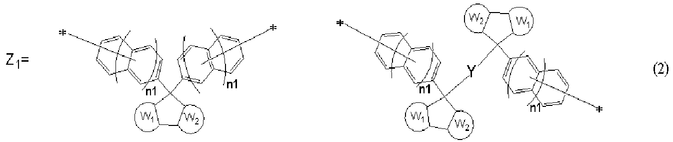

## Description

### TECHNICAL FIELD

The present invention relates to a composition for forming a metal oxide film that can be used for fine patterning by way of a multilayer resist method in a semiconductor apparatus manufacturing process, a patterning process using the composition, and a method for forming a metal oxide film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching using a pattern-formed photoresist film as an etching mask. In practice, however, there is no dry etching method capable of providing an absolute etching selectivity between the photoresist film and the substrate to be processed. The photoresist film is thus also damaged and collapses during processing the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin shifted to a novolak resin, polyhydroxystyrene, and a resin having an aliphatic polycyclic skeleton as the exposure light shifted from i-line to KrF and ArF, which have shorter wavelength. However, this shift actually accelerated an etching rate under dry etching condition for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching using the resist upper layer film pattern as a dry etching mask; the pattern is further transferred to the substrate to be processed by dry etching using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition that is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1.

On the other hand, in recent years, with the rapid miniaturization of DRAM memory, there is a growing need for further improvement in dry etching resistance, as well as a need for a resist underlayer film having excellent filling and planarizing properties. As a coating-type organic underlayer film composition excellent in filling and planarizing properties, for example, the composition disclosed in Patent Document 2 has been reported. However, in view of application of this composition in the advanced generation, there is a concern about dry etching resistance. The application limit of the previously-known coating-type organic underlayer film composition is thus approaching.

In view of the problematic dry etching resistance of the coating-type organic resist underlayer film composition, a method of using a metal oxide film as the resist underlayer film is drawing attention. However, when only a metal oxide material is used, the flowability is insufficient, and it is difficult to perform high-level filling and planarization.
Therefore, a composition to which an organic material is added in order to increase the flowability is preferable. Compositions obtained by adding an organic material to a metal oxide compound are reported in Patent Document 3 and Patent Document 4. Although the filling and planarizing properties are not mentioned, the metal oxide dicarboxylate used in Patent Document 3 and the metal oxide compound used in Patent Document 4 have large thermal shrinkage and induce remarkable deterioration of filling, and thus there is a concern that they are insufficient as a resist underlayer film composition for which high planarizing and filling properties are required.

On the other hand, a composition for forming a metal oxide film obtained by adding a high-carbon polymer to metal oxide nanoparticles has been proposed (Patent Document 5). It is reported that the filling property of a metal oxide compound is improved by using metal oxide nanoparticles having small thermal shrinkage with respect to the metal oxide compound. Further, although addition of a high-carbon polymer as a flowability accelerator for metal oxide nanoparticles has been proposed, the high-carbon polymer has insufficient thermal flowability, and there is a concern that the planarizing property may be insufficient in the advanced generation in which high planarization of a fine structure pattern is required.

Examples of organic material having excellent dry etching resistance and thermal flowability include a material having a fluorene skeleton. Patent Document 6 reports a curable composition obtained by adding a fluorene compound having an oxirane ring and/or a thiirane ring at the terminals to metal oxide nanoparticles. Although dry etching resistance is not mentioned, a fluorene compound having an oxirane ring and/or a thiirane ring has insufficient curability and heat resistance, and there is a concern that the excellent dry etching resistance derived from the metal oxide nanoparticles may be significantly deteriorated.

### CITATION LIST

### PATENT LITERATURE

Patent Document 1: JP 2004-205685 A
Patent Document 2: JP 6714493 B2
Patent Document 3: JP 6342998 B2
Patent Document 4: JP 5756134 B2
Patent Document 5: JP 7008075 B2
Patent Document 6: JP 6587516 B2

### SUMMARY OF INVENTION

### TECHNICAL PROBLEM

The present invention has been made in view of the above circumstances, and an object thereof is to provide a composition for forming a metal oxide film having excellent dry etching resistance relative to a previously-known organic underlayer film composition and also has high filling and planarizing properties, a patterning process using the composition, and a method for forming a metal oxide film (resist underlayer film).

### SOLUTION TO PROBLEM

In order to achieve the above object, the present invention provides a composition for forming a metal oxide film that can be used as a resist underlayer film composition for use in a multilayer resist method, the composition for forming a metal oxide film comprising:
(A) a metal oxide nanoparticle, (B) a flowability accelerator, which is a compound and/or a polymer having a molecular weight of 5000 or less represented by one or more selected from the following general formulae (I), (II) and (III), and (C) an organic solvent, wherein the weight ratio of the (A) metal oxide nanoparticle to the
(B) flowability accelerator is 10/90 to 90/10, 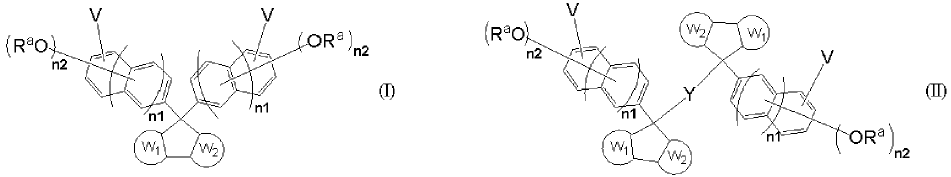 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} is a hydrogen atom, a saturated hydrocarbon group having 1 to 10 carbon atoms, or an unsaturated hydrocarbon group having 2 to 10 carbon atoms; Y is a group represented by the following general formula (1); n1 is 0 or 1; n2 is 1 or 2; and V independently represents a hydrogen atom or a connection portion, 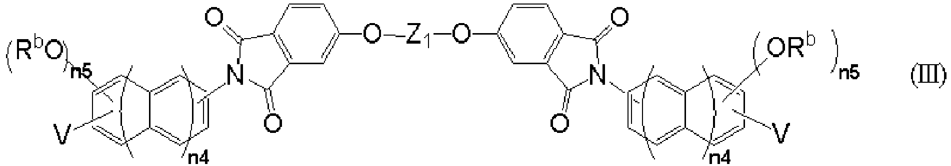 wherein Z₁ is a group represented by the following general formula (2); R^{b} is a hydrogen atom, a saturated hydrocarbon group having 1 to 10 carbon atoms, or an unsaturated hydrocarbon group having 2 to 10 carbon atoms; n4 is 0 or 1; n5 is 1 or 2; and V independently represents a hydrogen atom or a connection portion, 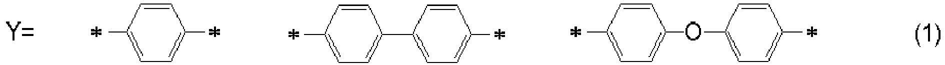 wherein * represents a bonding arm, 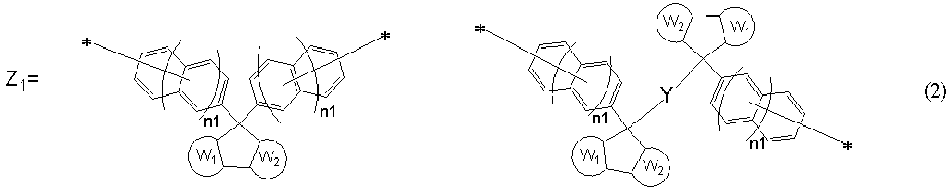 wherein, W₁, W₂, Y, and n1 are as defined above.

The composition for forming a metal oxide film described above contains a flowability accelerator excellent both in dry etching resistance and flowability. Therefore, it is possible to provide a composition for forming a metal oxide film that is capable of maximally exhibiting excellent dry etching resistance derived from metal oxide nanoparticles and that can be used as a resist underlayer film composition having both high planarizing and filling properties, which have been difficult to achieve by metal oxide nanoparticles alone. In addition, when the composition for forming a metal oxide film has a ratio of (A) to (B) in this range, various physical properties required when the composition is used for a resist underlayer film, such as filling and planarizing properties, dry etching resistance, and the like can be adjusted within an appropriate range.

The (A) metal oxide nanoparticle is preferably one or more kinds of oxide nanoparticles of metals selected from the group consisting of zirconium, hafnium, aluminum, tungsten, titanium, copper, tin, cerium, indium, zinc, yttrium, lanthanum, chromium, cobalt, platinum, iron, antimony, and germanium.

By using such metal oxide nanoparticles, it is possible to prepare a composition for forming a metal oxide film excellent in dispersibility/stability of metal nanoparticles.

The (A) metal oxide nanoparticle is preferably one or more selected from the group consisting of zirconium oxide nanoparticles, hafnium oxide nanoparticles, tungsten oxide nanoparticles, titanium oxide nanoparticles, and tin oxide nanoparticles.

By using such metal oxide nanoparticles, it is possible to form a resist underlayer film having excellent etching resistance.

The (A) metal oxide nanoparticle preferably has an average primary particle size of 100 nm or less.

By using such metal oxide nanoparticles, it is possible to prepare a composition for forming a metal oxide film excellent in dispersibility/flowability of metal nanoparticles.

The (B) flowability accelerator is preferably a compound represented by one or more selected from the following general formulae (3), (4) and (5), 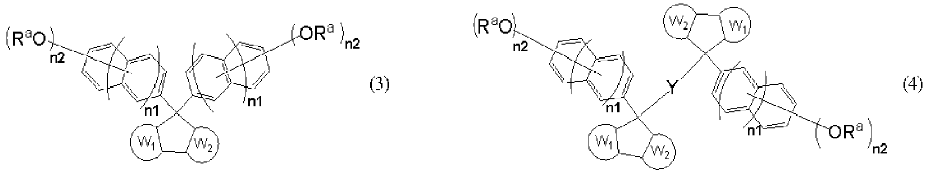 wherein W₁, W₂, R^{a}, Y, n1 and n2 are as defined above, 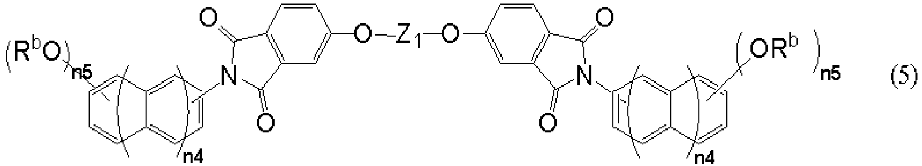 wherein Z₁, R^{b}, n4 and n5 are as defined above.

When the (B) flowability accelerator is a compound represented by one or more selected from the following general formulae (3), (4) and (5) above, due to its excellent heat resistance, the compound may be solely used as a thermal flowability accelerator. With such an excellent thermal flowability as compared with a high molecular weight compound, excellent filling and planarizing properties with respect to a pattern substrate are also ensured.

The (B) flowability accelerator is preferably a polymer with a repeating unit represented by one or more selected from the following general formulae (6), (7) and (8), 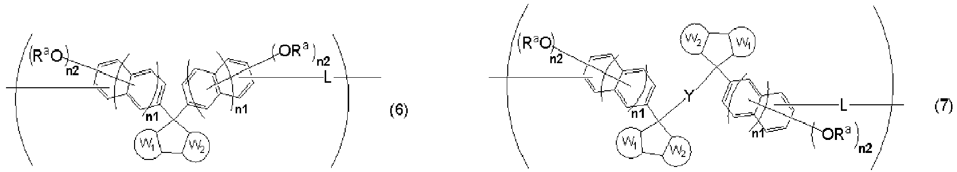 wherein W₁, W₂, R^{a}, Y, n1 and n2 are as defined above, and L is a divalent organic group having 1 to 40 carbon atoms, 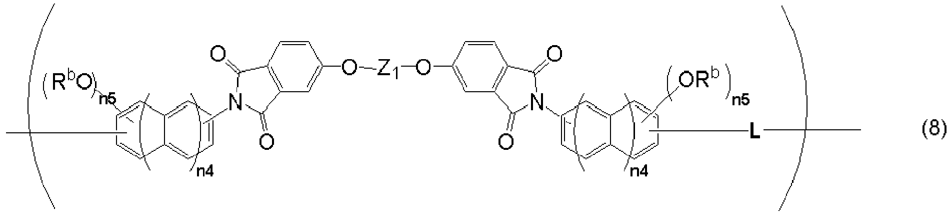 wherein Z₁, R^{b}, n4 and n5 are as defined above, and L is a divalent organic group having 1 to 40 carbon atoms.

By using the polymer with a repeating unit represented by one or more selected from the following general formulae (6), (7) and (8) as the flowability accelerator, a composition for forming a metal oxide film which does not cause deterioration of etching resistance, and which thereby can form a dense metal oxide film by enhancing curability, and is thus excellent in film forming property regardless of dependency on a substrate material and a shape, can be obtained.

The composition for forming a metal oxide film preferably contains, as the component (B), one or more compounds represented by the following general formulae (3) to (5) and one or more polymers having repeating structural units represented by the following general formulae (6) to (8), 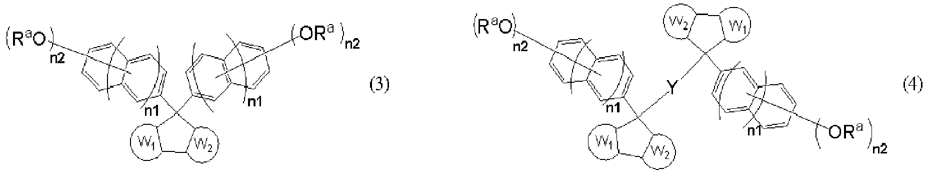 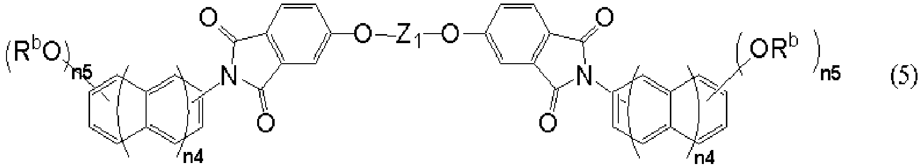 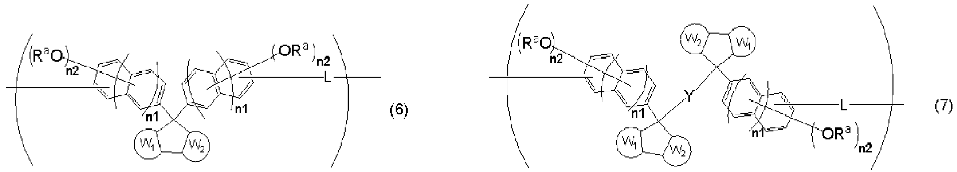 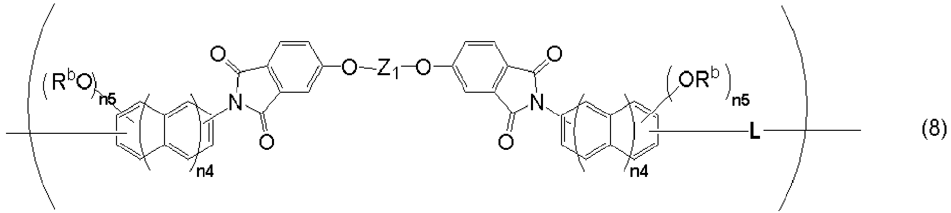 wherein W₁, W₂, R^{a}, Y, n1, n2, Z₁, R^{b}, n4 and n5 are as defined above, and L is a divalent organic group having 1 to 40 carbon atoms.

When such a mixture is used as the flowability accelerator, various physical properties required when used to form a metal oxide film, such as filling and planarizing properties, film forming property, outgassing caused by sublimate, and the like, can be adjusted within an appropriate range.

R^{a} in the general formulae (I) and (II) and R^{b} in the general formula (III) are each preferably a hydrogen atom or a structure represented by the following general formula (9), 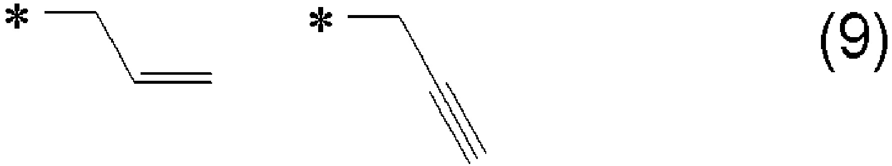 wherein * represents a portion bonded with an oxygen atom.

When the flowability accelerator has both of the hydroxyl group and the crosslinking group represented by the general formula (9) above, it is possible to form a metal oxide film having both excellent thermal flowability and substrate adhesiveness.

Among R^{a} and R^{b} above, when the proportion of hydrogen atom is "a" and the proportion of the structure represented by the general formula (9) is "b", the component (B) as a whole preferably satisfies the relationships: a+b=1 and 0.2^b^0.8.

When the contents of the hydroxyl group and the crosslinking group represented by the general formula (9) are within the above ranges, various physical properties required when used to form a metal oxide film, such as filling and planarizing properties, dry etching resistance, substrate adhesiveness, and the like, can be adjusted within an appropriate range.

The ratio Mw/Mn (i.e., dispersity), which is a ratio of the weight average molecular weight Mw to the number average molecular weight Mn on polystyrene basis according to gel permeation chromatography, of one or more compounds selected from the general formulae (3), (4) and (5) above is preferably in the range of 1.00≦Mw/Mn≦1.25 for each compound.

With the composition for forming a metal oxide film containing a compound having such a range of dispersity, the flowability accelerator exhibits more excellent thermal flowability. Thus, when it is incorporated in the composition for forming a metal oxide film, it is possible to not only desirably fill a fine structure formed on the substrate but also form a resist underlayer film with the entire substrate planarized.

The L is preferably a divalent organic group represented by the following general formula (10), 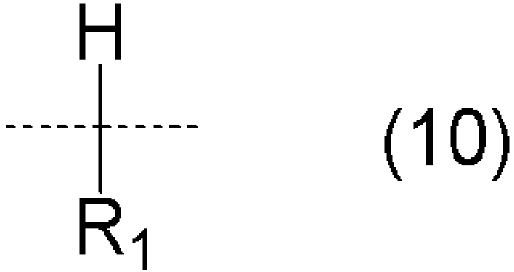 wherein R₁ is a hydrogen atom or an organic group with an aromatic ring having 6 to 20 carbon atoms, and the dashed line represents a bonding arm.

By constituting the repeating units with such a linkage group L, curability, etching resistance, and other characteristics can be improved.

The weight average molecular weight on polystyrene basis according to gel permeation chromatography of the polymer represented by one or more selected from the general formulae (6), (7) and (8) above is preferably 1000 to 5000.

The composition for forming a metal oxide film containing a polymer having such a range of weight average molecular weight, the solubility in an organic solvent is not impaired, and outgassing during baking can be suppressed.

The (C) organic solvent is preferably a mixture of one or more organic solvents having a boiling point of lower than 180°C and one or more organic solvents having a boiling point of 180°C or higher.

When the organic solvent above is the mixture described above, thermal flowability is imparted to the compound and/or the polymer by the addition of the high boiling point solvent, and thus the composition for forming a metal oxide film has both high filling and planarizing properties.

The composition for forming a metal oxide film preferably further contains one or more of a crosslinking agent, a surfactant, an acid generator, a plasticizer, and a blend polymer.

The composition for forming a metal oxide film containing these additives is more excellent in coatability, dry etching resistance, and filling and planarizing properties.

The blend polymer is preferably a polymer containing the following general formula (BP), 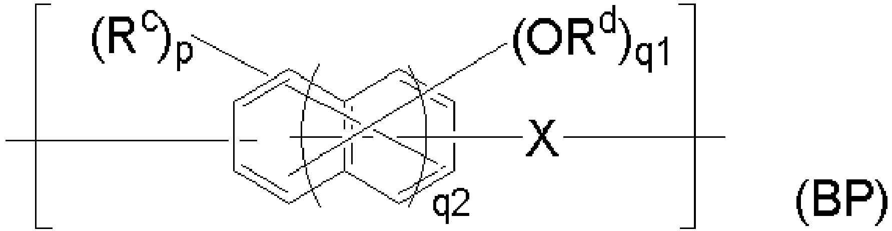 wherein R^{c} is a saturated or unsaturated monovalent organic group having 1 to 10 carbon atoms; R^{d} is a hydrogen atom, a saturated hydrocarbon group having 1 to 10 carbon atoms, or an unsaturated hydrocarbon group having 2 to 10 carbon atoms; X is a divalent organic group having 1 to 30 carbon atoms; "p" is an integer of 0 to 5; q1 is an integer of 1 to 6; p+q1 is an integer of 1 or more and 6 or less; and q2 is 0 or 1.

By adding the blend polymer described above, the filling and planarizing properties are further improved.

Further, the present invention provides a patterning process for forming a pattern in a substrate to be processed, comprising the steps of:
(I-1) applying the composition for forming a metal oxide film onto a substrate to be processed, followed by heating to form a metal oxide film;
(I-2) forming a resist upper layer film on the metal oxide film by using a photoresist material;
(I-3) subjecting the resist upper layer film to pattern exposure and then development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern in the substrate to be processed.

The patterning process by way of the two-layer resist process makes it possible to form fine patterns on the body to be processed (substrate to be processed).

Further, the present invention provides a patterning process for forming a pattern in a substrate to be processed, comprising the steps of:
(II-1) applying the composition for forming a metal oxide film onto a substrate to be processed, followed by heating to form a metal oxide film;
(II-2) forming a silicon-containing resist middle layer film on the metal oxide film by using a material for a silicon-containing resist middle layer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal oxide film by dry etching while using the resist middle layer film having the transferred pattern as a mask; and
(II-7) processing the substrate to be processed while using the metal oxide film having the formed pattern as a mask to form the pattern in the substrate to be processed.

The patterning process by way of the three-layer resist process makes it possible to form fine patterns on the body to be processed with a high degree of accuracy.

Further, the present invention provides a patterning process for forming a pattern in a substrate to be processed, comprising the steps of:
(III-1) applying the composition for forming a metal oxide film onto a substrate to be processed, followed by heating to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern in the substrate to be processed.

The patterning process by way of the four-layer resist process makes it possible to form fine patterns on the body to be processed with a high degree of accuracy.

Further, the present invention provides a patterning process for forming a pattern in a substrate to be processed, comprising the steps of:
(IV-1) forming a resist underlayer film on a substrate to be processed;
(IV-2) forming a resist middle layer film, or a combination of an inorganic hard mask middle layer film selected from a silicon oxide film, a silicon nitride film, and a silicon oxynitride film and an organic thin film on the resist underlayer film;
(IV-3) forming a resist upper layer film on the resist middle layer film, or the combination of the inorganic hard mask middle layer film and the organic thin film by using a photoresist material;
(IV-4) subjecting the resist upper layer film to pattern exposure and then development with a developer to form a pattern in the resist upper layer film;
(IV-5) transferring a pattern to the resist middle layer film or the organic thin film and the inorganic hard mask middle layer film by dry etching while using the resist upper layer film having the formed pattern as a mask;
(IV-6) transferring a pattern to the resist underlayer film by dry etching while using the resist middle layer film or the inorganic hard mask middle layer film having the transferred pattern as a mask;
(IV-7) applying the composition for forming a metal oxide film onto the resist underlayer film having the formed pattern, followed by heating to cover the resist underlayer film with a metal oxide film, thereby filling a space between the resist underlayer film patterns with the metal oxide film;
(IV-8) etching back the metal oxide film covering the resist underlayer film having the formed pattern by a chemical stripper or dry etching to expose an upper surface of the resist underlayer film having the formed pattern;
(IV-9) removing the resist middle layer film or the hard mask middle layer film remaining on the upper surface of the resist underlayer film by dry etching;
(IV-10) removing the resist underlayer film having the formed pattern with its surface exposed by dry etching to form a reverse pattern of an original pattern in the metal oxide film;
(IV-11) processing the substrate to be processed while using the metal oxide film having the formed reversal pattern as a mask to form a tone-reversal pattern in the substrate to be processed.

The patterning process by way of the reverse process makes it possible to form fine patterns on the body to be processed with a higher degree of accuracy.

A substrate having a step or a structure with a height of 30 nm or more is preferably used as the substrate to be processed.

In the present invention, for example, the above-mentioned bodies can be used as the body to be processed.

The present invention also provides a method for forming a metal oxide film that serves as a planarizing film used in a semiconductor apparatus manufacturing process, the method including spin-coating a substrate to be processed with the composition for forming a metal oxide film; and heating the substrate coated with the composition for forming a metal oxide film at a temperature of 100°C or higher and 600°C or lower for 10 to 600 seconds to form a cured film.

The present invention also provides a method for forming a metal oxide film that serves as a planarizing film used in a semiconductor apparatus manufacturing process, the method including spin-coating a substrate to be processed with the composition for forming a metal oxide film; and heating the substrate coated with the composition for forming a metal oxide film under an atmosphere with an oxygen concentration of 1 volume % or more and 21 volume % or less to form a cured film.

Such a process accelerates the crosslinking reaction of the composition for forming a metal oxide film when the resist underlayer film is formed, thus highly suppressing mixing with the upper layer film. Moreover, appropriate adjustment of the heating temperature, the time, and the oxygen concentration within the above ranges allows the resist underlayer film to have filling, planarizing, and curing properties suitable for use.

The present invention also provides a method for forming a metal oxide film that serves as a planarizing film used in a semiconductor apparatus manufacturing process, the method including spin-coating a substrate to be processed with the composition for forming a metal oxide film; and heating the substrate coated with the composition for forming a metal oxide film under an atmosphere with an oxygen concentration of less than 1 volume % to form a cured film.

Such a process accelerates the crosslinking reaction of the composition for forming a metal oxide film when the resist underlayer film is formed without causing deterioration of a substrate to be processed even when the substrate to be processed contains a material unstable to heating in an oxygen atmosphere, thus highly and effectively suppressing mixing with the upper layer film.

### ADVANTAGEOUS EFFECTS OF INVENTION

As explained above, the composition for forming a metal oxide film, the patterning process, and the method for forming a resist underlayer film of the present invention are suitably used particularly in a multilayer resist process, including filling and planarization of a substrate to be processed having steps, irregularities, and are significantly useful in fine patterning for the manufacture of semiconductor apparatuses. Specifically, due to the incorporation of a flowability accelerator superior both in dry etching resistance and flowability, it is possible to provide a resist underlayer film composition that is capable of maximally exhibiting excellent dry etching resistance derived from metal oxide nanoparticles and that has both high planarizing and filling properties, which have been difficult to achieve by metal oxide nanoparticles alone. In particular, in a fine patterning process using a multilayer resist method in a semiconductor apparatus manufacturing process, even on a substrate to be processed having a portion where filling and planarization are difficult, such as portion with a dense fine pattern structure portion with a high aspect ratio typified by a DRAM memory under prosperous miniaturization, filling can be performed without causing defects such as voids and peeling; further, owing to remarkably high dry etching resistance relative to previously-known coating-type organic resist underlayer film compositions, a fine pattern can be formed on a body to be processed with a higher degree of accuracy.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the tone-reversal patterning process of the present invention.
FIG. 3 is an explanatory view of a method for evaluating the filling property.
FIG. 4 is an explanatory view of a method for evaluating the planarizing property.

### DESCRIPTION OF EMBODIMENTS

As described above, there has been a demand for a resist underlayer film composition that enables filling/planarization without causing defects such as voids and peeling even on a substrate to be processed having a portion where filling and planarization are difficult, such as portion with a dense fine pattern structure portion with a high aspect ratio typified by a DRAM memory under prosperous miniaturization in a fine patterning process using a multilayer resist method in a semiconductor apparatus manufacturing process, that has excellent dry etching resistance relative to previously-known coating-type organic resist underlayer film compositions, and that is capable of transferring a resist pattern onto a substrate to be processed with a higher degree of accuracy.

The present inventors have conducted intensive study to solve the above problems, and, as a result, investigated various resist underlayer film compositions and patterning process to enable high-level filling and planarization by the formation of an underlayer film as well as excellent dry etching resistance in a multilayer resist method using a resist underlayer film. As a result, the present inventors found that a patterning process using a composition for forming a metal oxide film containing metal oxide nanoparticles excellent in dry etching resistance, a flowability accelerator containing a compound/polymer having a specific structure, and an organic solvent is very effective. With this finding, the inventors completed the present invention.

Specifically, the present invention is a composition for forming a metal oxide film, comprising:
(A) a metal oxide nanoparticle, (B) a flowability accelerator, which is a compound and/or a polymer having a molecular weight of 5000 or less represented by one or more selected from the following general formulae (I), (II) and (III), and (C) an organic solvent, wherein the weight ratio of the (A) metal oxide nanoparticle to the
(B) flowability accelerator is 10/90 to 90/10, 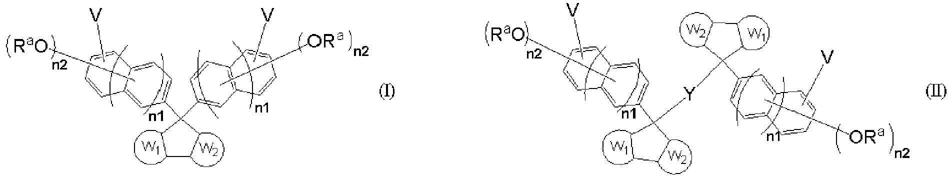 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} is a hydrogen atom, a saturated hydrocarbon group having 1 to 10 carbon atoms, or an unsaturated hydrocarbon group having 2 to 10 carbon atoms; Y is a group represented by the following general formula (1); n1 is 0 or 1; n2 is 1 or 2; and V independently represents a hydrogen atom or a connection portion, 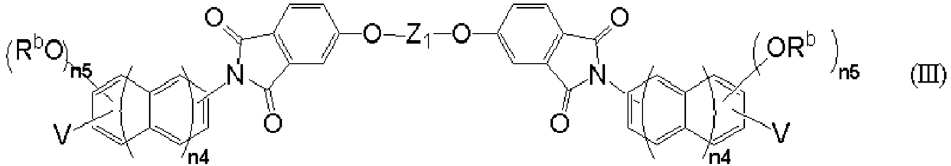 wherein Z₁ is a group represented by the following general formula (2); R^{b} is a hydrogen atom, a saturated hydrocarbon group having 1 to 10 carbon atoms, or an unsaturated hydrocarbon group having 2 to 10 carbon atoms; n4 is 0 or 1; n5 is 1 or 2; and V independently represents a hydrogen atom or a connection portion, 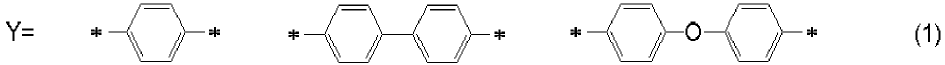 wherein * represents a bonding arm, 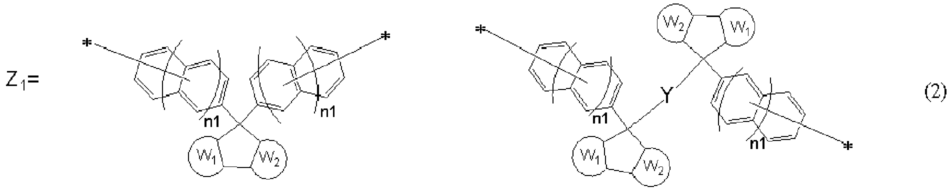 wherein, W₁, W₂, Y, and n1 are as defined above.

The present invention is described below in detail; however, the present invention is not limited to the examples described below.

### ▪ Composition for Forming a Metal Oxide Film

The composition for forming a metal oxide film of the present invention contains (A) metal oxide nanoparticles, (B) a flowability accelerator represented by a specific general formula, and (C) an organic solvent, which will be described later. The weight ratio of the (A) metal oxide nanoparticles to the (B) flowability accelerator is 10/90 to 90/10. The composition for forming a metal oxide film of the present invention may contain additives such as a surfactant, a crosslinking agent, and the like, as necessary. Hereinbelow, each component of the composition of the present invention is described.

### (A) Metal Oxide Nanoparticles

The (A) metal oxide nanoparticle contained in the composition for forming a metal oxide film of the present invention is preferably one or more kinds of oxide nanoparticles of metals selected from the group consisting of zirconium, hafnium, aluminum, tungsten, titanium, copper, tin, cerium, indium, zinc, yttrium, lanthanum, chromium, cobalt, platinum, iron, antimony, and germanium. Among these, zirconium oxide nanoparticles, hafnium oxide nanoparticles, tungsten oxide nanoparticles, titanium oxide nanoparticles, and tin oxide nanoparticles are preferable from the viewpoint of dispersibility and dry etching resistance.

By selecting such metal oxides, it is possible to form a metal oxide film excellent in dispersibility and dry etching resistance.

The (A) metal oxide nanoparticle described above preferably has an average primary particle size of 100 nm or less, more preferably 50 nm or less, even more preferably 30 nm or less, and particularly preferably 15 nm or less. The average primary particle size of the metal oxide nanoparticles before being dispersed in an organic solvent can be determined by a method of directly measuring the size of primary particles from an electron micrograph. Specifically, the minor axis diameter and the major axis diameter of each primary particle are measured, and the average of the values is defined as the particle size of the particle. Then, for 100 or more particles, the volume (mass) of each particle is approximated to a cuboid of the determined particle size, and this volume average particle size is determined as the average particle size. Identical results can be obtained when any of a transmission type electron microscope (TEM), a scanning type electron microscope (SEM), and a scanning transmission type electron microscope (STEM) are used.

With such a particle size range, desirable dispersibility in the composition for forming a metal oxide film can be ensured, and it is possible to form a metal oxide film excellent in filling and planarizing properties in a dense fine pattern structure portion.

As the (A) metal oxide nanoparticles contained in the composition for forming a metal oxide film of the present invention, commercially-available metal oxide nanoparticles can be used.

Examples of titania nanoparticles include TTO series (TTO-51 (A), TTO-51 (C), and the like), TTO-S and V series (TTO-S-1, TTO-S-2, TTO-V-3, and the like) manufactured by Ishihara Sangyo Kaisha, Ltd., MT series (MT-01, MT-05, MT-100SA, MT-500SA, NS405, and the like) manufactured by Tayca Corporation, STR-100A-LP manufactured by Sakai Chemical Industry Co., Ltd., and the like.

Examples of zirconia nanoparticles include PCS (manufactured by Nippon Denko Co., Ltd.), JS-01, JS-03, and JS-04 (manufactured by Nippon Denko Co., Ltd.), UEP, UEP-50, and UEP-100 (manufactured by Daiichi Kigenso Kagaku Kogyo Co., Ltd.), PCPB-2-50-PGA and PCPA-2-502-PGA (manufactured by Pixelligent Technologies LLC), ZrO₂ nanoparticles 915505 (manufactured by Sigma-Aldrich Co. LLC), and the like.

Only one kind or a combination of two or more kinds of the (A) metal oxide nanoparticles contained in the composition for forming a metal oxide film of the present invention may be used. Any combination can be selected according to the required performance. The component (A) may be used in an amount of 11 to 900 parts by mass per 100 parts by mass of the flowability accelerator in the composition.

### (B) Flowability Accelerator

The composition for forming a metal oxide film of the present invention contains a flowability accelerator, which is a compound and/or a polymer having a molecular weight of 5000 or less represented by one or more selected from the following general formulae (I), (II) and (III). 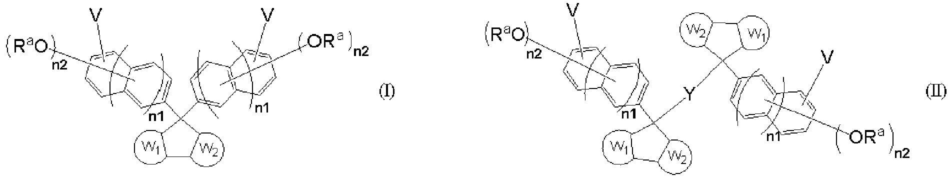 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} is a hydrogen atom, a saturated hydrocarbon group having 1 to 10 carbon atoms, or an unsaturated hydrocarbon group having 2 to 10 carbon atoms; Y is a group represented by the following general formula (1); n1 is 0 or 1; n2 is 1 or 2; and V independently represents a hydrogen atom or a connection portion, 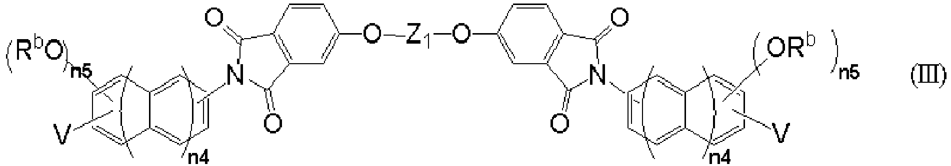 wherein Z₁ is a group represented by the following general formula (2); R^{b} is a hydrogen atom, a saturated hydrocarbon group having 1 to 10 carbon atoms, or an unsaturated hydrocarbon group having 2 to 10 carbon atoms; n4 is 0 or 1; n5 is 1 or 2; and V independently represents a hydrogen atom or a connection portion, 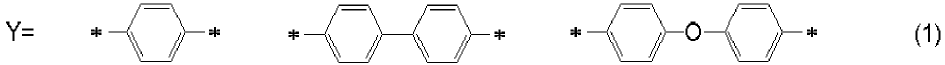 wherein * represents a bonding arm, 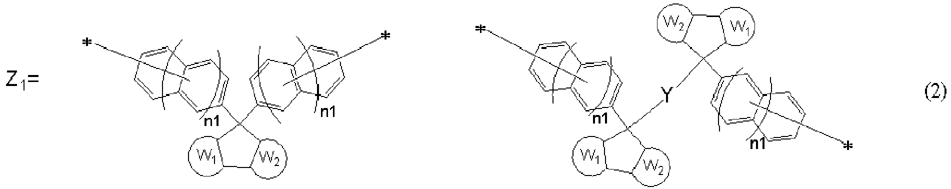 wherein W₁, W₂, Y, and n1 are as defined above.

wherein W₁ and W₂ each independently represent a benzene ring or a naphthalene ring, and hydrogen atoms in the benzene ring and the naphthalene ring are optionally substituted with a hydrocarbon group having 1 to 6 carbon atoms. W₁ and W₂ are preferably benzene rings from the viewpoint of flowability, and n1 is preferably 1 and n2 is preferably 1 from the viewpoint of dry etching resistance and reduction in outgassing caused by sublimate. R^{a} is a hydrogen atom, a saturated hydrocarbon group having 1 to 10 carbon atoms, or an unsaturated hydrocarbon group having 2 to 10 carbon atoms, and does not contain heteroatoms. From the viewpoint of thermosetting property and flowability, R^{a} is preferably a hydrogen atom or a structure represented by the following formula (R^{a}-1). Among these, a hydrogen atom, an allyl group or a propargyl group is more preferable. 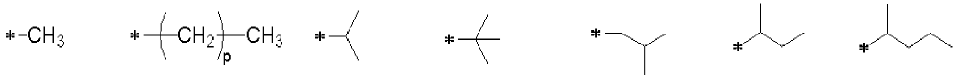 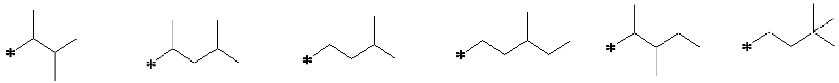 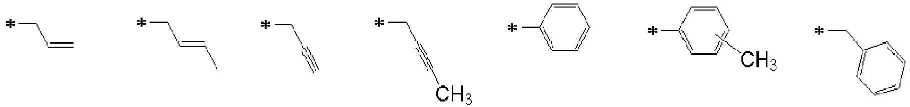 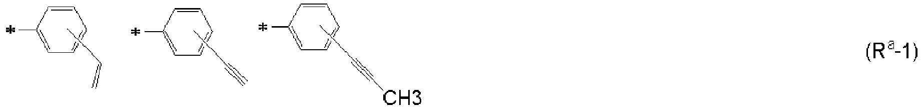 wherein "p" is 1 to 10, and is applied only to this formula.

In the general formula (III), Z₁ is a group represented by the general formula (2), R^{b} is a hydrogen atom, a saturated hydrocarbon group having 1 to 10 carbon atoms, or an unsaturated hydrocarbon group having 2 to 10 carbon atoms, and does not contain heteroatoms. n4 is preferably 1 and n5 is preferably 1.

In the general formula (III), from the viewpoint of thermosetting property and flowability, R^{b} is preferably a hydrogen atom or a structure represented by the following formula (R^{b}-1). Among these, a hydrogen atom, an allyl group or a propargyl group is more preferable. 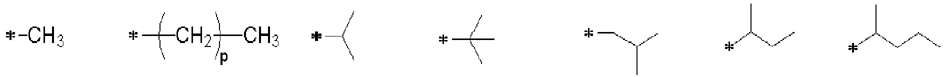 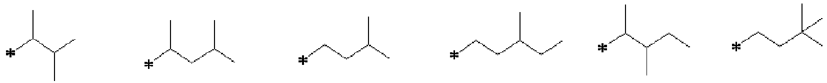 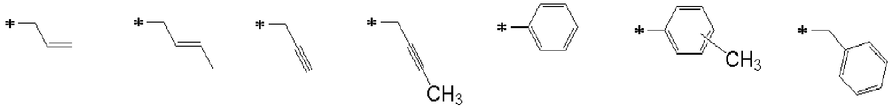 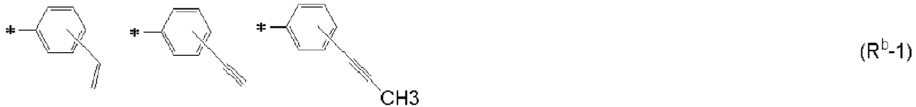 wherein "p" is 1 to 10, and is applied only to this formula.

In the general formulae (I), (II) and (III) above, V independently represents a hydrogen atom or a connection portion. In the case where each V is a hydrogen atom (i.e., there is no connection portion), the flowability accelerator represented by the above general formulae is a monomolecular compound, and corresponds to the compounds represented by the general formulae (3), (4), and (5) described below. When V is a connection portion, the flowability accelerator is a polymer. The connection portion is a portion that connects the structures represented by the above general formulae each other, and may be, for example, a single bond or a linkage group L described below. That is, the polymer includes a polymer having repeating units represented by the following general formulae (6), (7), and (8).

Since the flowability accelerator having such a structure has a rigid structure containing many aromatic rings, a composition for forming a metal oxide film having desirable heat resistance and etching resistance can be formed. Further, by the action of the cardo structure introduced into the molecule, the interaction between the molecules is alleviated and the solubility in an organic solvent is imparted, and therefore, the metal oxide nanoparticles can be desirably dispersed in the composition for forming a metal oxide film, thereby improving the film forming property at the time of forming a coating film. In addition, despite the introduction of a plurality of condensed carbon rings having a high carbon density, it is possible to achieve both heat resistance and filling and planarizing properties, which are contradictory to each other.

When the constituent of R^{a} in the general formulae (I) and (II) above is either a hydrogen atom or a structure represented by the general formula (R^{a}-1) above, the constituent of R^{b} in the general formula (III) above is either a hydrogen atom or a structure represented by the general formula (R^{b}-1) above, and when the proportion of hydrogen atom is "a" and the proportion of each of the structures represented by the general formulae (R^{a}-1) and (R^{b}-1) above is "b" in the structures constituting R^{a} and R^{b} above, the component (B) as a whole preferably satisfies the relationships: a+b=1 and 0.2^b^0.8, more preferably 0.3≦b≦0.7, and even more preferably 0.4^b^0.6.

By controlling the proportion of the hydrogen atom and those represented by the general formulae (R^{a}-1) and (R^{b}-1) above to be in the above-described range, it is possible to provide a resist underlayer film composition highly exhibiting flowability and substrate adhesiveness and having improved filling and planarizing properties. In order to improve the film forming property and the adhesiveness of the film with respect to the substrate, the proportion "a" of the hydrogen atom may be increased, that is, a>b may be satisfied, and in order to improve the curability, the heat resistance, and the planarizing property, a<b may be satisfied. These proportions can be adjusted according to the required performance.

The general formulae (R^{a}-1) and (R^{b}-1) above more preferably have the structure represented by the following general formula (9). 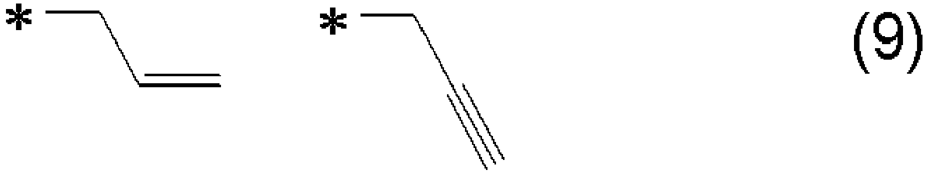 wherein * represents a portion bonded with an oxygen atom.

By having such a crosslinking group, it is possible to further improve the flowability, thereby forming a cured film having excellent film forming property and less outgassing.

In the present invention, only one kind of the flowability accelerator represented by the general formulae (I) to (III) in which the proportion of hydrogen atom and those represented by the general formulae (R^{a}-1) and (R^{b}-1) are controlled within the above-described range may be used, or two or more kinds thereof may be mixed at a desired mixing ratio to form an equivalent composition.

The flowability accelerator above may be the compound represented by the general formulae (3), (4), and (5) described below (hereinafter, these compounds are also referred to as "a compound for a flowability accelerator"), or may also be the polymer having repeating units represented by the general formulae (6), (7), and (8) described below (hereinafter, these polymers are also referred to as "a polymer for a flowability accelerator"). The (B) flowability accelerator above may contain one or more selected from each of the compounds represented by the general formulae (3) to (5) and the polymers having the repeating units represented by the general formulae (6) to (8). Hereinafter, the flowability accelerator (compound and polymer) will be further described.

### Compound for Flowability Accelerator

The compound for a flowability accelerator contained in the composition for forming a metal oxide film of the present invention may be a compound represented by one or more selected from the following general formulae (3), (4) and (5). 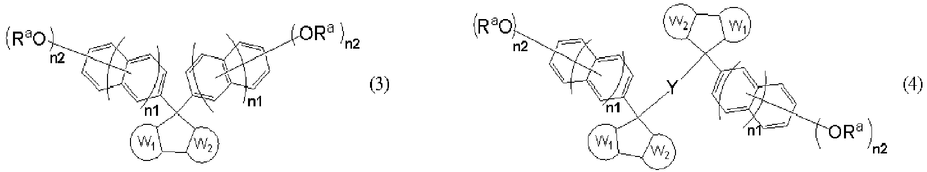 wherein W₁, W₂, R^{a}, Y, n1 and n2 are as defined above, 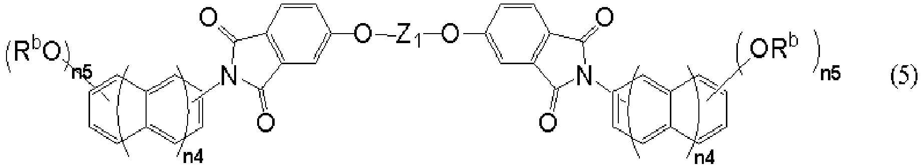 wherein Z₁, R^{b}, n4 and n5 are as defined above.

W₁, W₂, R^{a}, Y, n1 and n2 in the general formulae (3) and (4) above are as defined above for the general formulae (I) and (II) above.

Z₁, R^{b}, n4 and n5 in the general formula (5) above are as defined above for the general formula (III).

Specific examples of the compounds for a flowability accelerator represented by the general formulae (3), (4), and (5) include, but not limited to, the following compounds.

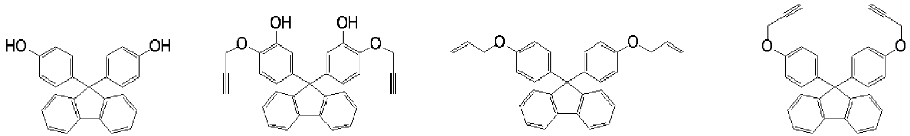

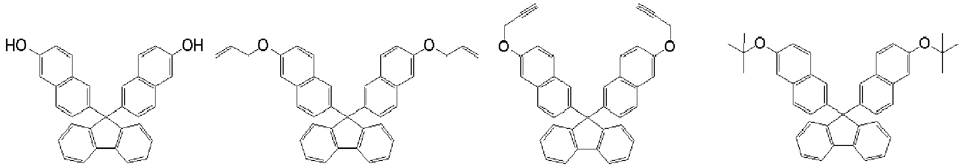

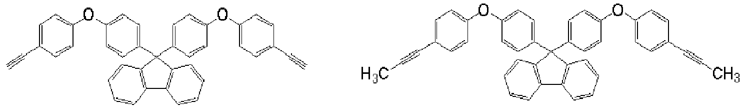

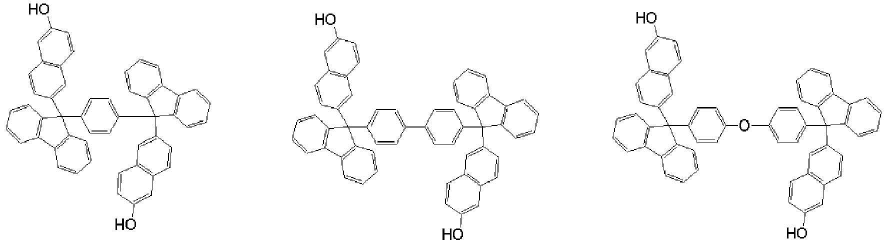

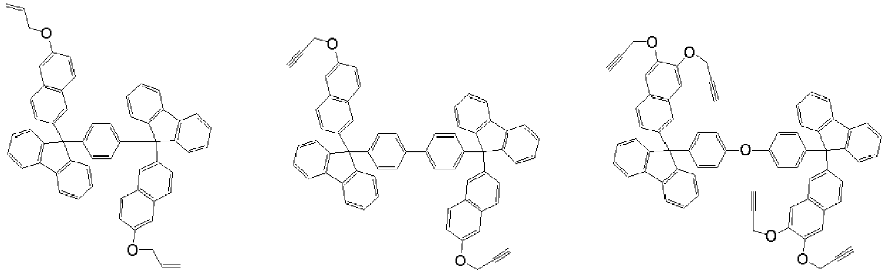

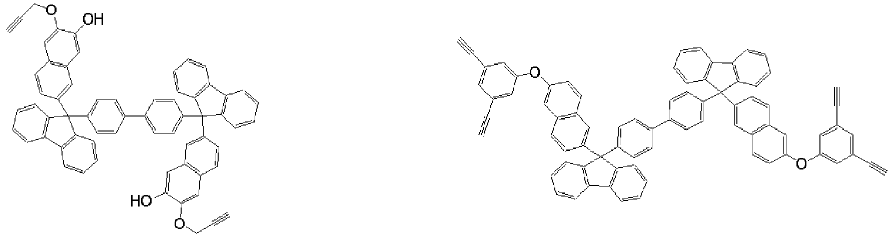

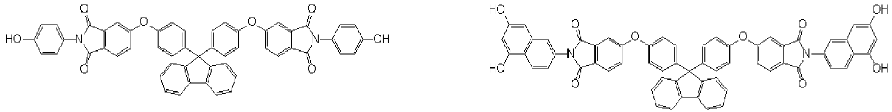

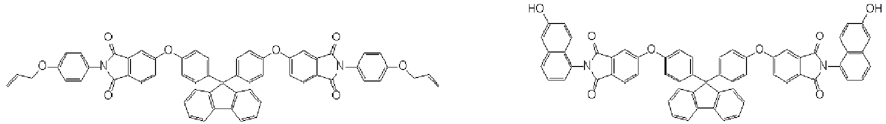

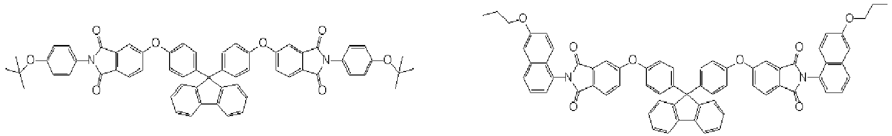

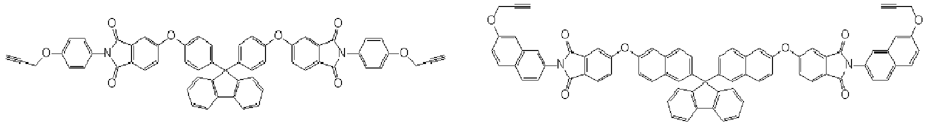

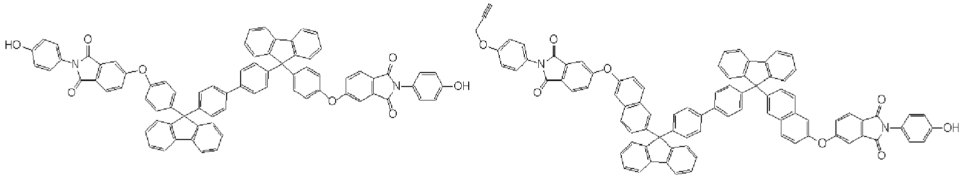

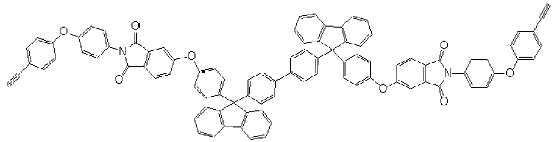

The ratio Mw/Mn (i.e., dispersity), which is a ratio of the weight average molecular weight Mw to the number average molecular weight Mn on polystyrene basis according to gel permeation chromatography, of one or more compounds selected from the general formulae (3), (4) and (5) above is preferably in the range of 1.00≦Mw/Mn≦1.25 for each compound. With such a range of dispersity, the compound for a flowability accelerator exhibits more excellent thermal flowability. Thus, when it is incorporated in the composition, it is possible to not only desirably fill a fine structure formed on the substrate but also form a resist underlayer film with the entire substrate planarized.

### Polymer for Flowability Accelerator

The polymer for a flowability accelerator contained in the composition for forming a metal oxide film of the present invention may be such that the flowability accelerator is a polymer having repeating units represented by one or more selected from the following general formulae (6), (7) and (8). 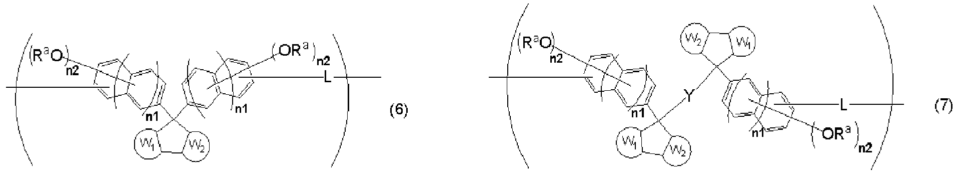 wherein W₁, W₂, R^{a}, Y, n1 and n2 are as defined above, and L is a divalent organic group having 1 to 40 carbon atoms. 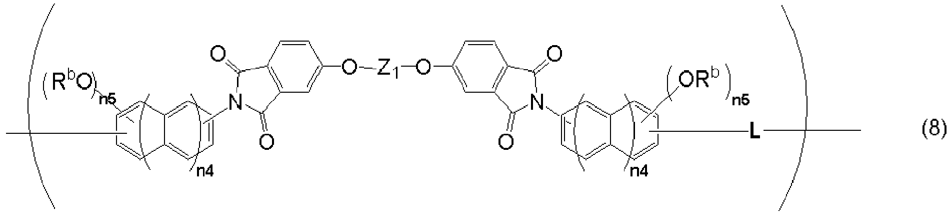 wherein Z₁, R^{b}, n4 and n5 are as defined above, and L is a divalent organic group having 1 to 40 carbon atoms.

W₁, W₂, R^{a}, Y, n1 and n2 in the general formulae (6) and (7) above are as defined above for the general formulae (I) and (II) above.

Z₁, R^{b}, n4 and n5 in the general formula (8) above are as defined above for the general formula (III).

These are polymers obtained by using the compounds represented by the general formulae (3), (4), and (5) above, and are excellent in heat resistance, planarizing property, and thermosetting property because the compounds for a flowability accelerator described above are used. In addition, since the polymer is not a monomer but a polymer having repeating units, the amount of outgas component is small, and the polymer has a molecular weight distribution; therefore, crystallinity is alleviated, and improved film forming property can be expected.

L, which is a linkage group constituting the repeating units of the general formulae (6), (7), and (8) above, is a divalent organic group having 1 to 40 carbon atoms. Specific examples thereof include the following.

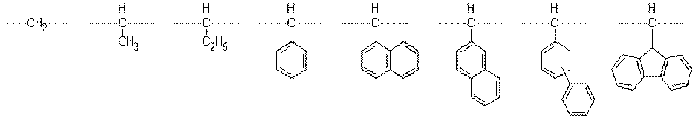

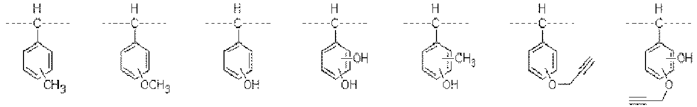

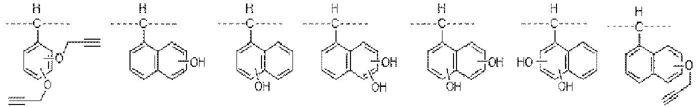

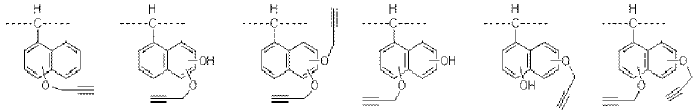

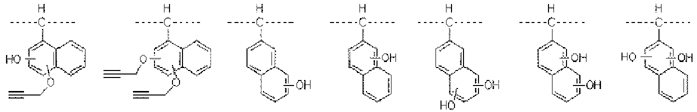

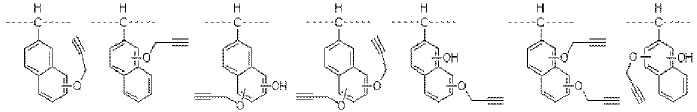

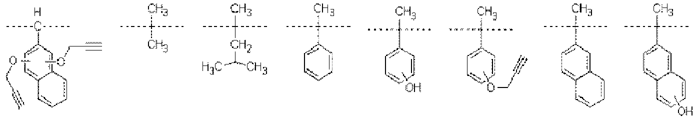

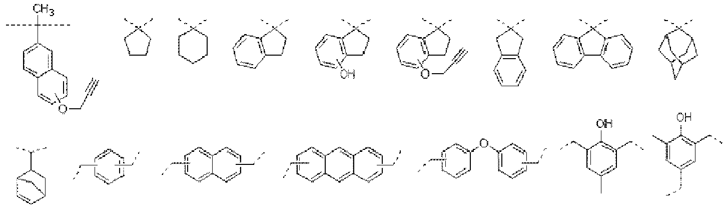

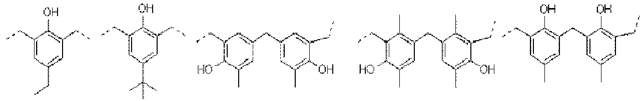

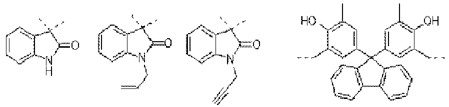

Further, the linkage group L of the polymer described above is preferably represented by the following general formula (10). 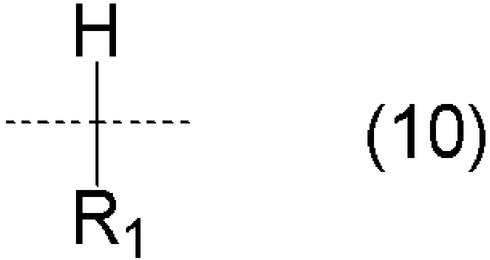 wherein R₁ is a hydrogen atom or an organic group with an aromatic ring having 6 to 20 carbon atoms, and the dashed line represents a bonding arm.

Specific examples of those represented by the general formula (10) above include the following; among these, a methylene group is preferable because of easy obtainability of the material, i.e., R₁ is preferably a hydrogen atom.

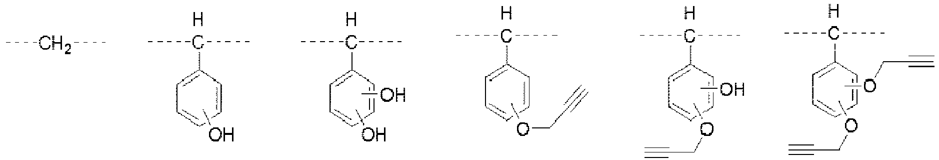

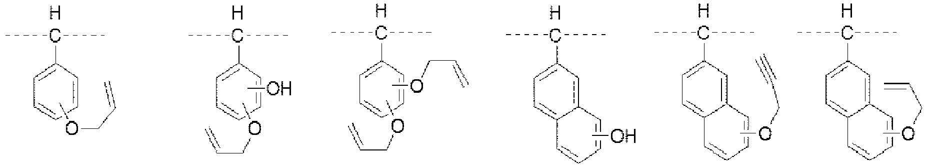

Further, the weight average molecular weight on polystyrene basis according to gel permeation chromatography of the polymer having the repeating structure units represented by one or more selected from the general formulae (6), (7) and (8) above is not more than 5000, preferably 1000 to 5000; and Mw is preferably 1000 to 4000.

When the molecular weight is within this range, solubility in an organic solvent can be ensured, thereby suppressing sublimate generated during the baking. In addition, since the polymer for a flowability accelerator has desirable thermal flowability, when it is incorporated in the composition, it is possible to not only desirably fill a fine structure formed on the substrate but also form a metal oxide film with the entire substrate planarized.

### Compound and/or Polymer for Flowability Accelerator

In the composition for forming a metal oxide film of the present invention containing, as the composition for forming a metal oxide film, metal oxide nanoparticles, the compound and/or the polymer for a flowability accelerator described above, and an organic solvent, the compound or the polymer for a flowability accelerator may be used alone or in a combination of two or more.

Further, in the present invention, at least one kind selected from each of the compound and the polymer for a flowability accelerator described above is preferably contained. Specifically, the composition for forming a metal oxide film preferably contains, as the component (B), one or more compounds represented by the general formulae (3) to (5) above and one or more polymers having repeating structural units represented by the general formulae (6) to (8) above.

With such a mixture, various physical properties required when the composition for forming a metal oxide film is used, such as filling and planarizing properties, outgassing caused by sublimate, and the like, can be adjusted within an appropriate range. Specifically, the flowability accelerator contained in the composition for forming a metal oxide film may be any of (i) one or more compounds for a flowability accelerator, (ii) one or more polymers for a flowability accelerator, or (iii) a mixture of at least one compound for a flowability accelerator and at least one polymer for a flowability accelerator. They can be arbitrarily combined to give a metal oxide film having desired characteristics. When the flowability accelerator is either a compound or a polymer alone, preparation is easy, and when the flowability accelerator is a mixture of a compound and a polymer, the degree of freedom in controlling the workability of the composition or the physical properties of the metal oxide film is increased.

When the flowability accelerator is a mixture of a compound and a polymer, the weight ratio of the compound x to the polymer y is preferably such that x/y = 20/80 to 80/20. Within this range, it is possible to provide a resist underlayer film composition highly exhibiting flowability and denseness of the cured film and having improved filling and planarizing properties and dry etching resistance. In order to improve the filling and planarizing properties, the proportion of the compound x may be increased, that is, x>y may be satisfied, and in order to improve the curability, the heat resistance, and the film forming property, x<y may be satisfied. These proportions can be adjusted according to the required performance.

In the composition for forming a metal oxide film of the present invention, the weight ratio of the (A) metal oxide nanoparticle to the (B) flowability accelerator is 10/90 to 90/10, preferably 20/80 to 80/20, and further preferably 30/70 to 70/30.

By controlling the ratio between the (A) metal oxide nanoparticles and the (B) flowability accelerator within the above-described range, it is possible to highly exhibit dry etching resistance and filling and planarizing properties. When the ratio falls outside the range of 10/90 to 90/10, heat resistance and dry etching resistance decrease. In order to improve dry etching resistance, the proportion of the (A) metal oxide nanoparticles may be increased; in order to improve filling and planarizing properties, the proportion of the (B) flowability accelerator may be increased. These proportions can be adjusted according to the required performance. The component (B) may be used in an amount of 11 to 900 parts by mass per 100 parts by mass of the metal oxide nanoparticles in the composition.

### (C) Organic Solvent

The (C) organic solvent that can be used in the composition for forming a metal oxide film of the present invention is not particularly limited insofar as it is capable of dispersing the (A) metal oxide nanoparticles and dissolving the compound and/or the polymer for a flowability accelerator (flowability accelerator), and also, when contained, a crosslinking agent, a surfactant, an acid generator, a plasticizer, other additives, and the like, which will be described later. Specifically, solvents having a boiling point of less than 180°C, such as the solvents described in paragraphs [0091] to [0092] of JP 2007-199653 A may be used. Among them, propylene glycol monomethyl ether acetate, propylene glycol monomethyl ether, 2-heptanone, cyclopentanone, cyclohexanone, and a mixture of two or more of these solvents may be preferably used. The incorporation amount of the organic solvent is preferably 200 to 10,000 parts, more preferably 300 to 5,000 parts, per 100 parts of the (A) metal oxide nanoparticles.

With such a composition for forming a metal oxide film, the (A) metal oxide nanoparticles can be desirably dispersed, and the composition can be applied by spin coating, thereby forming a metal oxide film having both dry etching resistance and high filling and planarizing properties.

Further, it is possible to add, as an organic solvent, a high boiling point solvent having a boiling point of 180°C or higher to the solvent having a boiling point of less than 180°C (a mixture of a solvent having a boiling point of less than 180°C and a solvent having a boiling point of 180°C or higher) in the composition for forming a metal oxide film of the present invention. Examples of the high boiling point organic solvent include, with no particular limitation, any hydrocarbons, alcohols, ketones, esters, ethers, and chlorine-based solvents, insofar as it is capable of dissolving the compound and/or the polymer for a flowability accelerator. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, and dibutyl adipate, and the like. They may be used alone or as a mixture.

The boiling point of the high boiling point solvent may be suitably selected according to the temperature at which the composition for forming a metal oxide film is heat-treated. The boiling point of the high boiling point solvent to be added is preferably 180°C to 300°C, more preferably 200°C to 300°C. With this boiling point, it is possible to prevent an excessive evaporation rate at the baking (heating) due to excessively low boiling point, thus ensuring sufficient thermal flowability. Moreover, the solvent having such a boiling point is free from a defect that it fails to evaporate and remain in the film even after the baking due to excessive boiling point. Therefore, there will be no adverse effects on the physical properties of the film, such as etching resistance.

Further, when the high boiling point solvent described above is used, the incorporation amount of the high boiling point solvent is preferably 1 to 30 parts by mass, per 100 parts by mass of the solvent having a boiling point of less than 180°C. With the incorporation amount within this range, it is possible to impart sufficient thermal flowability, and there will be no residues in the film, thus ensuring desirable physical properties of the film such as etching resistance.

With such a composition for forming a metal oxide film in which thermal flowability is imparted due to the addition of the high boiling point solvent to the composition for forming a metal oxide film described above, it is possible to provide a composition for forming a metal oxide film having higher filling and planarizing properties.

### Other Components

### Crosslinking Agent

To increase the curability and further inhibit intermixing with the resist upper layer film, a crosslinking agent may be added to the composition for forming a metal oxide film of the present invention. The crosslinking agent is not particularly limited, and various known crosslinking agents can be widely used. Examples thereof include polynuclear phenol-based, such as methylol or alkoxymethyl-based crosslinking agent (polynuclear phenol-based crosslinking agent), a melamine-based crosslinking agent, a glycoluril-based crosslinking agent, a benzoguanamine-based crosslinking agent, a urea-based crosslinking agent, a β-hydroxyalkylamide-based crosslinking agent, an isocyanurate-based crosslinking agent, an aziridine-based crosslinking agent, an oxazoline-based crosslinking agent, an epoxy-based crosslinking agent, and the like. When the crosslinking agent is added, the addition amount is preferably 1 to 100 parts, more preferably 5 to 50 parts, per 100 parts of the metal oxide nanoparticles.

Specific examples of the melamine-based crosslinking agent include hexamethoxymethylated melamine, hexabutoxymethylated melamine, alkoxy- and/or hydroxy-substituted derivatives thereof, and partial self-condensates thereof.

Specific examples of the glycoluril-based crosslinking agent include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agent include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agent include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide. Specific examples of the isocyanurate-based crosslinking agent include triglycidyl isocyanurate and triallyl isocyanurate.

Specific examples of the aziridine-based crosslinking agent include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agent include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agent include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agent include a compound represented by the following general formula (11). 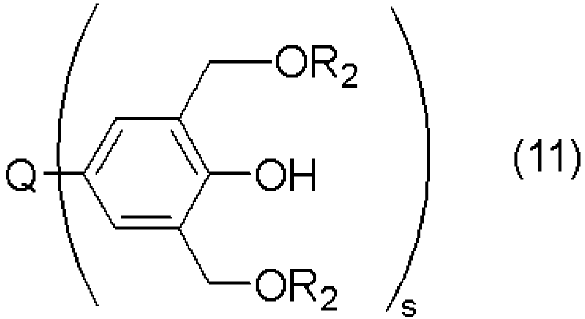 wherein Q is a single bond or a q-valent hydrocarbon group having 1 to 20 carbon atoms; R₂ is a hydrogen atom or an alkyl group having 1 to 20 carbon atoms; and s is an integer of 1 to 5.

Q is a single bond or an s-valent hydrocarbon group having 1 to 20 carbon atoms; and s is an integer of 1 to 5, more preferably 2 or 3. Specific examples of Q include groups obtained by removing q hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₂ is a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (11) above include the following compounds. Among these, triphenolmethane, triphenolethane, 1,1,1,-tris (4-hydroxyphenyl)ethane, and a hexamethoxymethylated derivative of tris (4-hydroxyphenyl)-1-ethyl-4-isopropylbenzene are preferable from the viewpoint of improving the curability and film thickness uniformity of the organic film. R² is as defined above.

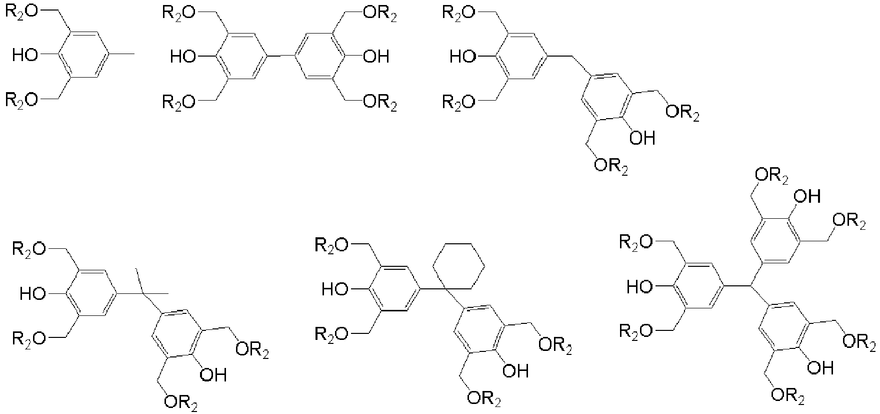

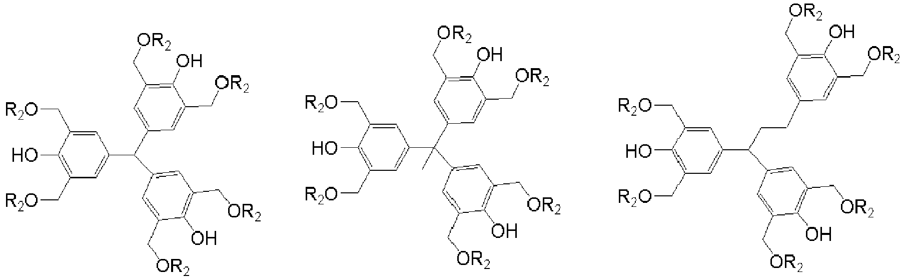

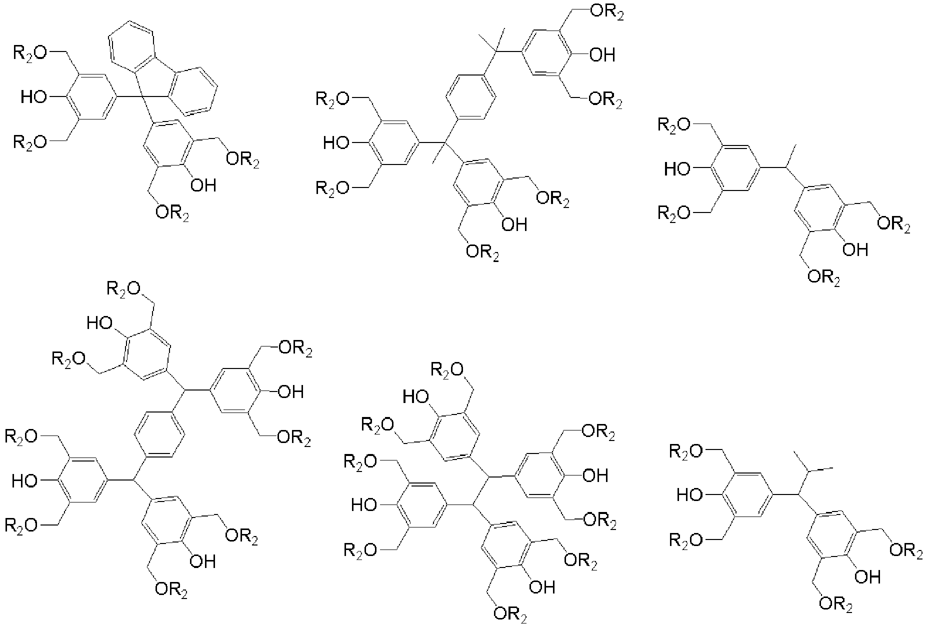

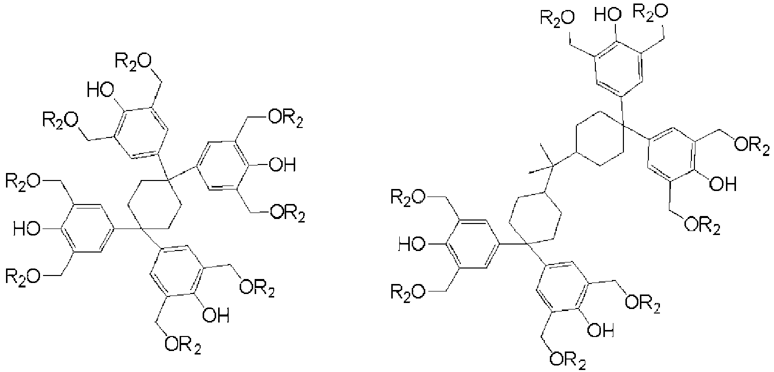

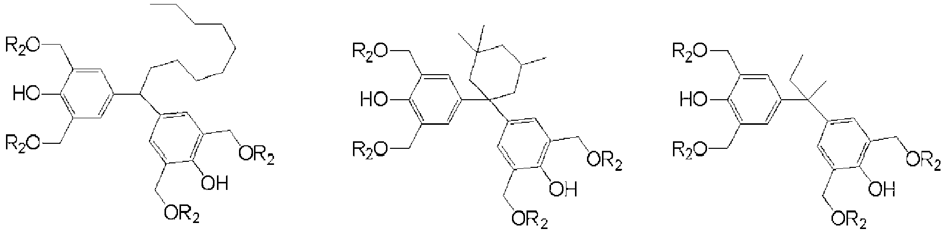

### Surfactant

A surfactant may be added to the composition for forming a metal oxide film of the present invention in order to improve coatability in spin coating. Specific examples of the surfactant include those disclosed in paragraphs [0142] to [0147] of JP 2009-269953 A. When the surfactant is added, the addition amount is preferably 0.01 to 10 parts, more preferably 0.05 to 5 parts, per 100 parts of the compound and/or the polymer.

### Acid Generator

An acid generator may be added to the composition for forming a metal oxide film of the present invention in order to further promote the curing reaction. The acid generator can be classified into those that generate an acid by thermal decomposition and those that generate an acid by optical irradiation; however, any acid generators can be added. Specific examples of the acid generator include, but not limited to, those disclosed in paragraphs [0061] to [0085] of JP 2007-199653 A.

These acid generators may be used individually or in a combination of two or more kinds. When the acid generator is added, the addition amount is preferably 0.05 to 50 parts, more preferably 0.1 to 10 parts, per 100 parts of the (A) metal oxide nanoparticles.

### Plasticizer

A plasticizer may be added to the composition for forming a metal oxide film of the present invention in order to further improve the planarizing and filling properties. The plasticizer is not particularly limited, and various known plasticizers can be widely used. Examples of the plasticizer include low molecular weight compounds such as phthalate esters, adipate esters, phosphate esters, trimellitate esters, and citrate esters; polymers such as polyether-based polymers, polyester-based polymers, and polyacetal-based polymers disclosed in JP 2013-253227 A, and the like. When the plasticizer is added, the addition amount is preferably 1 to 100 parts, more preferably 5 to 30 parts, per 100 parts of the (A) metal oxide nanoparticles.

In addition, for the composition for forming a metal oxide film of the present invention, as an additive for imparting filling and planarizing properties like a plasticizer, for example, a liquid additive having a polyethylene glycol or polypropylene glycol structure, or a thermo-decomposable polymer having a weight reduction rate of 40% by mass or more at 30°C to 250°C and a weight average molecular weight of 300 to 200,000 is preferably used. This thermo-decomposable polymer preferably contains a repeating unit having an acetal structure represented by the following general formula (DP1), (DP1a). 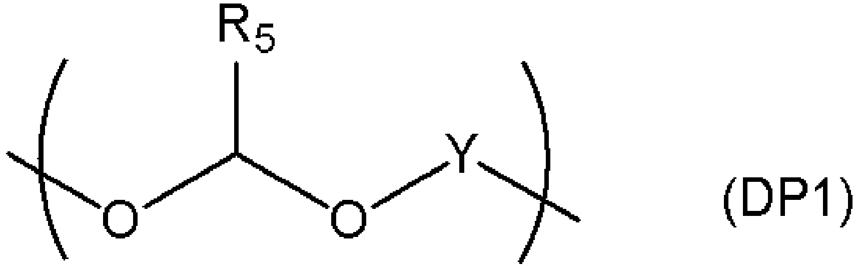 wherein R₅ is a hydrogen atom or a substituted or unsubstituted saturated or unsaturated monovalent organic group having 1 to 30 carbon atoms; Y is a saturated or unsaturated divalent organic group having 2 to 30 carbon atoms; each symbol is applied only to this formula. 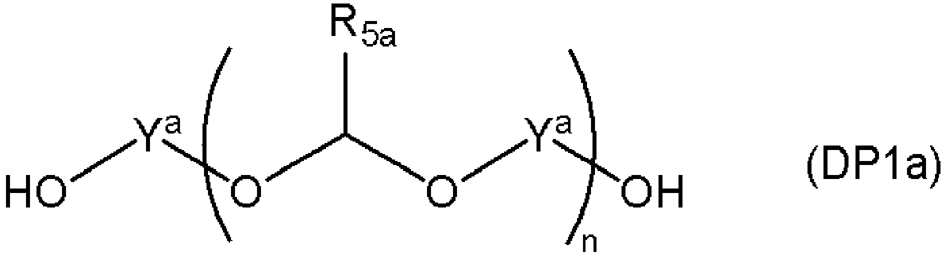 wherein R₅ₐ is an alkyl group having 1 to 4 carbon atoms; Y^{a} is a saturated or unsaturated divalent hydrocarbon group having 4 to 10 carbon atoms and optionally containing an ether bond; and n represents an average repeating unit number of 3 to 500.

### Blend Polymer or Compound

Yet another polymer or compound may be blended in the composition for forming a metal oxide film of the present invention. The blend polymer or the blend compound is mixed with the (A) metal oxide nanoparticles and the (B) flowability accelerator of the present invention and serves to improve the film forming property by spin coating and the filling property for a substrate with a step.

Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'dimethyl-4,4'-(9H-fluorene-9-ylidene)bisphenol, 2,2'diallyl-4,4'-(9H-fluorene-9-ylidene)bisphenol, 2,2'difluoro-4,4'-(9H-fluorene-9-ylidene)bisphenol, 2,2'diphenyl-4,4'-(9H-fluorene-9-ylidene)bisphenol, 2,2'dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6, 6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, and 7-methoxy-2-naphthol, dihydroxynaphthalene such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. In addition, the composition may contain a naphthol dicyclopentadiene copolymer disclosed in JP 2004-205685 A, a fluorene bisphenol novolak resin disclosed in JP 2005-128509 A, an acenaphthylene copolymer disclosed in JP 2005-250434 A, fullerene having a phenolic group disclosed in JP 2006-227391 A, a bisphenol compound and a novolak resin thereof disclosed in JP 2006-293298 A, a novolak resin of an adamantane phenol compound disclosed in JP 2006-285095 A, a bisnaphthol compound and a novolak resin thereof disclosed in JP 2010-122656 A, a fullerene resin compound disclosed in JP 2008-158002 A, and the like. It is also possible to blend a polymer including the following general formula (BP). Among these, the polymer including (BP) is preferably used as the blend polymer from the viewpoint of flowability.

### Blend Polymer (BP)

The blend compound or polymer described above is preferably a blend polymer having the structure represented by the following general formula (BP). 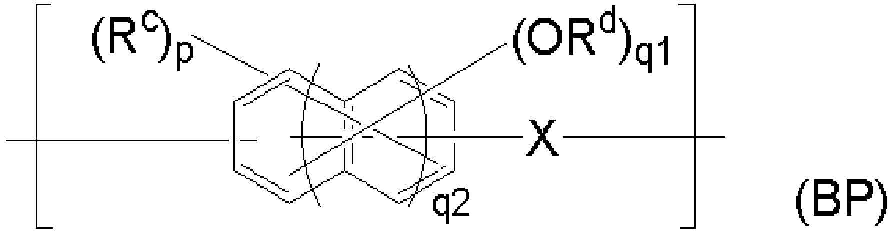 wherein R^{c} is a saturated or unsaturated monovalent organic group having 1 to 10 carbon atoms; R^{d} is a hydrogen atom, a saturated hydrocarbon group having 1 to 10 carbon atoms, or an unsaturated hydrocarbon group having 2 to 10 carbon atoms; X is a divalent organic group having 1 to 30 carbon atoms; "p" is an integer of 0 to 5; q1 is an integer of 1 to 6; p+q1 is an integer of 1 or more and 6 or less; and q2 is 0 or 1.

In the general formula (BP) above, X is preferably a methylene group from the viewpoint of obtainability of starting materials, "p" is preferably 0 or 1, q1 is preferably 1 or 2, and q2 is preferably 0.

In the general formula (BP) above, particularly preferable examples of the structure of R^{d} include a hydrogen atom and the structure represented by the following general formula (12). By adding the blend polymer having such a structure, the flowability of the composition for forming a metal oxide film can be further improved. In addition, desirable heat resistance and film forming property are ensured, thereby suppressing generation of sublimate at the time of heat curing, suppressing contamination of the apparatus due to the sublimate, and suppressing generation of coating defects. 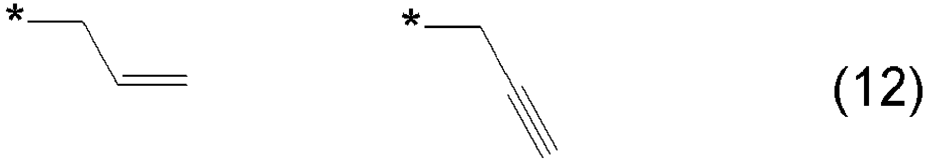 wherein * represents a portion bonded with an oxygen atom.

It is more preferable that the constituent of R^{d} in the general formula (BP) above is either a hydrogen atom or a structure represented by the general formula (12) above, and that, when the proportion of the hydrogen atom is Ba and the proportion of the structure represented by the general formula (12) is Bb, the polymer satisfies, as the whole components of (BP), the relationships: Ba+Bb=1, 0.2^Bb^0.8. By adding the blend polymer having such a range, the thermal flowability can be further improved.

The incorporation amount of the blend compound or the blend polymer is preferably 0 to 1,000 parts by mass, and more preferably 0 to 500 parts by mass, per 100 parts by mass of the (A) metal oxide nanoparticles.

### Dispersant

A dispersant may further be added to the composition for forming a metal oxide film of the present invention. The type of the dispersant to be used in the present invention is not particularly limited, and previously-known dispersants may be used. Examples of the dispersant include low-molecular dispersants such as alkylamines, alkanethiols, alkanediols, and phosphate esters, high-molecular dispersants having various functional groups, silane coupling agents, and the like. Examples of the high-molecular dispersant include styrene-based resins (styrene-(meth)acrylic acid copolymers, styrene-maleic anhydride copolymers, and the like), acrylic resins ((meth) acrylic acid-based resins such as methyl (meth)acrylate-(meth)acrylic acid copolymers, poly (meth)acrylic acid, and the like), water-soluble urethane resins, water-soluble acrylic urethane resins, water-soluble epoxy resins, water-soluble polyester-based resins, cellulose derivatives (nitrocellulose; cellulose ethers such as alkylcelluloses such as ethylcellulose, alkyl-hydroxyalkylcelluloses such as ethylhydroxyethylcellulose, hydroxyalkylcelluloses such as hydroxyethylcellulose and hydroxypropylcellulose, and carboxyalkylcelluloses such as carboxymethylcellulose), polyvinyl alcohol, polyalkylene glycols (liquid polyethylene glycol, polypropylene glycol, and the like), natural polymers (polysaccharides such as gelatin, dextrin, gum arabic, casein, and the like), polyethylenesulfonic acid or salts thereof, polystyrenesulfonic acid or salts thereof, formalin condensates of naphthalenesulfonic acid, nitrogen atom-containing polymer compounds (amino group-containing polymer compounds such as polyalkyleneimine (polyethyleneimine and the like), polyvinylpyrrolidone, polyallylamine, and polyetherpolyamine (polyoxyethylenepolyamine, and the like)), and the like.

In general, metal nanoparticles are covered with an organic top coat in order to prevent aggregation; however, the addition of a dispersant can further improve the aggregation prevention property of metal nanoparticles.

The compositions for forming a metal oxide film of the present invention may be used individually or in a combination of two or more kinds. The composition for forming a metal oxide film described above can be used as a composition for a metal oxide film or a planarizing composition for the manufacture of a semiconductor apparatus.

As described above, according to the composition for forming a metal oxide film of the present invention, by combining the (A) metal oxide nanoparticles excellent in dry etching resistance and the flowability accelerator represented by the general formulae (I) to (III) above, it is possible to form a resist underlayer film exhibiting significantly excellent dry etching resistance relative to previously-known spin-on carbon. Thus, the composition is useful in fine patterning for the manufacture of semiconductor apparatuses. In addition, since the composition for forming a metal oxide film of the present invention contains the flowability accelerator represented by the general formulae (I) to (III) above, the composition for forming a metal oxide film of the present invention is useful as a planarizing film for the manufacture of semiconductor even in the filling and planarization of a portion with a dense fine pattern structure portion with a high aspect ratio where filling and planarization were difficult with previously-known metal oxide nanoparticle. Specifically, the metal oxide film-forming composition of the present invention is significantly useful as a resist underlayer film of a multilayer resist film used in lithography such as a two-layer resist process, a three-layer resist process using a silicon-containing resist middle layer film, a four-layer resist process using an inorganic hard mask middle layer film or a silicon-containing resist middle layer film and an organic antireflective film, a pattern reverse process, and the like, or as a filling film that serves as a planarizing film for the manufacture of semiconductor.

### Patterning Process

Further, the present invention provides, as a patterning process using a two-layer resist process using such a composition for forming a metal oxide film, a process for forming a pattern in a substrate to be processed, comprising the steps of:
(I-1) applying the composition for forming a metal oxide film onto a substrate to be processed, followed by heating to form a metal oxide film;
(I-2) forming a resist upper layer film on the metal oxide film by using a photoresist material;
(I-3) subjecting the resist upper layer film to pattern exposure and then development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern in the substrate to be processed.

The resist upper layer film in the two-layer resist process described above exhibits etching resistance with respect to chlorine-based gas; therefore, the dry etching of the metal oxide film that is performed while using the resist upper layer film as a mask in the two-layer resist process is preferably performed using an etching gas mainly containing a chlorine-based gas.

Further, the present invention provides, as a patterning process using a three-layer resist process using such a composition for forming a metal oxide film, a process for forming a pattern in a substrate to be processed, comprising the steps of:
(II-1) applying the composition for forming a metal oxide film onto a substrate to be processed, followed by heating to form a metal oxide film;
(II-2) forming a silicon-containing resist middle layer film on the metal oxide film by using a material for a silicon-containing resist middle layer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal oxide film by dry etching while using the resist middle layer film having the transferred pattern as a mask; and
(II-7) processing the substrate to be processed while using the metal oxide film having the formed pattern as a mask to form the pattern in the substrate to be processed.

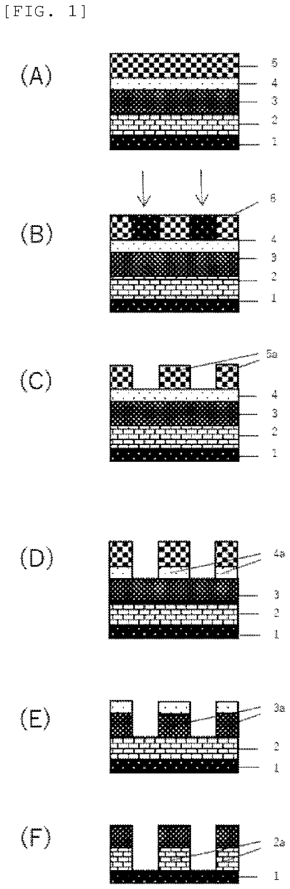

An example of the three-layer resist process is specifically explained below by referring to FIG. 1. In the case of the three-layer resist process, as shown in FIG. 1(A), a metal oxide film (metal-containing resist underlayer film) 3 is formed on a layer to be processed 2 stacked on a substrate to be processed 1 using a metal-oxide film forming composition of the present invention; thereafter, a silicon atom-containing resist middle layer film 4 is formed, and a resist upper layer film 5 is further formed thereon.

Next, as shown in FIG. 1(B), exposure is conducted for required portion (exposure portion) 6 of the resist upper layer film 5, followed by PEB and development, to form a resist upper layer film pattern 5a (FIG. 1(C)). The obtained resist upper layer film pattern 5a is then used as a mask to etch the silicon atom-containing resist middle layer film 4 using a CF-based gas to form a silicon atom-containing resist middle layer film pattern 4a (FIG. 1(D)). After removing the resist upper layer film pattern 5a, oxygen plasma etching of the metal oxide film 3 is performed while using the obtained silicon atom-containing resist middle layer film pattern 4a as a mask to form a metal oxide film pattern (metal-containing resist underlayer film pattern) 3a (FIG. 1(E)). Further, after removing the silicon atom-containing resist middle layer film pattern 4a, the layer to be processed 2 is etched while using the metal oxide film pattern 3a as a mask to form a pattern 2a to be formed on the layer to be processed (FIG. 1(F)).

The silicon-containing resist middle layer film in the three-layer resist process described above exhibits etching resistance with respect to a chlorine-based or oxygen-based gas; therefore, the dry etching of the metal oxide film that is performed while using the silicon-containing resist middle layer film as a mask in the three-layer resist process is preferably performed using an etching gas mainly containing a chlorine-based gas or an oxygen-based gas.

As the silicon-containing resist middle layer film in the three-layer resist process, a polysiloxane-based middle layer film is also preferably used. This makes the silicon-containing resist middle layer film to possess an effect as an antireflective film, thereby suppressing reflection. When a composition containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or a heat.

In addition, the present invention provides a patterning process by way of a four-layer resist process using such a composition for forming a metal oxide film, comprising the steps of: forming a metal oxide film on a substrate to be processed using the composition for forming a metal oxide film described above; forming a silicon-containing resist middle layer film on the resist underlayer film using a material for a silicon-containing resist middle layer film; forming an organic antireflective film (BARC) or an adhesive film on the silicon-containing resist middle layer film; forming a resist upper layer film using a photoresist material on the BARC, followed by pattern exposure of the resist upper layer film and development using a developer, thereby forming a pattern in the resist upper layer film; transferring the pattern to the BARC or the adhesive film and the silicon-containing resist middle layer film by dry etching while using the resist upper layer film having the formed pattern as a mask; transferring the pattern to the metal oxide film by dry etching using the silicon-containing resist middle layer film having the transferred pattern as a mask; and processing the substrate to be processed using the metal oxide film having the formed pattern as a mask, thereby forming a pattern in the substrate to be processed.

Further, an inorganic hard mask may be formed instead of the silicon-containing resist middle layer film; in this case, a semiconductor apparatus circuit pattern can be formed on a substrate, at least, by forming a metal oxide film on a body to be processed using the composition for forming a metal oxide film of the present invention, forming an inorganic hard mask selected from a silicon oxide film, a silicon nitride film, and a silicon oxynitride film on the metal oxide film, forming a resist upper layer film on the inorganic hard mask using the photoresist composition, forming a circuit pattern in the resist upper layer film, etching the inorganic hard mask while using the resist upper layer film having the formed pattern as a mask, etching the metal oxide film using the inorganic hard mask having the formed pattern as a mask, and etching the body to be processed using the metal oxide film having the formed pattern as a mask to form a pattern in the body to be processed.

Further, the present invention is a process for forming a pattern in a substrate to be processed, comprising the steps of:
(III-1) applying the composition for forming a metal oxide film onto a substrate to be processed, followed by heating to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film; (III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern in the substrate to be processed.

In this case, the inorganic hard mask middle layer film is preferably formed by a CVD method or an ALD method.

When the inorganic hard mask middle layer film is formed by a CVD method or an ALD method, a fine pattern can be formed on a body to be processed with higher accuracy.

As described above, when the inorganic hard mask middle layer film is formed on the metal oxide film, a silicon oxide film, a silicon nitride film, and a silicon oxynitride film (SiON film) can be formed by a CVD method, an ALD method, or the like. The method for forming the silicon nitride film is disclosed, for example, in JP 2002-334869 A and WO 2004/066377 A1. The thickness of the inorganic hard mask middle layer film is preferably 5 to 200 nm, more preferably 10 to 100 nm. The SiON film, which has a high function as an antireflective film, is most preferably used as the inorganic hard mask middle layer film. Since the substrate temperature increases to 300 to 500°C when the SiON film is formed, the metal oxide film must withstand a temperature of 300 to 500°C. The composition for forming a metal oxide film used in the present invention has high heat resistance and can withstand a high temperature of 300 to 500°C. Thus, the metal oxide film formed by spin coating and the inorganic hard mask middle layer film formed by the CVD method or the ALD method can be combined.

A photoresist film may be formed on the inorganic hard mask middle layer film as the resist upper layer film as described above; alternatively, an organic antireflective film (BARC) or an adhesive film may be formed on the inorganic hard mask middle layer film by spin coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

The resist upper layer film in the multilayer resist process described above may be either a positive type or negative type, and it is possible to use a film similar to the typically used photoresist composition. The prebaking, which is conducted after spin coating of the photoresist composition, is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 30 to 500 nm, particularly preferably 50 to 400 nm.

Further, examples of light for exposure include high energy beams at wavelengths of 300 nm or less, specifically excimer lasers at 248 nm, 193 nm, and 157 nm, soft X-rays at 3 to 20 nm, an electron beam, X-rays, and the like.

By using the method described above as the method for forming a circuit pattern in the resist upper layer film described above, it is possible to form fine patterns on the body to be processed with a higher degree of accuracy.

As the method for forming a pattern in the resist upper layer film, a patterning process using a photolithography with a wavelength of 5 nm or more and 300 nm or less, a direct drawing using an electron beam, nanoimprinting, or a combination thereof is preferably used.

The development method in the patterning process is preferably alkali development or development using an organic solvent. Specifically, it is preferable that, in the patterning process described above, exposure and development are performed to form a circuit pattern in the resist upper layer film, and that the development is alkali development or development using an organic solvent.

By using alkali development or development using an organic solvent as the development method, it is possible to form fine patterns on the body to be processed with a higher degree of accuracy.

Next, etching is performed by using the obtained resist pattern as a mask. The etching of a silicon-containing resist middle layer film or an inorganic hard mask middle layer film in the three-layer resist process is performed while using the upper layer resist pattern as a mask using a fluorocarbon-based gas. In this manner, a silicon-containing resist middle layer film pattern or an inorganic hard mask middle layer film pattern is formed.

Next, the metal oxide film is etched while using the obtained silicon-containing resist middle layer film pattern or inorganic hard mask middle layer film pattern as a mask. The etching of the metal oxide film is preferably performed using a chlorine-based gas or an oxygen-based gas.

The subsequent etching of a body to be processed may also be performed according to a usual manner; for example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal oxide film obtained by the composition for forming a metal oxide film of the present invention is characterized by its excellent etching resistance at the time of etching of the body to be processed.

Examples of the body to be processed (substrate to be processed) include, but not particularly limited to, substrates made of Si, α-Si, p-Si, SiO₂, SiN, SiON, W, TiN, Al, and the like, those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process of the present invention, a substrate to be processed having a step or a structure with a height of 30 nm or more is preferably used. As described above, the composition for forming a metal oxide film of the present invention has excellent filling and planarizing properties. Thus, even when the substrate to be processed has a step (irregularities) or a structure with a height of 30 nm or more, a flat cured film can be formed. The height of the structure or the step of the substrate to be processed is preferably 30 nm or more, more preferably 50 nm or more, and still more preferably 100 nm or more. In the method of processing a substrate with a step having a pattern with the above-described height, by performing filling and planarization by forming a film from the composition for forming a metal oxide film of the present invention, it is possible to unify the film thickness of the resist middle layer film and the resist upper layer film that are subsequently formed, and thus it is easy to ensure the exposure depth margin (DOF) at the time of photolithography, which is very preferable.

Further, the present invention also provides, as a tone-reversal patterning process using such a composition for forming a metal oxide film, a process for forming a pattern in a substrate to be processed, comprising the steps of:
(IV-1) forming a resist underlayer film on a substrate to be processed;
(IV-2) forming a resist middle layer film, or a combination of an inorganic hard mask middle layer film selected from a silicon oxide film, a silicon nitride film, and a silicon oxynitride film and an organic thin film on the resist underlayer film;
(IV-3) forming a resist upper layer film on the resist middle layer film, or the combination of the inorganic hard mask middle layer film and the organic thin film by using a photoresist material;
(IV-4) subjecting the resist upper layer film to pattern exposure and then development with a developer to form a pattern in the resist upper layer film;
(IV-5) transferring a pattern to the resist middle layer film or the organic thin film and the inorganic hard mask middle layer film by dry etching while using the resist upper layer film having the formed pattern as a mask;
(IV-6) transferring a pattern to the resist underlayer film by dry etching while using the resist middle layer film or the inorganic hard mask middle layer film having the transferred pattern as a mask;
(IV-7) applying the composition for forming a metal oxide film onto the resist underlayer film having the formed pattern, followed by heating to cover the resist underlayer film with a metal oxide film, thereby filling a space between the resist underlayer film patterns with the metal oxide film;
(IV-8) etching back the metal oxide film covering the resist underlayer film having the formed pattern by a chemical stripper or dry etching to expose an upper surface of the resist underlayer film having the formed pattern;
(IV-9) removing the resist middle layer film or the hard mask middle layer film remaining on the upper surface of the resist underlayer film by dry etching;
(IV-10) removing the resist underlayer film having the formed pattern with its surface exposed by dry etching to form a reverse pattern of an original pattern in the metal oxide film;
(IV-11) processing the substrate to be processed while using the metal oxide film having the formed reversal pattern as a mask to form a tone-reversal pattern in the substrate to be processed.

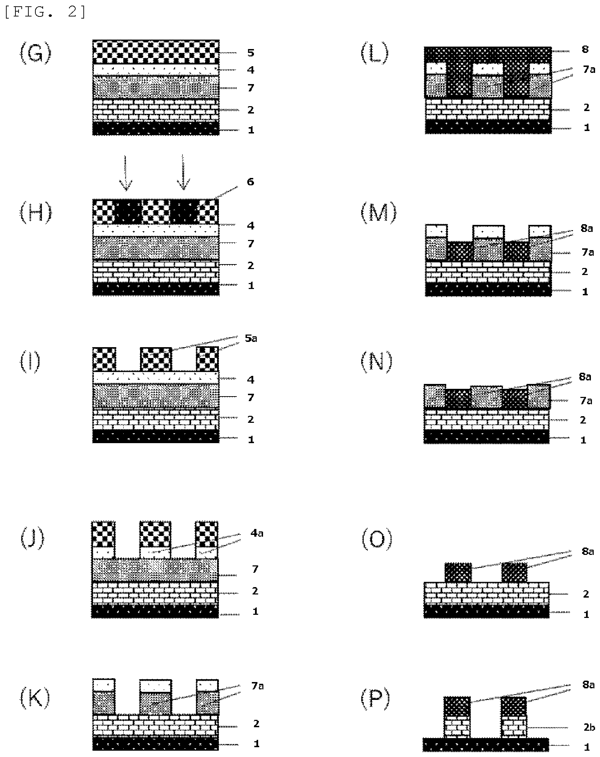

An example of formation of a tone-reversal pattern is specifically explained below by referring to FIG. 2. As shown in FIG. 2(G), a resist underlayer film 7 formed from a coating-type organic underlayer film composition is formed on a layer to be processed 2 stacked on a substrate to be processed 1; thereafter, a silicon atom-containing resist middle layer film 4 is formed, and a resist upper layer film 5 is further formed thereon.

Next, as shown in FIG. 2(H), exposure is conducted for required portion (exposure portion) 6 of the resist upper layer film 5, followed by PEB and development, to form a resist upper layer film pattern 5a (FIG. 2(I)). The obtained resist upper layer film pattern 5a is then used as a mask to etch the silicon atom-containing resist middle layer film 4 using a CF-based gas to form a silicon atom-containing resist middle layer film pattern 4a (FIG. 2(J)). After removing the resist upper layer film pattern 5a, oxygen plasma etching of the resist underlayer film 7 formed from a coating-type organic underlayer film composition is performed while using the obtained silicon atom-containing resist middle layer film pattern 4a as a mask to form a resist underlayer film pattern 7a formed of a coating-type organic underlayer film composition (FIG. 2(K)).

After applying the composition for forming a metal oxide film of the present invention onto the resist underlayer film pattern 7a formed of a coating-type organic underlayer film composition, followed by heating to cover the resist underlayer film pattern with a metal oxide film 8, thereby filling a space between the resist underlayer film patterns 7a formed of a coating-type organic underlayer film composition with the metal oxide film (FIG. 2(L)). Then, the metal oxide film 8 covering the resist underlayer film pattern 7a formed of a coating-type organic underlayer film composition is etched back by a chemical stripper or dry etching, thereby exposing an upper surface of the resist underlayer film pattern 7a formed of a coating-type organic underlayer film composition (FIG. 2(M)). Further, the silicon atom-containing resist middle layer film pattern 4a remaining on the upper surface of the resist underlayer film pattern 7a formed of a coating-type organic underlayer film composition is removed by dry etching (FIG. 2(N)). Subsequently, the resist underlayer film pattern 7a formed of a coating-type organic underlayer film composition is removed by dry etching to form a reverse pattern of the original pattern in the metal oxide film (form a metal oxide film pattern 8a as a reverse pattern of the resist underlayer film pattern) (FIG. 2(O)); after this step, the substrate to be processed is processed while using the metal oxide film pattern 8a as a reverse pattern of the resist underlayer film pattern as a mask to form a tone-reversal pattern 2b in the substrate to be processed (FIG. 2(P)).

As described above, when the resist underlayer film is formed on the substrate to be processed, the resist underlayer film can be formed by a method using a coating-type organic underlayer film composition, a CVD method, an ALD method, or the like. Examples of the coating-type organic underlayer film composition include resins and compositions disclosed in JP 2012-001687 A, JP 2012-077295 A, JP 2004-264710 A, JP 2005-043471 A, JP 2005-250434 A, JP 2007-293294 A, JP 2008-065303 A, JP 2004-205685 A, JP 2007-171895 A, JP 2009-014816 A, JP 2007-199653 A, JP 2008-274250 A, JP 2010-122656 A, JP 2012-214720 A, JP 2014-029435 A, WO 2012/077640 A1, WO 2010/147155 A1, WO 2012/176767 A1, JP 2005-128509 A, JP 2006-259249 A, JP 2006-259482 A, JP 2006-293298 A, JP 2007-316282 A, JP 2012-145897 A, JP 2017-119671 A, JP 2019-044022 A, and the like.

In the tone-reversal patterning process, after the obtained resist underlayer film pattern is coated with the composition for forming a metal oxide film, it is preferable to remove the metal oxide film by dry etching using a chlorine-based gas or an oxygen-based gas so as to expose the upper surface of the resist underlayer film pattern. Thereafter, the resist middle layer film or the inorganic hard mask middle layer film remaining on the resist underlayer film is removed by dry etching using a fluorocarbon-based gas, and the resist underlayer film pattern having an exposed surface is removed by dry etching using an oxygen-based gas to form a metal oxide film pattern.

In the tone-reversal patterning process described above, the resist underlayer film pattern preferably has a step or a structure with a height of 30 nm or more. As described above, the composition for forming a metal oxide film of the present invention has excellent filling and planarizing properties. Thus, even when the film to be processed has a step (irregularities) or a structure with a height of 30 nm or more, a flat cured film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the composition for forming a metal oxide film of the present invention, inversion/transfer of the pattern can be performed with a high degree of accuracy, which is very preferable. Reversing the resist underlayer film pattern using the composition for forming a metal oxide film provides an advantage that a desired resist pattern can be formed on a film to be processed with a high degree of accuracy due to the excellence in resistance in dry etching using a fluorocarbon-based gas relative to the resist underlayer film using a previously-known coating-type organic underlayer film composition.

### Metal Oxide Film Forming Method

The present invention provides a method for forming a resist underlayer film of a multilayer resist film used in lithography or a filling film that serves as a planarizing film (organic planarizing film) used for the manufacture of semiconductor, using the composition for forming a metal oxide film described above.

More specifically, the present invention provides a method for forming a metal oxide film that serves as a planarizing film used in a semiconductor apparatus manufacturing process, the method including applying the composition for forming a metal oxide film onto a substrate to be processed, followed by heating at a temperature of 100°C or higher and 600°C or lower for 10 to 600 seconds to form a cured film.

Further, the present invention also provides a method for forming a metal oxide film that serves as a planarizing film used in a semiconductor apparatus manufacturing process, the method including applying the composition for forming a metal oxide film onto a substrate to be processed, followed by heating under an atmosphere having an oxygen concentration of 1 volume % or more and 21 volume % or less to form a cured film.

Further, the present invention also provides a method for forming a metal oxide film that serves as a planarizing film used in a semiconductor apparatus manufacturing process, the method including applying the composition for forming a metal oxide film onto a substrate to be processed, followed by heating in an atmosphere having an oxygen concentration of less than 1 volume % to form a cured film.

In the method for forming a metal oxide film using the composition for forming a metal oxide film of the present invention, the substrate to be processed is coated with the composition for forming a metal oxide film described above by spin coating or the like. Using the spin coating or the like ensures a desirable filling property. After spin coating, baking (heating) is performed so as to evaporate the solvent, and promote a crosslinking reaction to prevent mixing of the resist upper layer film and the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the metal oxide film forming method using the composition for forming a metal oxide film of the present invention, a substrate to be processed may also be coated with the composition for forming a metal oxide film of the present invention by spin coating or the like in the same manner as described above, and then the composition for forming a metal oxide film may be baked and cured under an atmosphere with an oxygen concentration of 0.1 volume % or more and 21 volume % or less to form a metal oxide film.

By baking the composition for forming a metal oxide film of the present invention in such an oxygen atmosphere, a sufficiently cured film can be obtained. The atmosphere during baking may be air; however, to prevent oxidation of the metal oxide film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal oxide film during the baking, the absorption does not increase and the etching resistance does not decrease, which is preferable.

### EXAMPLES

The present invention is more specifically described below with reference to Synthesis Examples, Comparative Synthesis Examples, Examples, and Comparative Examples. However, the present invention is not limited to these Examples. To obtain molecular weight and dispersity, weight average molecular weight (Mw) and number average molecular weight (Mn) on polystyrene basis were measured by gel permeation chromatography (GPC) using tetrahydrofuran as an eluent, and dispersity (Mw/Mn) was calculated from these values.

### Synthesis Examples

In the following Synthesis Examples, the following starting material group G: (G1) to (G8) and modifying agent group H: (H1) to (H4) were used.

The starting material group G: (G1) to (G8) are shown below.

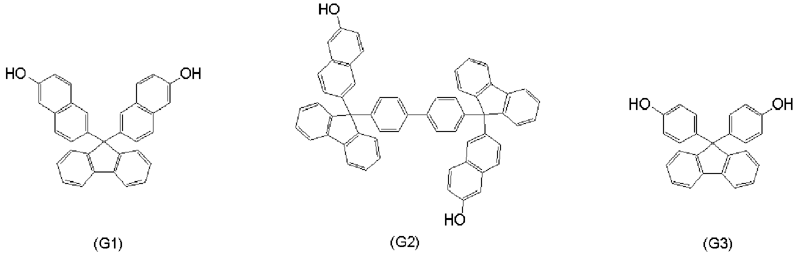

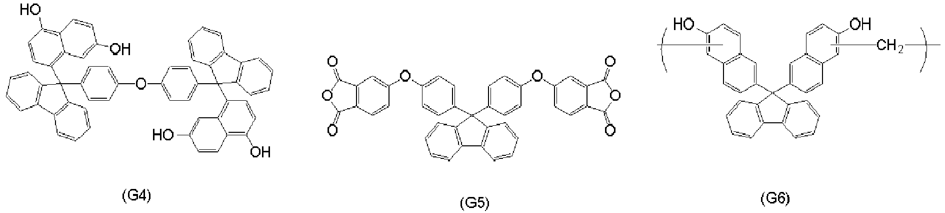

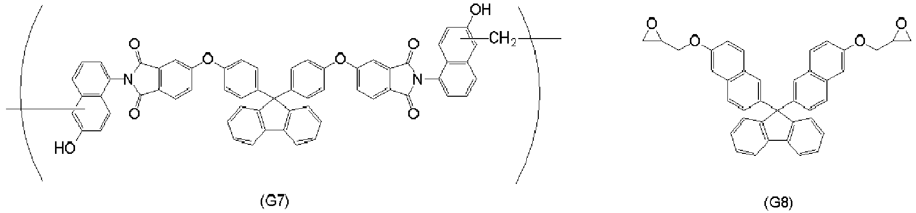

The modifying agent group H: (H1) to (H4) are shown below.

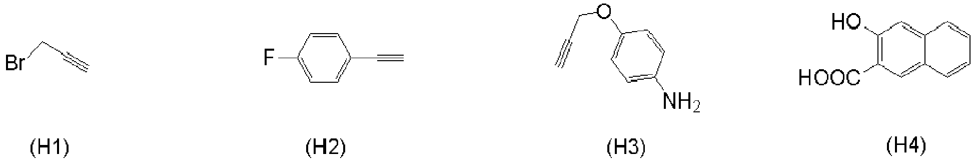

### Synthesis Example 1: Synthesis of Compound (B2) for Flowability Accelerator

In an atmosphere of nitrogen, 42.8 g of the compound (G1) in the starting material group, 15.7 g of potassium carbonate, and 150 g of DMF were added, and a homogeneous dispersion liquid was prepared at an internal temperature of 50°C. 28.2 g of the modifying agent (H1) was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100g of a 3% aqueous nitric acid solution and 100 g of pure water six times, and then the organic layer was dried under reduced pressure to hardness, thereby obtaining a compound (B2) for a flowability accelerator.

The weight average molecular weight (Mw) and the dispersity (Mw/Mn) were determined by GPC, and the following results were obtained.
(B2):Mw=560, Mw/Mn=1.01

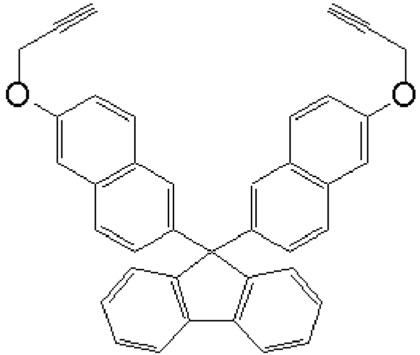

### Synthesis Example 2: Synthesis of Compound (B4) for Flowability Accelerator

In an atmosphere of nitrogen, 45.5 g of the compound (G2) in the starting material group, 9.8 g of potassium carbonate, and 150 g of DMF were added, and a homogeneous dispersion liquid was prepared at an internal temperature of 50°C. 17.6 g of the modifying agent (H1) was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a compound (B4) for a flowability accelerator.

The weight average molecular weight (Mw) and the dispersity (Mw/Mn) were determined by GPC, and the following results were obtained.
(B4):Mw=965, Mw/Mn=1.08

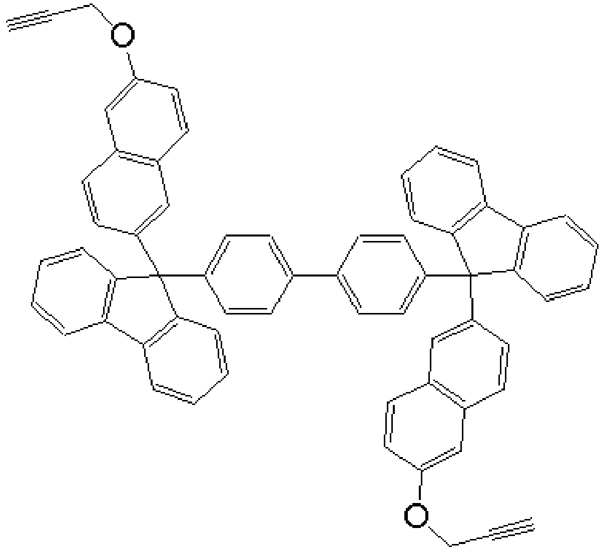

### Synthesis Example 3: Synthesis of Compound (B5) for Flowability Accelerator

In an atmosphere of nitrogen, 20.0 g of the compound (G3) in the starting material group, 16.4 g of the modifying agent (H2), 23.3 g of potassium carbonate, and 200 g of N-methylpyrrolidone were added, followed by a reaction at an internal temperature of 140°C for 24 hours. After cooling at room temperature, 300 ml of methylisobutylketone and 300 ml of pure water were added to a reaction solution for homogenization; thereafter, the separated water layer was removed. Further, the organic layer was washed with 100 ml of a 3% aqueous nitric acid solution twice and washed with 100 ml of pure water five times, and then the organic layer was dried under reduced pressure to hardness. 100 g of THF was added to the residue to yield a homogeneous solution, and a crystal was precipitated by 350 g of methanol. The precipitated crystal was separated by filtration, washed twice with 200 g of methanol, and recovered. The recovered crystal was vacuum-dried at 70°C, thereby obtaining a compound (B5) for a flowability accelerator.

The weight average molecular weight (Mw) and the dispersity (Mw/Mn) were determined by GPC, and the following results were obtained.
(B5):Mw=580, Mw/Mn=1.03

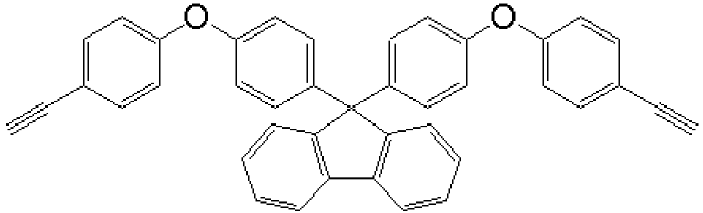

### Synthesis Example 4: Synthesis of Compound (B6) for Flowability Accelerator

In an atmosphere of nitrogen, 45.7 g of the compound (G4) in the starting material group, 9.3 g of potassium carbonate, and 150 g of DMF were added, and a homogeneous dispersion liquid was prepared at an internal temperature of 50°C. 13.4 g of the modifying agent (H1) was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a compound (B6) for a flowability accelerator.

The weight average molecular weight (Mw) and the dispersity (Mw/Mn) were determined by GPC, and the following results were obtained.
(B6):Mw=1,050, Mw/Mn=1.02

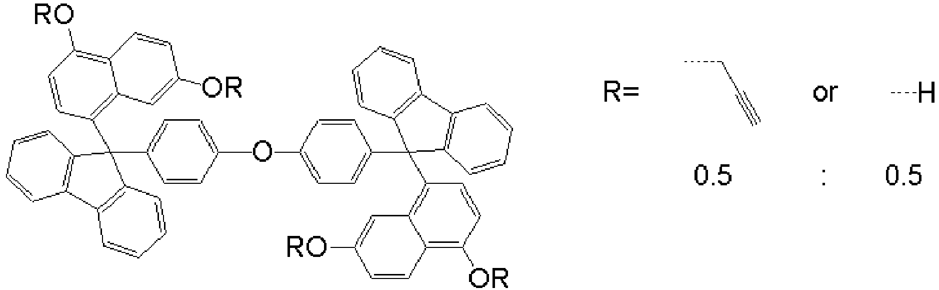

### Synthesis Example 5: Synthesis of Compound (B7) for Flowability Accelerator

In an atmosphere of nitrogen, 100 g of N-methylpyrrolidone was added to 30.00 g of the compound (G5) in the starting material group, and a homogeneous solution was obtained at an internal temperature of 40°C in an atmosphere of nitrogen; thereafter, 13.7 g of the modifying agent (H3) was added, followed by a reaction at an internal temperature of 40°C for 3 hours, thereby obtaining an amide acid solution. 200 g of o-xylene was added to the obtained amide acid solution, and the mixture was reacted at an internal temperature of 150°C for 9 hours while removing the produced low-boiling substance and water from the system, thereby performing dehydrating imidation. The mixture was cooled to room temperature after the reaction and a crystal was precipitated by 1,000 g of methanol. The precipitated crystal was separated by filtration, washed twice with 500 g of methanol, and recovered. The recovered crystal was vacuum-dried at 70°C, thereby obtaining a compound (B7) for a flowability accelerator.

The weight average molecular weight (Mw) and the dispersity (Mw/Mn) were determined by GPC, and the following results were obtained.
(B7):Mw=930, Mw/Mn=1.01

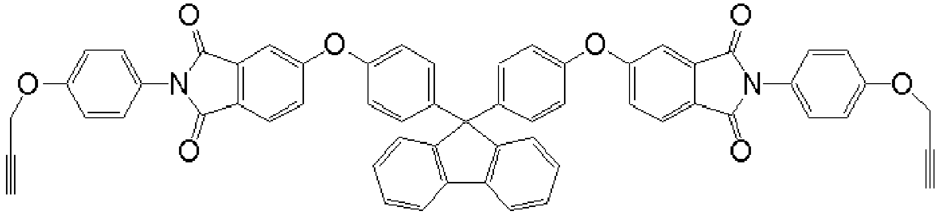

### Synthesis Example 6: Synthesis of Polymer (B9) for Flowability Accelerator

In an atmosphere of nitrogen, 44.7 g of the compound (G6) in the starting material group, 16.5 g of potassium carbonate, and 150 g of DMF were added, and a homogeneous dispersion liquid was prepared at an internal temperature of 50°C. 16.5 g of the modifying agent (H1) was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a polymer (B9) for a flowability accelerator.

The weight average molecular weight (Mw) and the dispersity (Mw/Mn) were determined by GPC, and the following results were obtained.
(B9):Mw=2,500, Mw/Mn=3.10

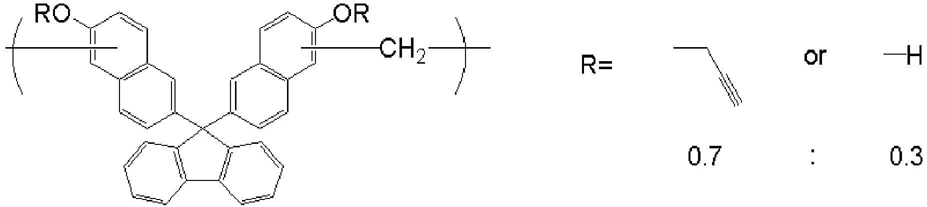

### Synthesis Example 7: Synthesis of Polymer (B10) for Flowability Accelerator

10.0 g of the compound (G2) in the starting material group and 30 ml of 1-methoxy-2-propanol were weighed and placed in a 200 ml three-necked flask, and stirred and dissolved in an oil bath at 75°C in an atmosphere of nitrogen. 0.25 g of paraformaldehyde was added thereto, and 2.5 g of 20% by mass of p-toluenesulfonic monohydrate dissolved in 1-methoxy-2-propanol was added dropwise. After completion of the dropwise addition, the temperature of the oil bath was increased to 85°C, followed by a reaction for 4 hours. After cooling to room temperature, the mixture was diluted with 100 ml of methylisobutylketone, and the insoluble matter was separated by filtration and transferred to a separating funnel, followed by separation washing with 30 ml of ultrapure water eight times. The organic layer was concentrated under reduced pressure to recover a polymer, and the polymer was dried under reduced pressure, thereby obtaining a polymer (B10) for a flowability accelerator.

The weight average molecular weight (Mw) and the dispersity (Mw/Mn) were determined by GPC, and the following results were obtained.
(B10):Mw=4,920, Mw/Mn=1.75

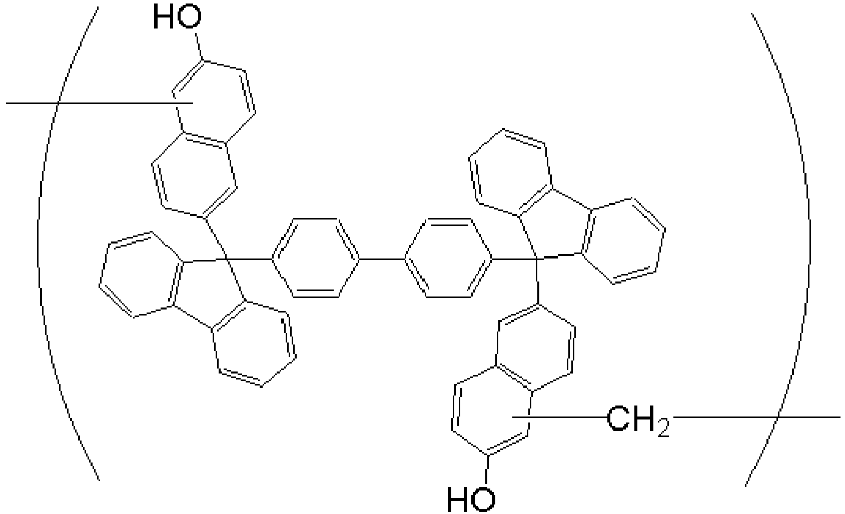

### Synthesis Example 8: Synthesis of Polymer (B11) for Flowability Accelerator

In an atmosphere of nitrogen, 40 g of N-methyl-2-pyrrolidone was added to 8.00 g of the polymer (G7) in the starting material group and 4.72 g of potassium carbonate, and a homogeneous dispersion liquid was prepared at an internal temperature of 50°C in an atmosphere of nitrogen. 4.04 g of the modifying agent (H1) was slowly added, followed by a reaction at an internal temperature of 50°C for 24 hours. 150 g of methylisobutylketone and 50 g of pure water were added to a reaction solution for homogenization; thereafter, the separated water layer was removed. Further, the organic layer was washed with 50 g of a 3% aqueous nitric acid solution and 50 g of pure water six times, and then the organic layer was dried under reduced pressure to hardness. 40 g of THF was added to the residue to yield a homogeneous solution, and a crystal was precipitated by 150 g of methanol. The precipitated crystal was separated by filtration, washed twice with 60 g of methanol, and recovered. The recovered crystal was vacuum-dried at 70°C, thereby obtaining a polymer (B11) for a flowability accelerator.

The weight average molecular weight (Mw) and the dispersity (Mw/Mn) were determined by GPC, and the following results were obtained.
(B 11) : Mw= 3, 740, Mw/Mn=1.55

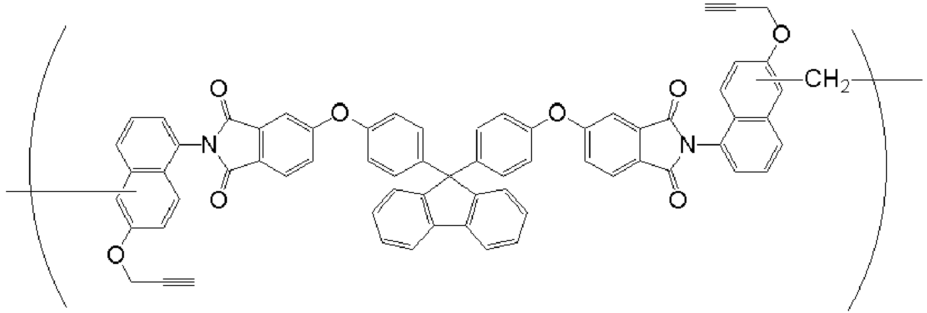

### Comparative Synthesis Example 1: Synthesis of Polymer (R1) for Comparative Flowability Accelerator

23.3 g of PGMEA was heated and stirred at 80°C in an atmosphere of nitrogen. A mixture of 25.8 g of glycidyl methacrylate, 12.0 g of (2-phenoxyethyl) acrylate, 12.9 g of tricyclodecanyl acrylate, and 46.7 g of PGMEA, and a mixture of 4.45 g of dimethyl 2,2-azobis (2-methylpropionate) and 46.7 g of PGMEA were added thereto simultaneously but separately over the course of 2 hours. After further heating and stirring for 16 hours, the mixture was cooled to 60°C, 200 g of heptanes was added; then the mixture was cooled to room temperature and allowed to stand for 2 hours. The upper layer was separated and removed, 100 g of PGMEA was added, and then heptanes were distilled off under reduced pressure, thereby obtaining a target polymer (R1) dissolved in PGMEA.

The weight average molecular weight (Mw) and the dispersity (Mw/Mn) were determined by GPC, and the following results were obtained.
(R1):Mw=7,700, Mw/Mn=1.90

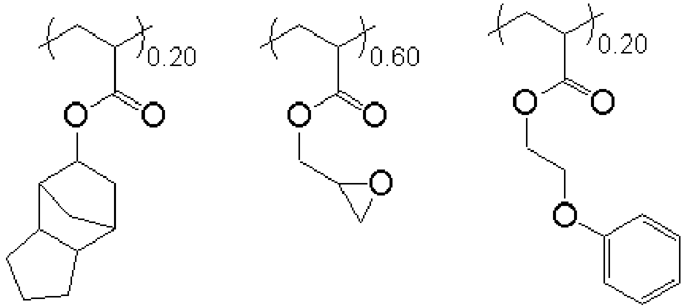

### Comparative Synthesis Example 2: Synthesis of Compound (R3) for Comparative Flowability Accelerator

In an atmosphere of nitrogen, 77.5 g of the compound (G8) in the starting material group, 47.0 g of the modifying agent (H4), and 600 g of 2-methoxy-1-propanol were mixed to yield a homogeneous solution at an internal temperature of 100°C, and then 5.7 g of benzyltriethylammonium chloride was added thereto, followed by stirring at an internal temperature of 120°C for 12 hours. After cooling to room temperature, 1,500 g of methylisobutylketone was added and the organic layer was washed with 300 g of pure water five times. The organic layer was solidified under reduced pressure, thereby obtaining the compound (R3).

The weight average molecular weight (Mw) and the dispersity (Mw/Mn) were determined by GPC, and the following results were obtained.
(R3):Mw=960, Mw/Mn=1.03

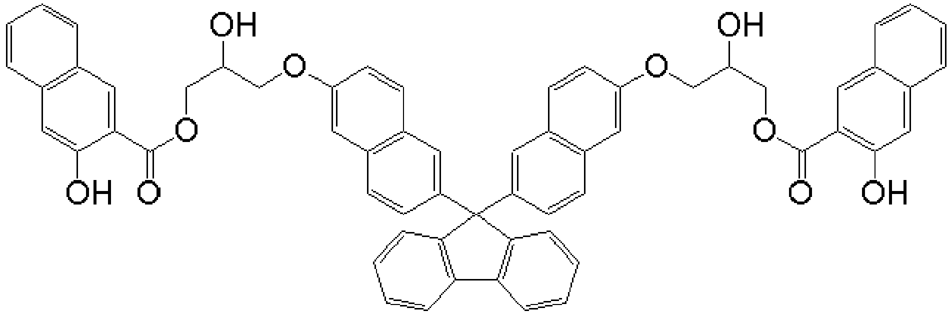

### Comparative Synthesis Example 3: Synthesis of Compound (R4) for Comparative Flowability Accelerator

200 g of the compound (G3) in the starting material group, 75 g of 37% aqueous formalin solution, and 5 g of oxalic acid were added to a 300 ml flask, and reacted at 100°C for 24 hours while stirring. After the reaction, the mixture was dissolved in 500 ml of methylisobutylketone, and then washed thoroughly by water to remove a catalyst and metallic impurities. The solvent was removed under reduced pressure, and then water and unreacted monomers were removed at 150°C by reducing the pressure to 2 mmHg, thereby obtaining the compound (R4).

The weight average molecular weight (Mw) and the dispersity (Mw/Mn) were determined by GPC, and the following results were obtained.
(R4):Mw=6,500, Mw/Mn=5.20

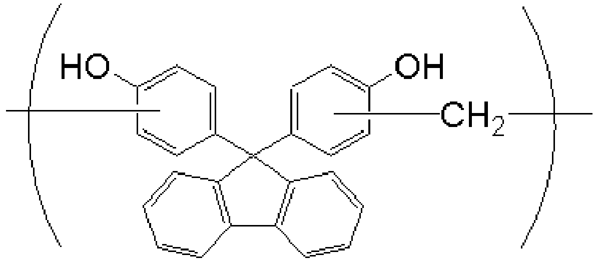

### Comparative Synthesis Example 4: Synthesis of Compound (R5) for Comparative Flowability Accelerator

In an atmosphere of nitrogen, 15.6 g of 2-phenylphenol, 19.1 g of 9-anthracenemethanol, 12.3 g of divinylbenzene, 30 g of cyclopentyl methyl ether (CPME), and 110 g of diethylene glycol dimethyl ether were added, and the mixture was stirred at room temperature for homogeneous dispersion. Thereafter, 1.14 g of trifluorosulfonic acid was slowly added, and the mixture was further stirred for 5 minutes to obtain a homogeneous solution, followed by a reaction for 4 hours in an oil bath at 140°C while removing generated water from the reaction system. The mixture was cooled to room temperature, diluted with 250 g CPME, transferred to a separating funnel, washed four times with ultrapure water, and then the organic layer was dried under reduced pressure to hardness. 120 g of CPME was added to the residue, and a polymer crystal was precipitated by 500 g of hexane. The precipitated crystal was separated by filtration, washed twice with 200 g of hexane, and recovered. The recovered crystal was vacuum-dried at 70°C, thereby obtaining the compound (R5) .

The weight average molecular weight (Mw) and the dispersity (Mw/Mn) were determined by GPC, and the following results were obtained.
(R5):Mw=1,960, Mw/Mn=1.57

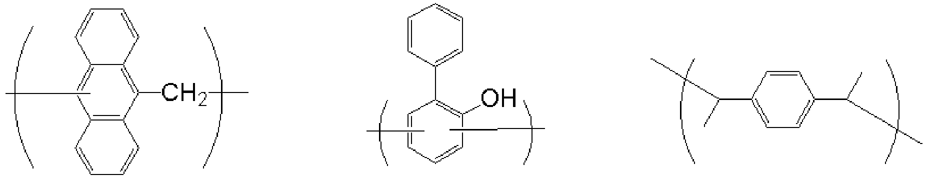

### Blend Polymer Synthesis Example 1: Synthesis of Blend Polymer (BP1)

78.8 g of 2,7-dipropargyloxynaphthalene, 21.6 g of a 37% formalin solution, and 250 g of 1,2-dichloroethane were mixed in an atmosphere of nitrogen at a liquid temperature of 70°C to obtain a homogeneous solution. Thereafter, 5 g of methanesulfonic acid was slowly added to the solution, and the mixture was stirred at a liquid temperature of 80°C for 12 hours. After cooling to room temperature, 500 g of methylisobutylketone was added thereto, and the organic layer was washed with 200 g of pure water five times and dried under reduced pressure to hardness. Then, 300 ml of THF was added to the residue, and the polymer was reprecipitated by 2,000 ml of hexane. The precipitated polymer was separated by filtration and dried under reduced pressure, thereby obtaining the polymer (BP1).

The weight average molecular weight (Mw) and the dispersity (Mw/Mn) were determined by GPC, and the following results were obtained.
(BP1):Mw=2,720, Mw/Mn=1.55

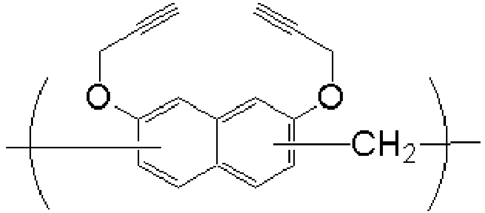

### Blend Polymer Synthesis Example 2: Synthesis of Blend Polymer (BP2)

In an atmosphere of nitrogen, 20.0 g of cresol novolak, 27.6 g of potassium carbonate and 100 g of DMF were added, and a homogeneous dispersion liquid was prepared at an internal temperature of 50°C. 11.9 g of the modifying agent (H1) was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining the resin (BP2).

The weight average molecular weight (Mw) and the dispersity (Mw/Mn) were determined by GPC, and the following results were obtained.
(BP2):Mw=8,500, Mw/Mn=3.46

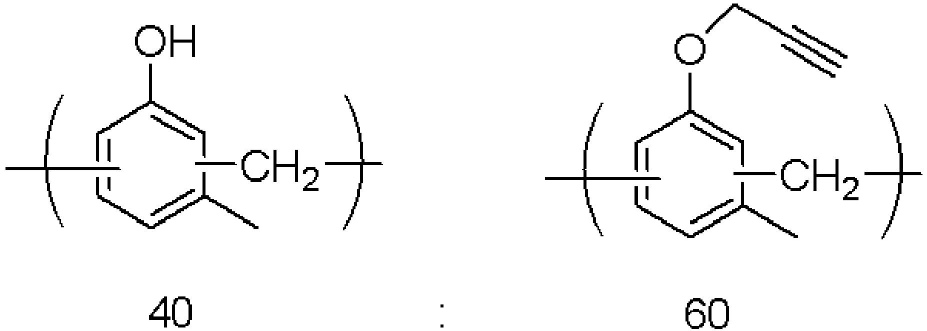

Tables 1 to 3 show the structure, weight average molecular weight (Mw), and dispersity (Mw/Mn) of the obtained compound/polymer for a flowability accelerator and the blend polymer. The (G1) in the starting material group G used as a starting material in Synthesis Examples was used for the compound (B1) for a flowability accelerator, the (G2) in the starting material group G was used for the compound (B3) for a flowability accelerator, the (G6) in the starting material group G was used for the polymer (B8) for a flowability accelerator, and the (G8) in the starting material group G was used for the compound (R2) for a comparative flowability accelerator. R^{a} and R^{b} in the general formulae (I) to (III) representing the compound/polymer for a flowability accelerator of the present invention are hydrocarbon groups and do not contain a heteroatom. Therefore, the compounds R2 and R3 for comparative flowability accelerator are used as Comparative Examples.

**[Table 1]**

| | Compound or Polymer | Mw | Mw /Mn |
|---|---|---|---|
| B1 | 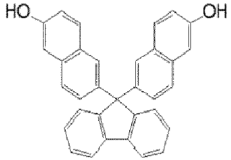 | 480 | 1.02 |
| B2 | 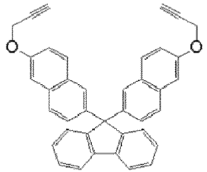 | 560 | 1.01 |
| B3 | 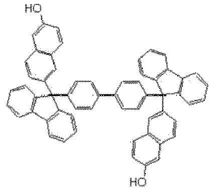 | 801 | 1.07 |
| B4 | 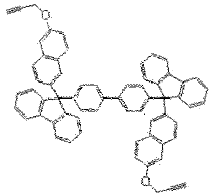 | 965 | 1.08 |
| B5 | 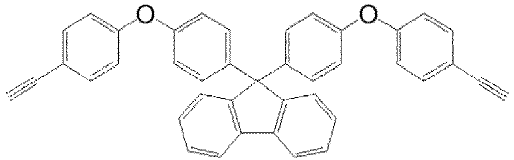 | 580 | 1.03 |
| B6 | 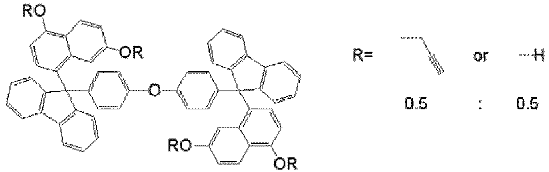 | 105 0 | 1.02 |

**[Table 2]**

| | Compound or Polymer | Mw | Mw /Mn |
|---|---|---|---|
| B7 | 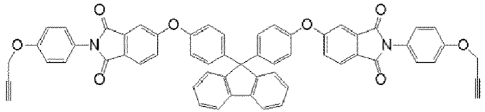 | 930 | 1.01 |
| B8 | 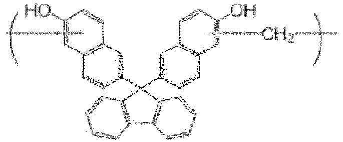 | 3700 | 2.82 |
| B9 | 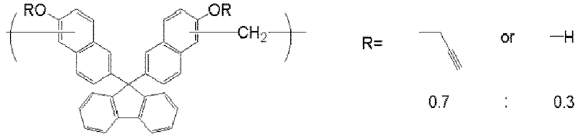 | 2500 | 3.10 |
| B10 | 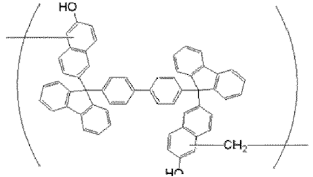 | 4920 | 1.75 |
| B11 | 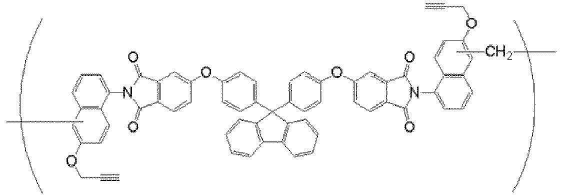 | 3740 | 1.55 |

**[Table 3]**

| | Compound or Polymer | Mw | Mw /Mn |
|---|---|---|---|
| R1 | 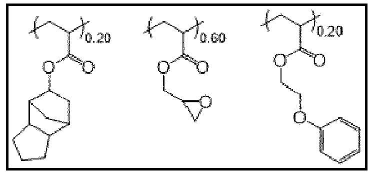 | 7700 | 1.90 |
| R2 | 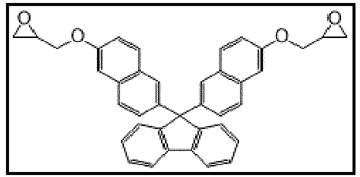 | 580 | 1.03 |
| R3 | 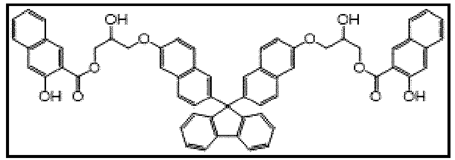 | 960 | 1.03 |
| R4 | 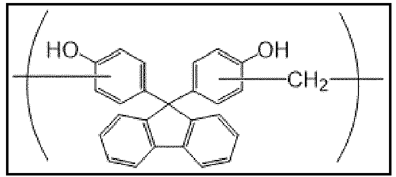 | 6500 | 5.20 |
| R5 | 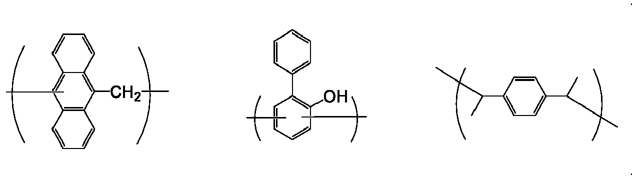 | 1960 | 1.57 |
| BP1 | 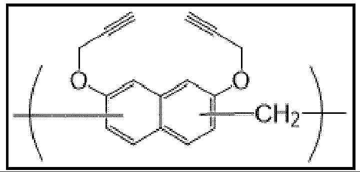 | 2720 | 1.55 |
| BP2 | 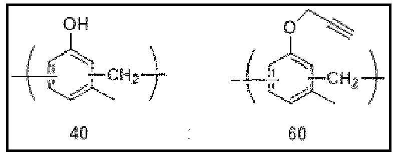 | 8500 | 3.46 |

### (A) Metal Oxide Nanoparticles

ZrO₂ nanoparticles (5 nm core, 915505, Sigma-Aldrich Corp) were used as the (A) metal oxide nanoparticles (A1) used for the composition for forming a metal oxide film.

### (A) Comparative Metal Oxide Compound

24 g of 2,4-dimethyl-2,4-hexanediol was added to 40g of titanium tetrabutoxide tetramer (manufactured by Tokyo Chemical Industry Co., Ltd.) dissolved in 10 g 1-butanol (BuOH), followed by stirring at room temperature for 30 minutes. This solution was concentrated at 50°C under reduced pressure, and further heated to 60°C. The heating was continued under reduced pressure until no distillates were produced. At a point where distillates were no longer observed, 200 g of propylene glycol monomethylether acetate (PGMEA) was added, and the mixture was heated at 50°C under reduced pressure until distillation of BuOH stopped, thereby obtaining 160 g of titanium-containing compound A2 dissolved in PGMEA (compound concentration = 25% by mass). The molecular weight on polystyrene basis of this compound was measured, with the result that Mw = 1,000.

Since the (A2) is not a metal oxide nanoparticle, it is used in the Comparative Examples.

### (D) Crosslinking Agent

The (D) crosslinking agent used for the composition for forming a metal oxide film is shown below.

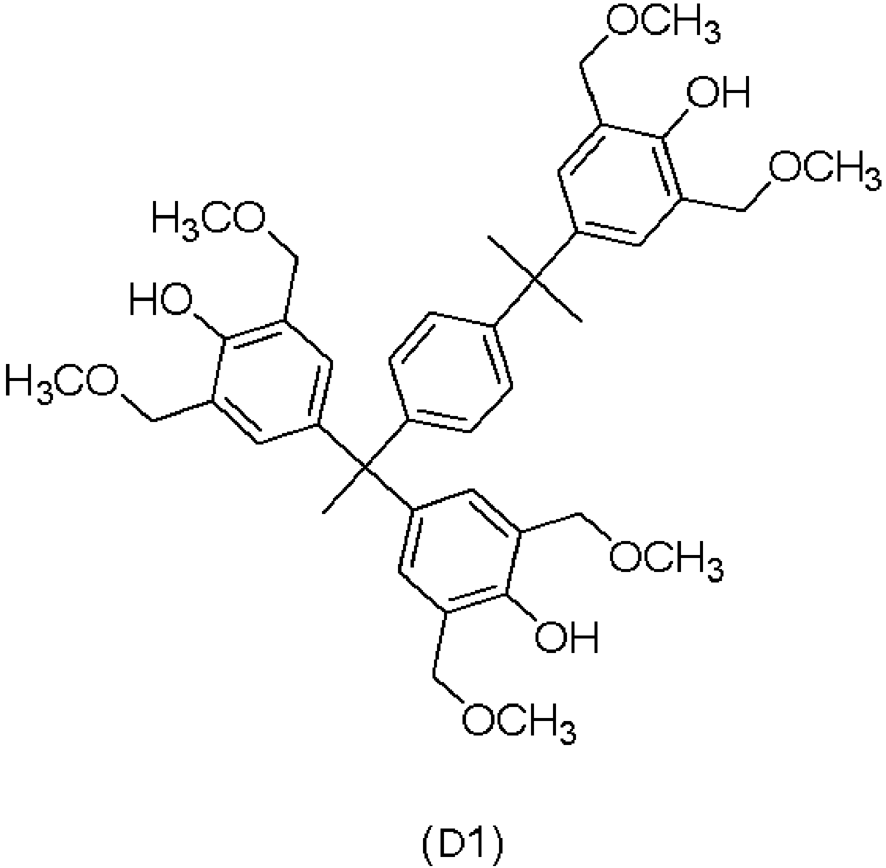

### (E) Thermal Acid Generator

The (E) thermal acid generator used for the composition for forming a metal oxide film is shown below.

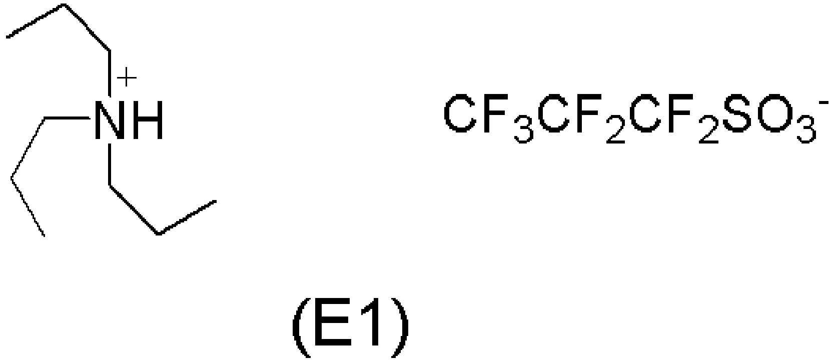

### Composition for Forming a Metal Oxide Film UDL-1

The metal oxide nanoparticles (A1) and the compound (B1) for a flowability accelerator were dissolved at a ratio shown in Table 4 in 1350 parts by mass of propylene glycol monomethylether acetate (PGMEA) containing 0.5% by mass of a surfactant FC-4430 (manufactured by Sumitomo 3M Limited), and the solution was filtered through a 0.02 um membrane filter to prepare a composition for forming a metal oxide film (UDL-1) .

### Compositions for Forming Metal Oxide Film UDL-2 to 18 and Comparative Examples UDL-1 to 11

Each chemical liquid was prepared in the same manner as in UDL-1, except that the type and the content of each component were as shown in Table 4. In Table 4, "-" indicates that the component was not used. The formula (E1) above was used as the acid generator (TAG), and 1,6-diacetoxyhexane (boiling point = 260°C) was used as the high boiling point solvent (F1).

**[Table 4]**

| Composition For Forming a Metal Oxide Film | (A) Metal Oxide Nanoparticles | (B)Compound/Polymer | (D) Crosslinking Agent | (E) Thermal Acid Generator | (F) High Boiling Point Solvent | (BP) Blend Polymer |
|---|---|---|---|---|---|---|
| | (part by mass) | (part by mass) | (part by mass) | (part by mass) | (part by mass) | (part by mass) |
| UDL-1 | A1 (50) | B1 (50) | - | - | | |
| UDL-2 | A1 (50) | B2 (50) | - | - | - | - |
| UDL-3 | A1 (50) | B3 (50) | - | - | - | - |
| UDL-4 | A1 (50) | B4 (50) | - | - | - | - |
| UDL-5 | A1 (50) | B5 (50) | - | - | - | - |
| UDL-6 | A1 (50) | B6 (50) | - | - | - | - |
| UDL-7 | A1 (50) | B7 (50) | - | - | - | - |
| UDL-8 | A1 (50) | B8 (50) | - | - | - | - |
| UDL-9 | A1 (50) | B9 (50) | - | - | - | - |
| UDL-10 | A1 (50) | B10 (50) | - | - | - | - |
| UDL-11 | A1 (50) | B11 (50) | - | - | - | - |
| UDL-12 | A1 (50) | B2 (35) | - | - | - | - |
| | | B8 (15) | | | | |
| UDL-13 | A1 (90) | B1 (10) | - | - | - | - |
| UDL-14 | A1 (10) | B1 (90) | - | - | - | - |
| UDL-15 | A1 (70) | B1 (30) | - | - | - | - |
| UDL-16 | A1 (30) | B1 (70) | - | - | - | - |
| UDL-17 | A1 (50) | B1 (50) | D1 (10) | E1 (2) | F1 (50) | BP1 (50) |
| UDL-18 | A1 (90) | B1 (10) | - | - | - | BP2 (30) |
| Comparative Example UDL-1 | A1 (100) | - | - | - | - | - |
| Comparative Example UDL-2 | - | B1 (100) | - | - | - | - |
| Comparative Example UDL-3 | A1 (50) | R1 (50) | - | - | - | - |
| Comparative Example UDL-4 | A1 (50) | R2(50) | - | - | - | - |
| Comparative Example UDL-5 | A1 (50) | R3(50) | - | - | - | - |
| Comparative Example UDL-6 | A1 (90) | R4(10) | - | - | - | - |
| Comparative Example UDL-7 | A1 (90) | R5(10) | - | - | - | - |
| Comparative Example UDL-8 | A1 (30) | - | - | - | - | BP1(70) |
| Comparative Example UDL-9 | A1 (95) | B1 (5) | - | - | - | - |
| Comparative Example UDL-10 | A1 (5) | B1 (95) | - | - | - | - |
| Comparative Example UDL-11 | A2(70) | B1 (30) | - | - | - | - |

### Filling Property Evaluation: Examples 1-1 to 1-18 and Comparative Examples 1-1 to 1-11

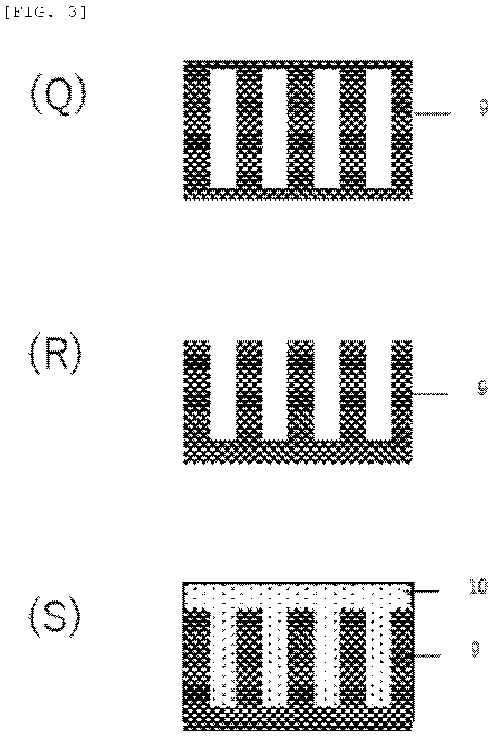

Each of the compositions for forming a metal oxide film described above (UDL-1 to 18 and Comparative Examples UDL-1 to 11) was applied onto a SiO₂ wafer substrate having a dense line-and-space pattern (line width = 40 nm, line depth = 120 nm, distance between the centers of two adjacent lines = 80 nm), followed by heating at 350°C for 60 seconds using a hotplate to form a metal oxide film having a thickness of 100 nm. Similarly by heating at 350°C for 60 seconds in the atmosphere, followed by baking at 450°C for 60 seconds under a nitrogen stream in which the oxygen concentration was controlled to 0.2% or less, a metal oxide film was formed. The substrate used is a base substrate 9 (SiO₂ wafer substrate) having a dense line-and-space pattern shown in FIG. 3(Q) (downward view) and (R) (cross-sectional view). The cross-sectional shape of each of the obtained wafer substrates was observed using an electron microscope (S-4700: manufactured by Hitachi, Ltd.), and the presence/absence of voids (gaps) inside the metal oxide film filled between the lines was confirmed. Table 5 shows the results. In this evaluation, when a composition for forming a metal oxide film having a poor filling property is used, voids are generated inside the metal oxide film filled between the lines. In this evaluation, when a composition for forming a metal oxide film having a desirable filling property is used, as shown in FIG. 3(S), the inside of the metal oxide film filled between the lines of the base substrate 9 having the dense line-and-space pattern is filled with a void-free metal oxide film 10.

**[Table 5]**

| | Composition for Forming a Metal Oxide Film | Baking Temperature | Presence or Absence of Voids (Baking at 350°C) | Presence or Absence of Voids (Baking at 450°C) |
|---|---|---|---|---|
| Example 1-1 | UDL-1 | 350°C×60 seconds | No | No |
| Example 1-2 | UDL-2 | 350°C×60 seconds | No | No |
| Example 1-3 | UDL-3 | 350°C×60 seconds | No | No |
| Example 1-4 | UDL-4 | 350°C×60 seconds | No | No |
| Example 1-5 | UDL-5 | 350°C×60 seconds | No | No |
| Example 1-6 | UDL-6 | 350°C×60 seconds | No | No |
| Example 1-7 | UDL-7 | 350°C×60 seconds | No | No |
| Example 1-8 | UDL-8 | 350°C×60 seconds | No | No |
| Example 1-9 | UDL-9 | 350°C×60 seconds | No | No |
| Example 1-10 | UDL-10 | 350°C×60 seconds | No | No |
| Example 1-11 | UDL-11 | 350°C×60 seconds | No | No |
| Example 1-12 | UDL-12 | 350°C×60 seconds | No | No |
| Example 1-13 | UDL-13 | 350°C×60 seconds | No | No |
| Example 1-14 | UDL-14 | 350°C×60 seconds | No | No |
| Example 1-15 | UDL-15 | 350°C×60 seconds | No | No |
| Example 1-16 | UDL-16 | 350°C×60 seconds | No | No |
| Example 1-17 | UDL-17 | 350°C×60 seconds | No | No |
| Example 1-18 | UDL-18 | 350°C×60 seconds | No | No |
| Comparative Example 1-1 | Comparative Example UDL-1 | 350°C×60 seconds | Yes | Yes |
| Comparative Example 1-2 | Comparative Example UDL-2 | 350°C×60 seconds | No | No |
| Comparative Example 1-3 | Comparative Example UDL-3 | 350°C×60 seconds | Yes | Yes |
| Comparative Example 1-4 | Comparative Example UDL-4 | 350°C×60 seconds | No | Yes |
| Comparative Example 1-5 | Comparative Example UDL-5 | 350°C×60 seconds | No | Yes |
| Comparative Example 1-6 | Comparative Example UDL-6 | 350°C×60 seconds | Yes | Yes |
| Comparative Example 1-7 | Comparative Example UDL-7 | 350°C×60 seconds | Yes | Yes |
| Comparative Example 1-8 | Comparative Example UDL-8 | 350°C×60 seconds | No | Yes |
| Comparative Example 1-9 | Comparative Example UDL-9 | 350°C×60 seconds | Yes | Yes |
| Comparative Example 1-10 | Comparative Example UDL-10 | 350°C×60 seconds | No | No |
| Comparative Example 1-11 | Comparative Example UDL-11 | 350°C×60 seconds | Yes | Yes |

It could be confirmed that, as shown in Table 5, Examples 1-1 to 1-18 using the compositions for forming a metal oxide film (UDL-1 to 18) of the present invention was capable of filling the dense line-and-space pattern without generation of voids and thus had an excellent filling property. In Comparative Examples 1-1 and 1-9 in which the weight ratio of the metal oxide nanoparticles to the flowability accelerator was outside the range of the present invention, voids were observed at the time of baking at 350°C due to low thermal flowability. In contrast, since the composition for forming a metal oxide film of the present invention contains an optimum amount of the compound or polymer for a flowability accelerator having excellent thermal flowability, a metal oxide film having an excellent filling property was successfully formed. In Comparative Example 1-3, it is presumed that, since the heat resistance of the polymer (R1) for a flowability accelerator with no cardo structure is insufficient, voids are generated at the time of baking at 350°C. In addition, in Comparative Examples 1-4 to 1-5, although the flowability of the compound for a flowability accelerator was desirable, it is assumed that, since the R2 and R3 used in these Comparative Examples contain a heteroatom in a portion corresponding to R^{a} of the compound for a flowability accelerator of the present invention, voids are generated by baking at 450°C due to insufficient heat resistance. Also in Comparative Example 1-8 in which the metal oxide nanoparticles and the blend polymer (BP1) were used in combination without using the flowability accelerator (thermal flowability accelerator) of the present invention, it is assumed that voids are generated by baking at 450°C for the same reason. In comparison in terms of a composition having a weight ratio of the metal oxide nanoparticles to the flowability accelerator of 90/10, generation of voids was observed at the time of baking at 350°C in Comparative Example 1-7; however, Example 1-13 of the present invention exhibited a desirable filling property at the time of baking at 350°C and 450°C. This is presumably because of the influence of the cardo structure contained in the structure of the compound or the polymer for a flowability accelerator used in the composition for forming a metal oxide film of the present invention, which provides a desirable thermal flowability. On the other hand, in Comparative Example 1-6, it is assumed that, although the polymer R4 having a cardo structure was used, since the molecular weight was large and the thermal flowability was insufficient, voids were generated at the time of baking at 350°C. In Comparative Example 1-11 in which the metal oxide compound (A2) was used instead of metal oxide nanoparticles, voids and peeling from the substrate were observed. This is presumably because the heat resistance of the metal oxide compound is poor and the thermal shrinkage during the baking at 350°C is large.

### Planarizing Property Evaluation: Examples 2-1 to 2-18 and Comparative Examples 2-1 to 2-11

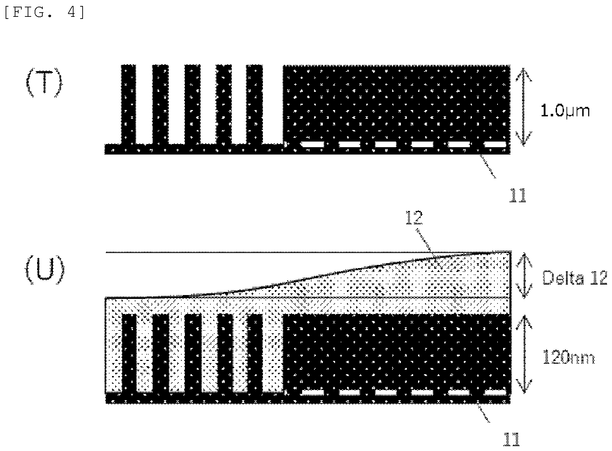

Each of the compositions for forming a metal oxide film described above (UDL-1 to 18 and Comparative Examples UDL-1 to 11) was applied onto a SiO₂ wafer substrate having a dense line-and-space pattern (line width = 40 nm, line depth = 120 nm, distance between the centers of two adjacent lines = 80 nm), followed by heating at 350°C for 60 seconds using a hotplate to form a metal oxide film having a thickness of 100 nm. The substrate used is a base substrate 11 (SiO₂ wafer substrate) having a dense line-and-space pattern shown in FIG. 4(T) (cross-sectional view). The cross sectional shape of each of the wafer substrates in which the metal oxide film 12 is formed as a filling film was observed using a scanning electron microscope (SEM), and the step (Delta 12 in FIG. 4(U)) between the line pattern dense portion and the non-line pattern portion of the filling film was observed using an electron microscope (S-4700: manufactured by Hitachi, Ltd.). Table 6 shows the results. In this evaluation, the smaller the step, superior the planarizing property.

**[Table 6]**

| | Composition for Forming a Metal Oxide Film | Baking Temperature | Step (nm) Baking at 350°C |
|---|---|---|---|
| Example 2-1 | UDL-1 | 350°C×60 seconds | 50 |
| Example 2-2 | UDL-2 | 350°C×60 seconds | 50 |
| Example 2-3 | UDL-3 | 350°C×60 seconds | 60 |
| Example 2-4 | UDL-4 | 350°C×60 seconds | 55 |
| Example 2-5 | UDL-5 | 350°C×60 seconds | 45 |
| Example 2-6 | UDL-6 | 350°C×60 seconds | 55 |
| Example 2-7 | UDL-7 | 350°C×60 seconds | 60 |
| Example 2-8 | UDL-8 | 350°C×60 seconds | 60 |
| Example 2-9 | UDL-9 | 350°C×60 seconds | 55 |
| Example 2-10 | UDL-10 | 350°C×60 seconds | 65 |
| Example 2-11 | UDL-11 | 350°C×60 seconds | 65 |
| Example 2-12 | UDL-12 | 350°C×60 seconds | 55 |
| Example 2-13 | UDL-13 | 350°C×60 seconds | 70 |
| Example 2-14 | UDL-14 | 350°C×60 seconds | 40 |
| Example 2-15 | UDL-15 | 350°C×60 seconds | 55 |
| Example 2-16 | UDL-16 | 350°C×60 seconds | 45 |
| Example 2-17 | UDL-17 | 350°C×60 seconds | 45 |
| Example 2-18 | UDL-18 | 350°C×60 seconds | 40 |
| Comparative Example 2-1 | Comparative Example UDL-1 | 350°C×60 seconds | 90 |
| Comparative Example 2-2 | Comparative Example UDL-2 | 350°C×60 seconds | 40 |
| Comparative Example 2-3 | Comparative Example UDL-3 | 350°C×60 seconds | 80 |
| Comparative Example 2-4 | Comparative Example UDL-4 | 350°C×60 seconds | 65 |
| Comparative Example 2-5 | Comparative Example UDL-5 | 350°C×60 seconds | 60 |
| Comparative Example 2-6 | Comparative Example UDL-6 | 350°C×60 seconds | 85 |
| Comparative Example 2-7 | Comparative Example UDL-7 | 350°C×60 seconds | 85 |
| Comparative Example 2-8 | Comparative Example UDL-8 | 350°C×60 seconds | 40 |
| Comparative Example 2-9 | Comparative Example UDL-9 | 350°C×60 seconds | 85 |
| Comparative Example 2-10 | Comparative Example UDL-10 | 350°C×60 seconds | 40 |
| Comparative Example 2-11 | Comparative Example UDL-11 | 350°C×60 seconds | Peeling Observed |

As shown in Table 6, it was confirmed that, in comparison in terms of a composition having a weight ratio of the metal oxide nanoparticles to the flowability accelerator of 50/50, Examples 2-1 to 2-12 using the composition for forming a metal oxide film of the present invention had a small step between the line pattern dense portion and the non-line pattern portion of the filling film and had an excellent planarizing property, compared with Comparative Example 2-3 using a polymer for a flowability accelerator with no cardo structure. Similarly, it was confirmed that, in comparison in terms of a composition having a weight ratio of the metal oxide nanoparticles to the flowability accelerator of 90/10, Example 2-13 had a small step between the line pattern dense portion and the non-line pattern portion of the filling film and had an excellent planarizing property, compared with Comparative Example 2-7 using a polymer for a flowability accelerator with no cardo structure. This is presumably because the structure of the compound or polymer for a flowability accelerator used in the composition for forming a metal oxide film of the present invention has a cardo structure excellent in heat resistance and exhibits a desirable thermal flowability, and the compound or polymer contains an optimal amount of a hydroxyl group, a propargyloxy group, or the like excellent in reactivity, and thus can form a cured film having small thermal shrinkage during baking. Since Comparative Examples 2-4 and 2-5 also contain a flowability accelerator compound having a cardo structure, the planarizing property was desirable. In contrast, in Comparative Example 2-6, it is assumed that, although the polymer R4 having a cardo structure was used, since the molecular weight was large and the thermal flowability was insufficient, the planarizing property was insufficient. In Examples 2-17 and 2-18 in which a high boiling point solvent and/or a blend polymer were added, it was confirmed that the planarizing property was further improved by adding the high boiling point solvent and/or the blend polymer. In addition, in Example 2-9 using a flowability accelerator having both a hydroxyl group and a propargyloxy group in a more preferable range, it was confirmed that the planarizing property was improved compared with Example 2-8 using a flowability accelerator having only a hydroxyl group. This is presumably because the propargyloxy group, which contributes to the flowability, and the hydroxyl group, which contributes to the adhesiveness and the heat resistance, were optimally balanced, and a film having excellent thermal flowability and thermal shrinkage resistance was formed. In Comparative Example 2-9 in which the weight ratio of the metal oxide nanoparticles to the flowability accelerator is 95/5, the improvement in the planarizing property from the case using the metal oxide nanoparticles alone (Comparative Example 2-1) was small; thus, it can be said that the weight ratio of the flowability accelerator of 10 or more is essential to exhibit the thermal flowability effect of the flowability accelerator.

### Evaluation of Resistance in Etching with CF₄ Gas (Examples 3-1 to 3-18 and Comparative Examples 3-1 to 3-11)

Each of the compositions for forming a metal oxide film (UDL-1 to 18 and Comparative UDL-1 to 11) prepared above was applied onto a silicon substrate and the substrate was baked in the atmosphere at 350°C for 60 seconds to form a 100 nm coating film, and the film thickness "a" was measured. Next, etching with CF₄ gas was performed for 1 minute under the following conditions using an etching apparatus Telius manufactured by Tokyo Electron Ltd., and the film thickness "b" was measured. The film thickness etched in one minute (thickness "b"-thickness "a") was calculated as the etching resistance, and the case where the thickness difference between B and A was less than 60 nm was evaluated as "A" (significantly desirable), the case where the thickness difference was 60 nm or more and less than 70 nm was evaluated as "B" (desirable), and the case where the thickness difference was 70 nm or more was evaluated as "C" (poor). Table 7 shows the results.

### Conditions of Dry Etching with CF₄ Gas

Chamber pressure: 100 mT
RF-power (upper portion): 500W
RF-power (lower portion): 400W
CF₄ gas flow rate: 300 sccm
Time: 60 sec

**[Table 7]**

| | Composition For Forming a Metal Oxide Film | Baking Temperature | CF₄ Etching Resistance |
|---|---|---|---|
| Example 3-1 | UDL-1 | 350°C×60 seconds | A |
| Example 3-2 | UDL-2 | 350°C×60 seconds | A |
| Example 3-3 | UDL-3 | 350°C×60 seconds | A |
| Example 3-4 | UDL-4 | 350°C×60 seconds | A |
| Example 3-5 | UDL-5 | 350°C×60 seconds | A |
| Example 3-6 | UDL-6 | 350°C×60 seconds | A |
| Example 3-7 | UDL-7 | 350°C×60 seconds | A |
| Example 3-8 | UDL-8 | 350°C×60 seconds | A |
| Example 3-9 | UDL-9 | 350°C×60 seconds | A |
| Example 3-10 | UDL-10 | 350°C×60 seconds | A |
| Example 3-11 | UDL-11 | 350°C×60 seconds | A |
| Example 3-12 | UDL-12 | 350°C×60 seconds | A |
| Example 3-13 | UDL-13 | 350°C×60 seconds | A |
| Example 3-14 | UDL-14 | 350°C×60 seconds | B |
| Example 3-15 | UDL-15 | 350°C×60 seconds | A |
| Example 3-16 | UDL-16 | 350°C×60 seconds | B |
| Example 3-17 | UDL-17 | 350°C×60 seconds | A |
| Example 3-18 | UDL-18 | 350°C×60 seconds | A |
| Comparative Example 3-1 | Comparative Example UDL-1 | 350°C×60 seconds | A |
| Comparative Example 3-2 | Comparative Example UDL-2 | 350°C×60 seconds | C |
| Comparative Example 3-3 | Comparative Example UDL-3 | 350°C×60 seconds | C |
| Comparative Example 3-4 | Comparative Example UDL-4 | 350°C×60 seconds | C |
| Comparative Example 3-5 | Comparative Example UDL-5 | 350°C×60 seconds | C |
| Comparative Example 3-6 | Comparative Example UDL-6 | 350°C×60 seconds | A |
| Comparative Example 3-7 | Comparative Example UDL-7 | 350°C×60 seconds | A |
| Comparative Example 3-8 | Comparative Example UDL-8 | 350°C×60 seconds | C |
| Comparative Example 3-9 | Comparative Example UDL-9 | 350°C×60 seconds | A |
| Comparative Example 3-10 | Comparative Example UDL-10 | 350°C×60 seconds | C |
| Comparative Example 3-11 | Comparative Example UDL-11 | 350°C×60 seconds | A |

As shown in Table 7, it was confirmed that, in comparison in terms of a composition having a weight ratio of the metal oxide nanoparticles to the flowability accelerator of 50/50, Examples 3-1 to 3-12 using the composition for forming a metal oxide film of the present invention had an excellent etching resistance with respect to CF₄-based gas, compared with Comparative Examples 3-3 to 3-5. On the other hand, in Comparative Example 3-8 in which the metal oxide nanoparticles and the blend polymer (BP1) were used in combination, since the thermal flowability accelerator of the present invention having an excellent dry etching resistance was not contained, insufficient etching resistance was observed. Further, in contrast to Comparative Example 3-10 in which the weight ratio between the metal oxide nanoparticles and the flowability accelerator is 5/95, Example 3-14 having a weight ratio of 10/90 showed evident improvement in etching resistance; thus, it is assumed that the weight ratio of the metal oxide nanoparticles is preferably 10 or more to exhibit characteristic dry etching resistance. Such results presumably derive from the effect that the structure of the compound or polymer for a flowability accelerator used in the composition for forming a metal oxide film of the present invention has a rigid cardo structure and also contains a hydroxyl group, a propargyloxy group, or the like excellent in reactivity, and thus can form a dense cured film. The evaluation results of the filling property and the planarizing property revealed that the composition for forming a metal oxide film of the present invention is a composition having a filling property and a planarizing property close to those of previously-known coating-type organic underlayer film composition, and also exhibiting significantly excellent dry etching resistance as compared with previously-known coating-type organic underlayer film composition. That is, in the composition for forming a metal oxide film of the present invention, by adjusting the weight ratio of the metal oxide nanoparticles to the flowability accelerator within the range of 10/90 to 90/10, it is possible to provide a composition for forming a metal oxide film having both excellent filling/planarizing properties and etching resistance. If it is more desirable to exhibit the filling/planarizing properties as the characteristics, the weight ratio between the metal oxide nanoparticles and the flowability accelerator may be set such that "flowability accelerator>metal oxide nanoparticles"; on the other hand, if it is more desirable to exhibit the etching resistance as the characteristics, the weight ratio between the metal oxide nanoparticles and the flowability accelerator may be set such that "flowability accelerator<metal oxide nanoparticles". In addition, if it is more desirable to further highly exhibit the filling/planarizing properties and dry etching resistance, the weight ratio between the metal oxide nanoparticles and the flowability accelerator is preferably adjusted within the range of 30/70 to 70/30.

### Patterning Process: Examples 4-1 to 4-18 and Comparative Examples 4-1 to 4-11

The compositions for forming a metal oxide film described above (UDL-1 to 18, Comparative UDL-1 to 11) were each applied onto a SiO₂ wafer substrate having a trench pattern (trench width: 10 um, trench depth: 0.10 µm), and baked at 350°C for 60 seconds in the atmosphere to form an organic film having a thickness of 100 nm. A CVD-SiON hard mask was formed thereon, and an organic antireflective film composition (ARC-29A: manufactured by Nissan Chemical Corporation) was further applied thereto, followed by baking at 210°C for 60 seconds to form an organic antireflective film having a thickness of 80 nm; then, a monolayer resist for ArF as a resist upper layer film composition was applied thereon, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The resist upper layer film composition (monolayer resist for ArF) was prepared by dissolving a polymer (RP1), an acid generator (PAG1), and a basic compound (Amine1), each in the proportion shown in Table 8, in a solvent containing 0.1% by mass of a surfactant (FC-4430: manufactured by Sumitomo 3M Limited), and filtering the solution through a 0.1-pm filter made of a fluororesin.

**[Table 8]**

| | Polymer (part by mass) | Acid Generator (part by mass) | Basic Compound (part by mass) | Solvent (part by mass) |
|---|---|---|---|---|
| Monolayer Resist for ArF | RP1 (100) | PAG1 (6.6) | Amine1 (0.8) | PGMEA (2500) |

The polymer (RP1), the acid generator (PAG1), and the basic compound (Amine1) used for the resist upper layer film composition (monolayer resist for ArF) are shown below.

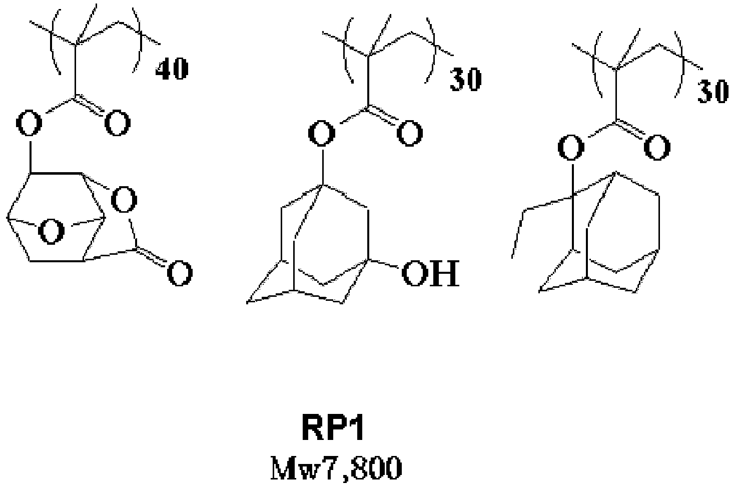

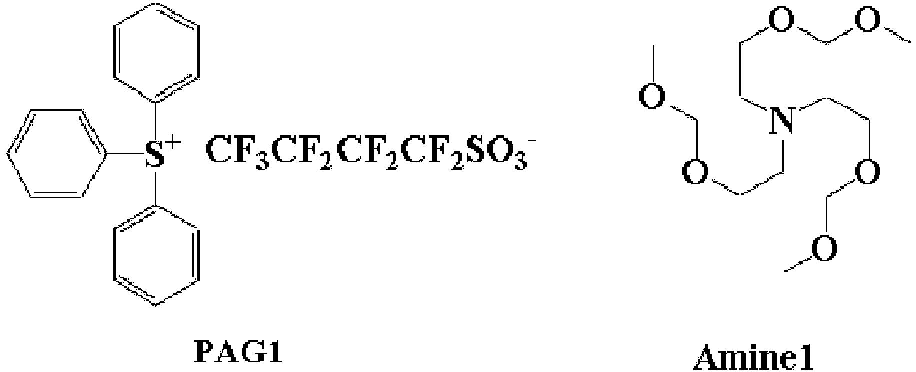

The liquid immersion top coat composition (TC-1) was prepared by dissolving a top coat polymer (PP1) in an organic solvent at the proportion shown in Table 9, and filtering the solution through a 0.1-pm filter made of a fluororesin.

**[Table 9]**

| | Polymer (part by mass) | Organic Solvent (part by mass) |
|---|---|---|
| TC-1 | PP1 (100) | Diisoamyl Ether (2700) 2-Methyl-1-Butanol (270) |

The polymer (PP1) used for the liquid immersion top coat composition (TC-1) is shown below.

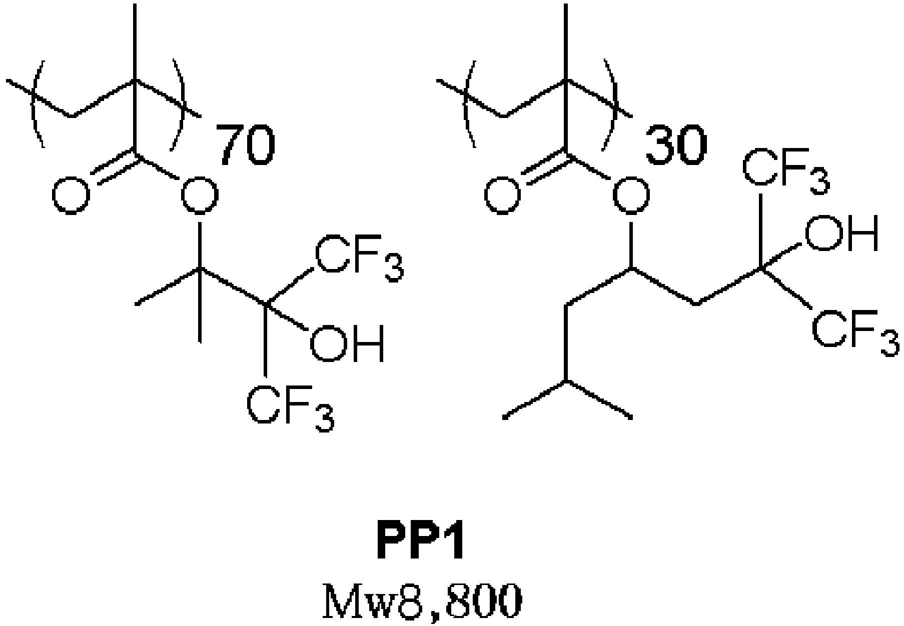

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38 % by mass of tetramethylammonium hydroxide (TMAH) aqueous solution for 30 seconds, thereby obtaining a 55 nm 1:1 positive line-and-space pattern (a resist pattern).

Then, the organic antireflective film and the CVD-SiON hard mask were etched by dry etching while using the resist pattern as a mask and an etching apparatus Telius manufactured by Tokyo Electron Ltd. to form a hard mask pattern. Then, a metal oxide film was etched while using the obtained hard mask pattern as a mask to form a metal oxide film pattern, and the SiO₂ film was etched using the obtained metal oxide film pattern as a mask. The etching conditions are as follows.

### Conditions in transferring resist pattern to SiON hard mask

Chamber pressure: 50 mT
RF-power (upper portion): 500W
RF-power (lower portion): 300W
CF₄ gas flow rate: 150 sccm
CHF₃ gas flow rate: 50 sccm
Time: 20 sec

### Conditions in transferring SiON hard mask pattern to metal oxide film

Chamber pressure: 15 mT
RF-power (upper portion): 300W
RF-power (lower portion): 50W
O₂ gas flow rate: 30 sccm
N₂ gas flow rate: 270 sccm
Time: 300 sec

### Conditions in transferring metal oxide film pattern to SiO₂ film

Chamber pressure: 10 mT
RF-power (upper portion): 100W
RF-power (lower portion): 800W
CF₄ gas flow rate: 25 sccm
CHF₃ gas flow rate: 15 sccm
O₂ gas flow rate: 5 sccm
Time: 200 sec

Table 10 shows the results obtained by observation of the pattern cross section with an electron microscope (S-4700) manufactured by Hitachi, Ltd.

**[Table 10]**

| | Composition For Forming a Metal Oxide Film | Baking Temperature | Pattern Shape After Substrate Transfer Etching |
|---|---|---|---|
| Example 4-1 | UDL-1 | 350°C×60 seconds | Vertical Shape |
| Example 4-2 | UDL-2 | 350°C×60 seconds | Vertical Shape |
| Example 4-3 | UDL-3 | 350°C×60 seconds | Vertical Shape |
| Example 4-4 | UDL-4 | 350°C×60 seconds | Vertical Shape |
| Example 4-5 | UDL-5 | 350°C×60 seconds | Vertical Shape |
| Example 4-6 | UDL-6 | 350°C×60 seconds | Vertical Shape |
| Example 4-7 | UDL-7 | 350°C×60 seconds | Vertical Shape |
| Example 4-8 | UDL-8 | 350°C×60 seconds | Vertical Shape |
| Example 4-9 | UDL-9 | 350°C×60 seconds | Vertical Shape |
| Example 4-10 | UDL-10 | 350°C×60 seconds | Vertical Shape |
| Example 4-11 | UDL-11 | 350°C×60 seconds | Vertical Shape |
| Example 4-12 | UDL-12 | 350°C×60 seconds | Vertical Shape |
| Example 4-13 | UDL-13 | 350°C×60 seconds | Vertical Shape |
| Example 4-14 | UDL-14 | 350°C×60 seconds | Vertical Shape |
| Example 4-15 | UDL-15 | 350°C×60 seconds | Vertical Shape |
| Example 4-16 | UDL-16 | 350°C×60 seconds | Vertical Shape |
| Example 4-17 | UDL-17 | 350°C×60 seconds | Vertical Shape |
| Example 4-18 | UDL-18 | 350°C×60 seconds | Vertical Shape |
| Comparative Example 4-1 | Comparative Example UDL-1 | 350°C×60 seconds | Pattern Collapse Observed |
| Comparative Example 4-2 | Comparative Example UDL-2 | 350°C×60 seconds | Pattern Distortion Observed |
| Comparative Example 4-3 | Comparative Example UDL-3 | 350°C×60 seconds | Pattern Collapse Observed |
| Comparative Example 4-4 | Comparative Example UDL-4 | 350°C×60 seconds | Pattern Distortion Observed |
| Comparative Example 4-5 | Comparative Example UDL-5 | 350°C×60 seconds | Pattern Distortion Observed |
| Comparative Example 4-6 | Comparative Example UDL-6 | 350°C×60 seconds | Pattern Collapse Observed |
| Comparative Example 4-7 | Comparative Example UDL-7 | 350°C×60 seconds | Pattern Collapse Observed |
| Comparative Example 4-8 | Comparative Example UDL-8 | 350°C×60 seconds | Pattern Distortion Observed |
| Comparative Example 4-9 | Comparative Example UDL-9 | 350°C×60 seconds | Pattern Collapse Observed |
| Comparative Example 4-10 | Comparative Example UDL-10 | 350°C×60 seconds | Pattern Distortion Observed |
| Comparative Example 4-11 | Comparative Example UDL-11 | 350°C×60 seconds | Pattern Collapse Observed |

As shown in Table 10, Examples 4-1 to 4-18 using the composition for forming a metal oxide film of the present invention (UDL-1 to 18) were all capable of desirably transferring the resist upper layer film pattern to the substrate in the end, and it was thus confirmed that the composition for forming a metal oxide film of the present invention can be suitably used for fine processing by way of the multilayer resist method. On the other hand, in Comparative Examples 4-1, 4-3, 4-6, 4-7, 4-9, and 4-11 in which insufficient performance was confirmed in the evaluation of filling property and the evaluation of planarizing property, pattern collapse occurred at the time of pattern processing, and a desirable pattern could not be obtained in the end. In addition, in Comparative Examples 4-2, 4-4, 4-5, 4-8, and 4-10 in which the evaluation of the filling property and the evaluation of the planarization property were desirable but the performance was found insufficient in the evaluation of the dry etching resistance, distortion of the pattern shape occurred at the time of pattern processing, and a desirable pattern could not be obtained in the end.

### SOC Pattern Inversion Method (Examples 5-1 to 5-18, Comparative Examples 5-1 to 5-12)

The coating-type organic underlayer film composition (SOC-1) was applied as a resist underlayer film onto a silicon wafer substrate on which a SiO₂ film having a thickness of 300 nm is formed, and the substrate was then baked at 350°C for 60 seconds to form a resist underlayer film having a thickness of 80 nm. A silicon atom-containing resist middle layer composition (SOG-1) was applied thereto, followed by baking at 220°C for 60 seconds to form a resist middle layer film having a thickness of 35 nm. Then, a monolayer resist for ArF as a resist upper layer film composition was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The resist upper layer film composition (monolayer resist for ArF) and the liquid immersion top coat composition (TC-1) on the photoresist film were made of the same composition as that used in the patterning process (Example 4).

The coating-type organic underlayer film composition (SOC-1) was prepared by dissolving the polymer denoted by the resist underlayer film polymer (SOP1) in an organic solvent containing 0.1% by mass of FC-4430 (manufactured by Sumitomo 3M Limited) at the proportions shown in Table 11 and filtering the resulting solution through a filter made of a fluororesin having a pore size of 0.2 µm.

**[Table 11]**

| | Polymer | Organic Solvent |
|---|---|---|
| | (part by mass) | (part by mass) |
| SOC-1 | SOP1 (5) | Propylene Glycol Monoethyl Ether (95) |

The structural formula of the resist underlayer film polymer (SOP1) used herein is shown in Table 12.

**[Table 12]**

| Compound or Polymer | Mw | Mw /Mn |
|---|---|---|
| 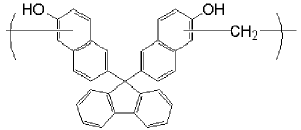 | 3700 | 2.82 |
| (SOP1) | | |

A silicon atom-containing resist middle layer composition (SOG-1) was prepared by dissolving a polymer denoted by the ArF silicon-containing middle layer film polymer (SiP1) and a crosslinking catalyst (CAT1) in an organic solvent containing 0.1% by mass of FC-4430 (manufactured by Sumitomo 3M Limited) at the proportions shown in Table 13 and filtering the resulting solution through a filter made of a fluororesin having a pore size of 0.1 µm.

**[Table 13]**

| | Polymer | Thermal Crosslinking Catalyst | Organic Solvent |
|---|---|---|---|
| | (part by mass) | (part by mass) | (part by mass) |
| SOG-1 | SiP1 (100) | CAT1 (1) | Propylene Glycol Monoethyl Ether (4000) |

The structural formulae of the ArF silicon-containing middle layer film polymer (SiP1) and the crosslinking catalyst (CAT1) used herein are shown below.

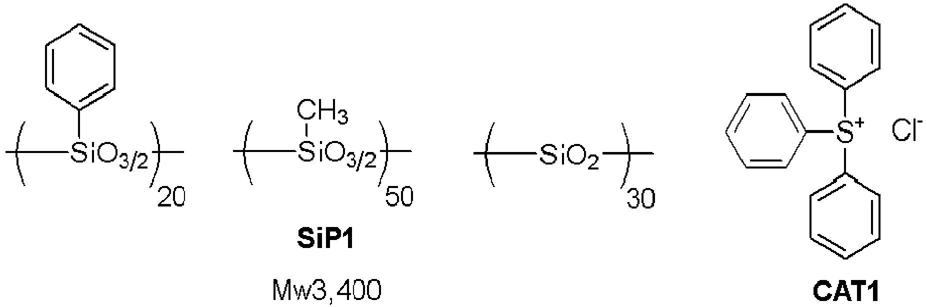

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38 % by mass of tetramethylammonium hydroxide (TMAH) aqueous solution for 30 seconds, thereby obtaining a 55 nm 1:1 positive line-and-space pattern.

Then, the silicon atom-containing resist middle layer composition (SOG-1) was etched by dry etching while using the resist pattern as a mask using an etching apparatus Telius manufactured by Tokyo Electron Ltd. to form a hard mask pattern. Then, a resist underlayer film (SOC-1) was etched while using the obtained hard mask pattern as a mask to form a SOC-1 film pattern. The etching conditions are as follows.

### Conditions in transferring resist upper layer film pattern to SOG-1 film

Chamber pressure: 50 mT
RF-power (upper portion): 500W
RF-power (lower portion): 300W
CF₄ gas flow rate: 150 sccm
CHF₃ gas flow rate: 50 sccm
Time: 20 sec

### Conditions in transferring SOG-1 film pattern to SOC-1 film

Chamber pressure: 10 mT
RF-power (upper portion): 1000W
RF-power (lower portion): 300W
CO₂ gas flow rate: 150 sccm
CO gas flow rate: 50 sccm
N₂ gas flow rate: 50 sccm
H₂ gas flow rate: 150 sccm
Time: 60 sec

Next, the compositions for forming a metal oxide film described above (UDL-1 to 18, Comparative UDL-1 to 11) were each applied onto the obtained SOC-1 film pattern, followed by baking in the atmosphere at 350°C for 60 seconds to form a metal oxide film having a thickness of 100 nm. Thereafter, the metal oxide film covering the SOC-1 film pattern was etched to expose the upper surface of the SOC-1 film pattern. The SOG-1 film remaining on the surface of the SOC-1 film pattern with the exposed upper surface was removed by etching, then the exposed SOC-1 was removed by etching, the above pattern was inverted onto a metal oxide film, and the SiO₂ film was etched while using the obtained metal oxide film pattern as a mask. As a Comparative Example, etching of the SiO₂ film was performed using the SOC-1 film pattern as a mask without using the composition for forming a metal oxide film (Comparative Example 5-12).

The etching conditions are as follows.

### Conditions in etch-back of metal oxide film (exposure of SOC-1 film pattern)

Chamber pressure: 15 mT
RF-power (upper portion): 300W
RF-power (lower portion): 50W
O₂ gas flow rate: 30 sccm
N₂ gas flow rate: 270 sccm
Time: 60 sec

### Removal of SOG-1 film remaining on the SOC-1 film pattern

Chamber pressure: 50 mT
RF-power (upper portion): 500W
RF-power (lower portion): 300W
CF₄ gas flow rate: 150 sccm
CHF₃ gas flow rate: 50 sccm
Time: 15 sec

### Removal of SOC-1 film pattern

Chamber pressure: 10 mT
RF-power (upper portion): 1000W
RF-power (lower portion): 300W
CO₂ gas flow rate: 150 sccm
CO gas flow rate: 50 sccm
N₂ gas flow rate: 50 sccm
H₂ gas flow rate: 150 sccm
Time: 60 sec

### Conditions in transferring metal oxide film pattern to SiO₂ film

Chamber pressure: 10 mT
RF-power (upper portion): 100W
RF-power (lower portion): 800W
CF₄ gas flow rate: 25 sccm
CHF₃ gas flow rate: 15 sccm
O₂ gas flow rate: 5 sccm
Time: 200 sec

### Comparative Example 5-12: Conditions in transferring SOC-1 film pattern to SiO₂ film

Chamber pressure: 10 mT
RF-power (upper portion): 100W
RF-power (lower portion): 800W
CF₄ gas flow rate: 25 sccm
CHF₃ gas flow rate: 15 sccm
O₂ gas flow rate: 5 sccm
Time: 200 sec

Table 14 shows the results obtained by observation of the pattern cross section with an electron microscope (S-4700) manufactured by Hitachi, Ltd.

**[Table 14]**

| | Composition for Forming a Metal Oxide Film | Baking Temperature | Pattern Shape After SOC Pattern Inversion |
|---|---|---|---|
| Example 5-1 | UDL-1 | 350°C×60 seconds | Vertical Shape |
| Example 5-2 | UDL-2 | 350°C×60 seconds | Vertical Shape |
| Example 5-3 | UDL-3 | 350°C×60 seconds | Vertical Shape |
| Example 5-4 | UDL-4 | 350°C×60 seconds | Vertical Shape |
| Example 5-5 | UDL-5 | 350°C×60 seconds | Vertical Shape |
| Example 5-6 | UDL-6 | 350°C×60 seconds | Vertical Shape |
| Example 5-7 | UDL-7 | 350°C×60 seconds | Vertical Shape |
| Example 5-8 | UDL-8 | 350°C×60 seconds | Vertical Shape |
| Example 5-9 | UDL-9 | 350°C×60 seconds | Vertical Shape |
| Example 5-10 | UDL-10 | 350°C×60 seconds | Vertical Shape |
| Example 5-11 | UDL-11 | 350°C×60 seconds | Vertical Shape |
| Example 5-12 | UDL-12 | 350°C×60 seconds | Vertical Shape |
| Example 5-13 | UDL-13 | 350°C×60 seconds | Vertical Shape |
| Example 5-14 | UDL-14 | 350°C×60 seconds | Vertical Shape |
| Example 5-15 | UDL-15 | 350°C×60 seconds | Vertical Shape |
| Example 5-16 | UDL-16 | 350°C×60 seconds | Vertical Shape |
| Example 5-17 | UDL-17 | 350°C×60 seconds | Vertical Shape |
| Example 5-18 | UDL-18 | 350°C×60 seconds | Vertical Shape |
| Comparative Example 5-1 | Comparative Example UDL-1 | 350°C×60 seconds | Pattern Collapse Observed |
| Comparative Example 5-2 | Comparative Example UDL-2 | 350°C×60 seconds | No Pattern |
| Comparative Example 5-3 | Comparative Example UDL-3 | 350°C×60 seconds | Pattern Collapse Observed |
| Comparative Example 5-4 | Comparative Example UDL-4 | 350°C×60 seconds | Pattern Distortion Observed |
| Comparative Example 5-5 | Comparative Example UDL-5 | 350°C×60 seconds | Pattern Distortion Observed |
| Comparative Example 5-6 | Comparative Example UDL-6 | 350°C×60 seconds | Pattern Collapse Observed |
| Comparative Example 5-7 | Comparative Example UDL-7 | 350°C×60 seconds | Pattern Collapse Observed |
| Comparative Example 5-8 | Comparative Example UDL-8 | 350°C×60 seconds | Pattern Distortion Observed |
| Comparative Example 5-9 | Comparative Example UDL-9 | 350°C×60 seconds | Pattern Collapse Observed |
| Comparative Example 5-10 | Comparative Example UDL-10 | 350°C×60 seconds | Pattern Distortion Observed |
| Comparative Example 5-11 | Comparative Example UDL-11 | 350°C×60 seconds | Pattern Collapse Observed |
| Comparative Example 5-12 | - | 350°C×60 seconds | Pattern Distortion Observed |

As shown in Table 14, Examples 5-1 to 5-18 using the composition for forming a metal oxide film of the present invention (UDL-1 to 18) are all capable of accurately inverting the SOC-1 film pattern, and the reverse pattern is desirably transferred to the substrate in the end without pattern collapse. It was thus confirmed that the composition for forming a metal oxide film of the present invention can be suitably used for fine processing using the tone-reversal etching method of the multilayer resist process method. On the other hand, in Comparative Example 5-12 in which the SOC-1 film pattern was directly transferred to the SiO₂ film, the etching resistance of the SOC-1 film was insufficient, and therefore, the distortion of the pattern shape was confirmed. Further, in Comparative Examples 5-1, 5-3, 5-6, 5-7, 5-9, and 5-11 in which insufficient performance was confirmed in the evaluation of filling property and the evaluation of planarizing property, pattern collapse occurred at the time of pattern processing, and a desirable reverse pattern could not be obtained in the end. On the other hand, in Comparative Examples 5-4, 5-5, 5-8, and 5-10 in which the evaluation of the filling property and the evaluation of the planarization property were desirable but the performance was found insufficient in the evaluation of the dry etching resistance, distortion of the pattern shape occurred at the time of pattern inversion processing, and a desirable reverse pattern could not be obtained in the end. In addition, in Comparative Example 5-2 in which the etching selectivity with respect to the SOC-1 film was insufficient, formation of a pattern was not confirmed.

It was thus revealed that the composition for forming a metal oxide film of the present invention, which has both high filling/planarizing properties and dry etching resistance, is significantly useful as a resist underlayer film composition used in the multilayer resist method and as an inverting agent used in the tone-reversal etching method, and that the patterning process of the present invention using this composition is capable of forming fine patterns with a high degree of accuracy even when a body to be processed is a substrate having a step.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

### EMBODIMENTS

1. A composition for forming a metal oxide film, comprising:
   (A) a metal oxide nanoparticle, (B) a flowability accelerator, which is a compound and/or a polymer having a molecular weight of 5000 or less represented by one or more selected from the following general formulae (I), (II) and (III), and (C) an organic solvent,
      wherein a weight ratio of the (A) metal oxide nanoparticle to the (B) flowability accelerator is 10/90 to 90/10, 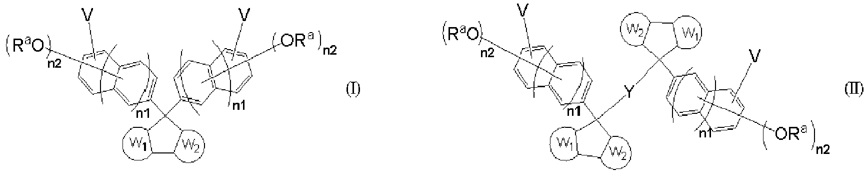
      wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} is a hydrogen atom, a saturated hydrocarbon group having 1 to 10 carbon atoms, or an unsaturated hydrocarbon group having 2 to 10 carbon atoms; Y is a group represented by the following general formula (1); n1 is 0 or 1; n2 is 1 or 2; and V independently represents a hydrogen atom or a connection portion, 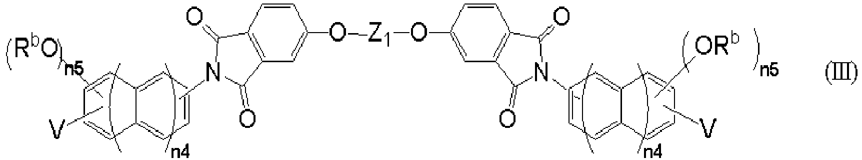
      wherein Z₁ is a group represented by the following general formula (2); R^{b} is a hydrogen atom, a saturated hydrocarbon group having 1 to 10 carbon atoms, or an unsaturated hydrocarbon group having 2 to 10 carbon atoms; n4 is 0 or 1; n5 is 1 or 2; and V independently represents a hydrogen atom or a connection portion, 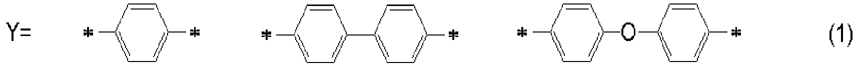
      wherein * represents a bonding arm, 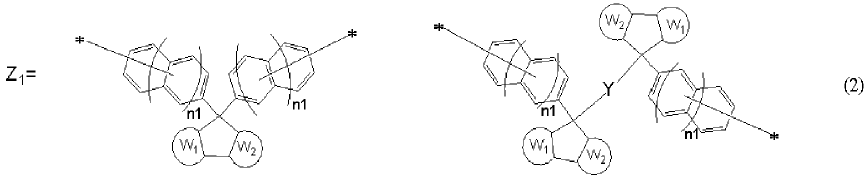
      wherein W₁, W₂, Y, and n1 are as defined above.
2. The composition for forming a metal oxide film according to claim 1, wherein the (A) metal oxide nanoparticle is one or more kinds of oxide nanoparticles of metals selected from the group consisting of zirconium, hafnium, aluminum, tungsten, titanium, copper, tin, cerium, indium, zinc, yttrium, lanthanum, chromium, cobalt, platinum, iron, antimony, and germanium.
3. The composition for forming a metal oxide film according to claim 1 or 2, wherein the (A) metal oxide nanoparticle is one or more selected from the group consisting of zirconium oxide nanoparticles, hafnium oxide nanoparticles, tungsten oxide nanoparticles, titanium oxide nanoparticles, and tin oxide nanoparticles.
4. The composition for forming a metal oxide film according to any one of claims 1 to 3, wherein the (A) metal-oxide nanoparticle has an average primary particle size of 100 nm or less.
5. The composition for forming a metal oxide film according to any one of claims 1 to 4, wherein the (B) flowability accelerator is a compound represented by one or more selected from the following general formulae (3), (4) and (5), 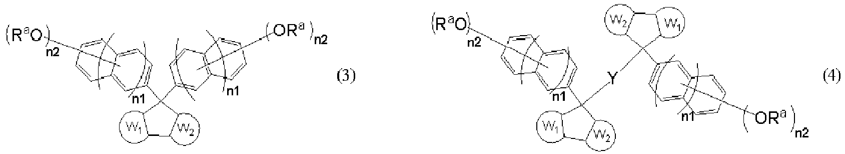 wherein W₁, W₂, R^{a}, Y, n1 and n2 are as defined above, 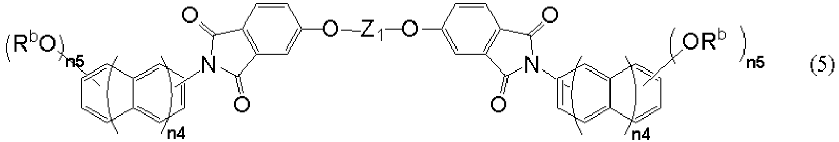 wherein Z₁, R^{b}, n4 and n5 are as defined above.
6. The composition for forming a metal oxide film according to any one of claims 1 to 4, wherein the (B) flowability accelerator is a polymer having a repeating unit represented by one or more selected from the following general formulae (6), (7) and (8), 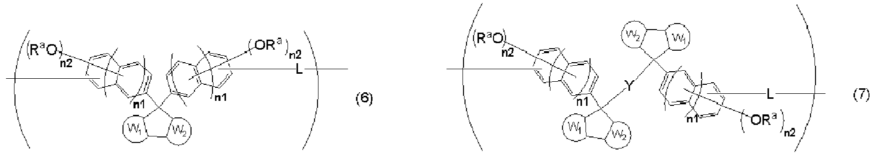 wherein W₁, W₂, R^{a}, Y, n1 and n2 are as defined above, and L is a divalent organic group having 1 to 40 carbon atoms, 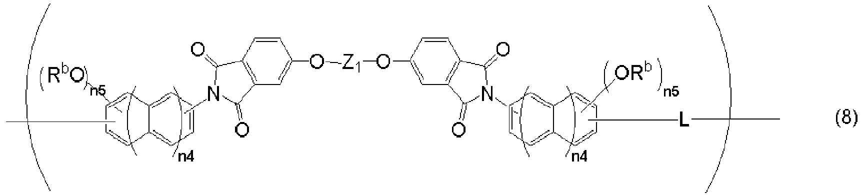 wherein Z₁, R^{b}, n4 and n5 are as defined above, and L is a divalent organic group having 1 to 40 carbon atoms.
7. The composition for forming a metal oxide film according to any one of claims 1 to 4, wherein the composition for forming a metal oxide film contains, as the component (B), one or more compounds represented by the following general formulae (3) to (5) and one or more polymers having repeating structural units represented by the following general formulae (6) to (8), 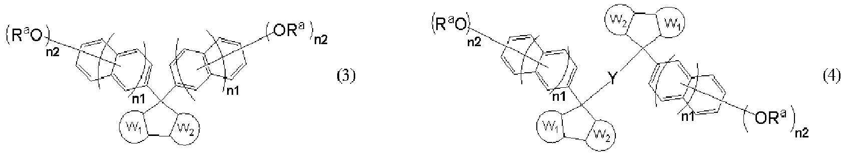 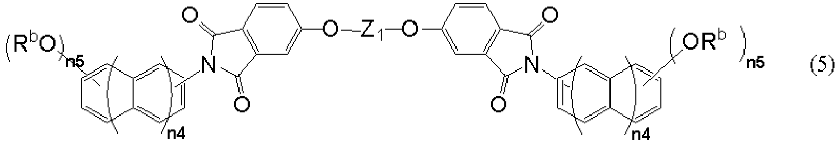 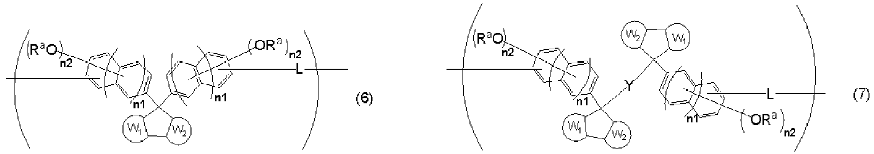 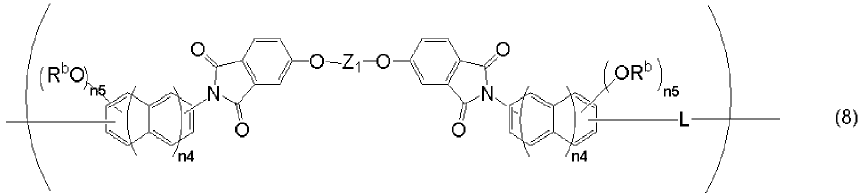 wherein W₁, W₂, R^{a}, Y, n1, n2, Z₁, R^{b}, n4 and n5 are as defined above, and L is a divalent organic group having 1 to 40 carbon atoms.
8. The composition for forming a metal oxide film according to any one of claims 1 to 7, wherein R^{a} in the general formulae (I) and (II) and R^{b} in the general formula (III) are each a hydrogen atom or a structure represented by the following general formula (9), 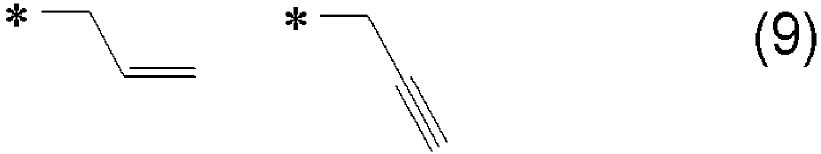 wherein * represents a portion bonded with an oxygen atom.
9. The composition for forming a metal oxide film according to claim 8, wherein, among the R^{a} and R^{b}, when a proportion of hydrogen atom is "a" and a proportion of the structure represented by the general formula (9) is "b", the component (B) as a whole satisfies relationships: a+b=1 and 0.2≦b≦0.8.
10. The composition for forming a metal oxide film according to claim 5 or 7, wherein a ratio Mw/Mn (i.e., dispersity), which is a ratio of a weight average molecular weight Mw to a number average molecular weight Mn on polystyrene basis according to gel permeation chromatography, of the compound represented by one or more selected from the general formulae (3), (4) and (5) is within a range of 1.00≦Mw/Mn≦1.25 for each compound.
11. The composition for forming a metal oxide film according to claim 6 or 7, wherein the L is a divalent organic group represented by the following general formula (10), 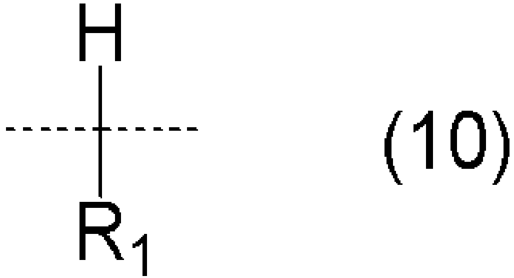 wherein R₁ is a hydrogen atom or an organic group with an aromatic ring having 6 to 20 carbon atoms, and a dashed line represents a bonding arm.
12. The composition for forming a metal oxide film according to claim 6, 7, or 11, wherein a weight average molecular weight on polystyrene basis according to gel permeation chromatography of the polymer represented by one or more selected from the general formulae (6), (7) and (8) is 1000 to 5000.
13. The composition for forming a metal oxide film according to any one of claims 1 to 12, wherein the (C) organic solvent is a mixture of one or more organic solvents having a boiling point of lower than 180°C and one or more organic solvents having a boiling point of 180°C or higher.
14. The composition for forming a metal oxide film according to any one of claims 1 to 13, wherein the composition for forming a metal oxide film further comprises one or more of a crosslinking agent, a surfactant, an acid generator, a plasticizer, and a blend polymer.
15. The composition for forming a metal oxide film according to any one of claims 1 to 14, wherein the blend polymer is a polymer comprising the following general formula (BP), 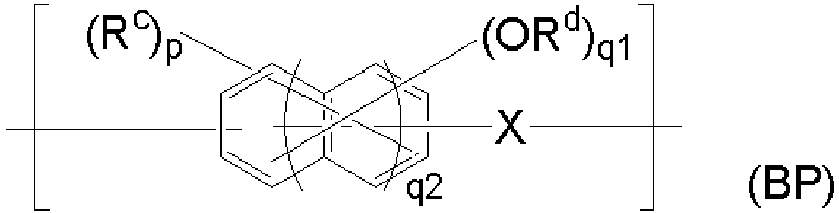 wherein R^{c} is a saturated or unsaturated monovalent organic group having 1 to 10 carbon atoms; R^{d} is a hydrogen atom, a saturated hydrocarbon group having 1 to 10 carbon atoms, or an unsaturated hydrocarbon group having 2 to 10 carbon atoms; X is a bivalent organic group having 1 to 30 carbon atoms; "p" is an integer of 0 to 5; q1 is an integer of 1 to 6; p+q1 is an integer of 1 or more and 6 or less; and q2 is 0 or 1.
16. A patterning process for forming a pattern in a substrate to be processed, comprising steps of:
   (I-1) applying the composition for forming a metal oxide film according to any one of claims 1 to 15 onto a substrate to be processed, followed by heating to form a metal oxide film;
   (I-2) forming a resist upper layer film on the metal oxide film by using a photoresist material;
   (I-3) subjecting the resist upper layer film to pattern exposure and then development with a developer to form a pattern in the resist upper layer film;
   (I-4) transferring the pattern to the metal oxide film by dry etching while using the resist upper layer film having the formed pattern as a mask; and
   (I-5) processing the substrate to be processed while using the metal oxide film having the formed pattern as a mask to form the pattern in the substrate to be processed.
17. A patterning process for forming a pattern in a substrate to be processed, comprising steps of:
   (II-1) applying the composition for forming a metal oxide film according to any one of claims 1 to 15 onto a substrate to be processed, followed by heating to form a metal oxide film;
   (II-2) forming a silicon-containing resist middle layer film on the metal oxide film by using a material for a silicon-containing resist middle layer film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry etching while using the resist upper layer film having the formed pattern as a mask;
   (II-6) transferring the pattern to the metal oxide film by dry etching while using the resist middle layer film having the transferred pattern as a mask; and
   (II-7) processing the substrate to be processed while using the metal oxide film having the formed pattern as a mask to form the pattern in the substrate to be processed.
18. A patterning process for forming a pattern in a substrate to be processed, comprising steps of:
   (III-1) applying the composition for forming a metal oxide film according to any one of claims 1 to 15 onto a substrate to be processed, followed by heating to form a metal oxide film;
   (III-2) forming an inorganic hard mask middle layer film selected from a silicon oxide film, a silicon nitride film, and a silicon oxynitride film on the metal oxide film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal oxide film by dry etching while using the inorganic hard mask middle layer film having the transferred pattern as a mask; and
   (III-8) processing the substrate to be processed while using the metal oxide film having the formed pattern as a mask to form the pattern in the substrate to be processed.
19. A patterning process for forming a pattern in a substrate to be processed, comprising steps of:
   (IV-1) forming a resist underlayer film on a substrate to be processed;
   (IV-2) forming a resist middle layer film, or a combination of an inorganic hard mask middle layer film selected from a silicon oxide film, a silicon nitride film, and a silicon oxynitride film and an organic thin film on the resist underlayer film;
   (IV-3) forming a resist upper layer film on the resist middle layer film, or the combination of the inorganic hard mask middle layer film and the organic thin film by using a photoresist material;
   (IV-4) subjecting the resist upper layer film to pattern exposure and then development with a developer to form a pattern in the resist upper layer film;
   (IV-5) transferring a pattern to the resist middle layer film or the organic thin film and the inorganic hard mask middle layer film by dry etching while using the resist upper layer film having the formed pattern as a mask;
   (IV-6) transferring a pattern to the resist underlayer film by dry etching while using the resist middle layer film or the inorganic hard mask middle layer film having the transferred pattern as a mask;
   (IV-7) applying the composition for forming a metal oxide film according to any one of claims 1 to 15 onto the resist underlayer film having the formed pattern, followed by heating to cover the resist underlayer film with a metal oxide film, thereby filling a space between the resist underlayer film patterns with the metal oxide film;
   (IV-8) etching back the metal oxide film covering the resist underlayer film having the formed pattern by a chemical stripper or dry etching to expose an upper surface of the resist underlayer film having the formed pattern;
   (IV-9) removing the resist middle layer film or the hard mask middle layer film remaining on the upper surface of the resist underlayer film by dry etching;
   (IV-10) removing the resist underlayer film having the formed pattern with its surface exposed by dry etching to form a reverse pattern of an original pattern on the metal oxide film;
   (IV-11) processing the substrate to be processed while using the metal oxide film having the formed reversal pattern as a mask to form a tone-reversal pattern in the substrate to be processed.
20. The patterning process according to any one of claims 16 to 19, wherein the substrate to be processed has a structure or a step with a height of 30 nm or more.
21. A method for forming a metal oxide film that serves as a planarizing film employed in a semiconductor apparatus manufacturing process, the method comprising:
   spin-coating a substrate to be processed with the composition for forming a metal oxide film according to any one of claims 1 to 15; and
   heating the substrate coated with the composition for forming a metal oxide film at a temperature of 100°C or higher and 600°C or lower for 10 to 600 seconds to form a cured film.
22. A method for forming a metal oxide film that serves as a planarizing film employed in a semiconductor apparatus manufacturing process, the method comprising:
   spin-coating a substrate to be processed with the composition for forming a metal oxide film according to any one of claims 1 to 15; and
   heating the substrate coated with the composition for forming a metal oxide film under an atmosphere with an oxygen concentration of 1 volume % or more and 21 volume % or less to form a cured film.
23. A method for forming a metal oxide film that serves as a planarizing film employed in a semiconductor apparatus manufacturing process, the method comprising:
   spin-coating a substrate to be processed with the composition for forming a metal oxide film according to any one of claims 1 to 15; and
   heating the substrate coated with the composition for forming a metal oxide film under an atmosphere with an oxygen concentration of less than 1 volume % to form a cured film.

## Claims

1. A composition for forming a metal oxide film, comprising:
(A) a metal oxide nanoparticle, (B) a flowability accelerator, which is a compound and/or a polymer having a molecular weight of 5000 or less represented by one or more selected from the following general formulae (I), (II) and (III), and (C) an organic solvent,
wherein a weight ratio of the (A) metal oxide nanoparticle to the (B) flowability accelerator is 10/90 to 90/10, 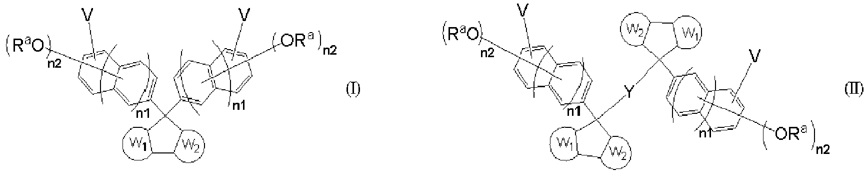
wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} is a hydrogen atom, a saturated hydrocarbon group having 1 to 10 carbon atoms, or an unsaturated hydrocarbon group having 2 to 10 carbon atoms; Y is a group represented by the following general formula (1); n1 is 0 or 1; n2 is 1 or 2; and V independently represents a hydrogen atom or a connection portion, 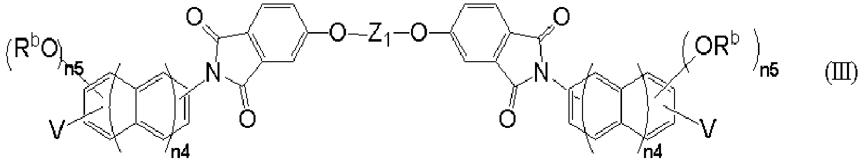
wherein Z₁ is a group represented by the following general formula (2); R^{b} is a hydrogen atom, a saturated hydrocarbon group having 1 to 10 carbon atoms, or an unsaturated hydrocarbon group having 2 to 10 carbon atoms; n4 is 0 or 1; n5 is 1 or 2; and V independently represents a hydrogen atom or a connection portion, 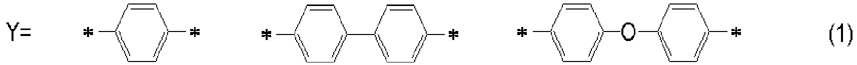
wherein * represents a bonding arm, 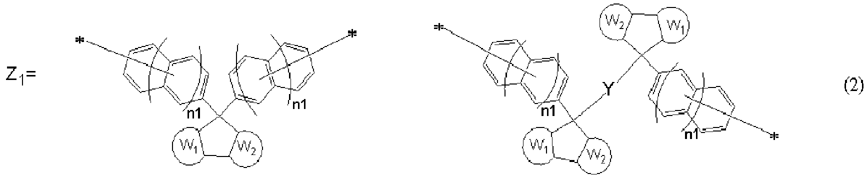
wherein W₁, W₂, Y, and n1 are as defined above.

2. The composition for forming a metal oxide film according to claim 1, wherein the (A) metal oxide nanoparticle is one or more kinds of oxide nanoparticles of metals selected from the group consisting of zirconium, hafnium, aluminum, tungsten, titanium, copper, tin, cerium, indium, zinc, yttrium, lanthanum, chromium, cobalt, platinum, iron, antimony, and germanium.

3. The composition for forming a metal oxide film according to claim 1 or 2, wherein the (A) metal oxide nanoparticle is one or more selected from the group consisting of zirconium oxide nanoparticles, hafnium oxide nanoparticles, tungsten oxide nanoparticles, titanium oxide nanoparticles, and tin oxide nanoparticles.

4. The composition for forming a metal oxide film according to any one of claims 1 to 3, wherein the (A) metal-oxide nanoparticle has an average primary particle size of 100 nm or less.

5. The composition for forming a metal oxide film according to any one of claims 1 to 4, wherein
a)
the (B) flowability accelerator is a compound represented by one or more selected from the following general formulae (3), (4) and (5), 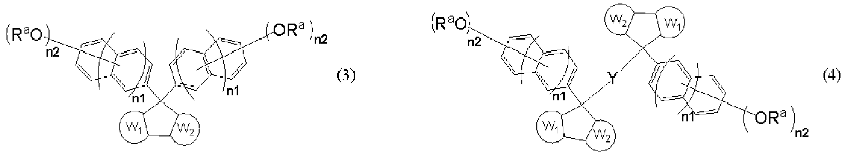 wherein W₁, W₂, R^{a}, Y, n1 and n2 are as defined above, 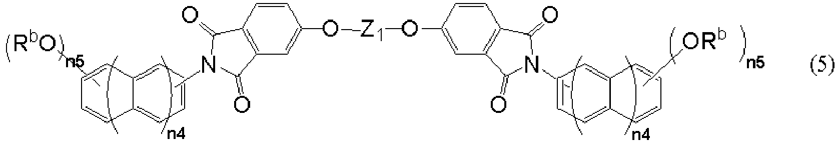 wherein Z₁, R^{b}, n4 and n5 are as defined above; or
b)
the (B) flowability accelerator is a polymer having a repeating unit represented by one or more selected from the following general formulae (6), (7) and (8), 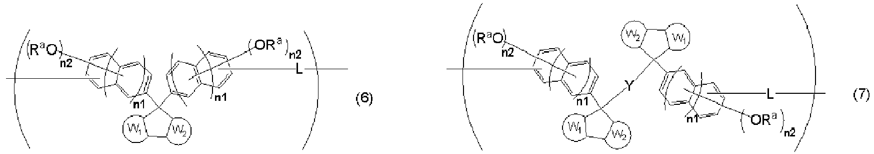 wherein W₁, W₂, R^{a}, Y, n1 and n2 are as defined above, and L is a divalent organic group having 1 to 40 carbon atoms, 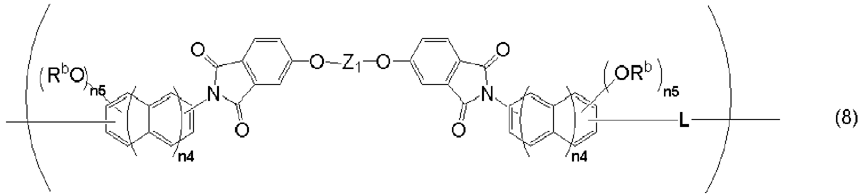 wherein Z₁, R^{b}, n4 and n5 are as defined above, and L is a divalent organic group having 1 to 40 carbon atoms; or
c)
the composition for forming a metal oxide film contains, as the component (B), one or more compounds represented by the following general formulae (3) to (5) and one or more polymers having repeating structural units represented by the following general formulae (6) to (8), 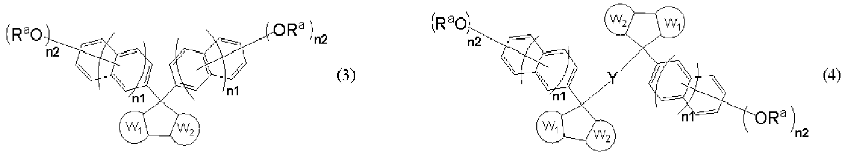 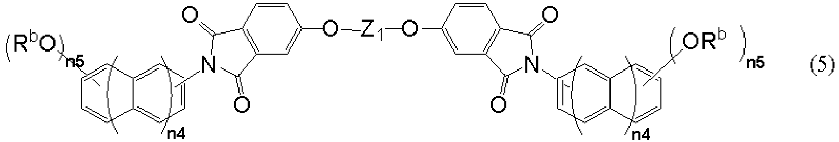 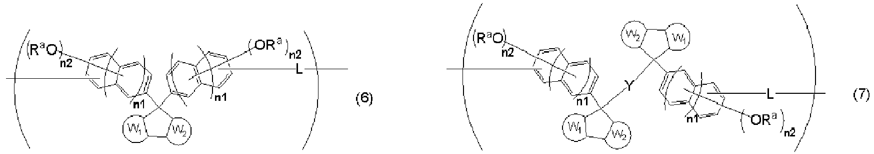 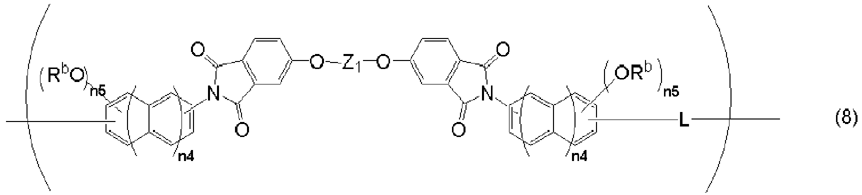 wherein W₁, W₂, R^{a}, Y, n1, n2, Z₁, R^{b}, n4 and n5 are as defined above, and L is a divalent organic group having 1 to 40 carbon atoms.

6. The composition for forming a metal oxide film according to any one of claims 1 to 5, wherein R^{a} in the general formulae (I) and (II) and R^{b} in the general formula (III) are each a hydrogen atom or a structure represented by the following general formula (9), 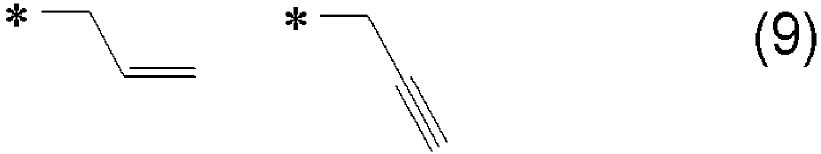 wherein * represents a portion bonded with an oxygen atom; preferably wherein, among the R^{a} and R^{b}, when a proportion of hydrogen atom is "a" and a proportion of the structure represented by the general formula (9) is "b", the component (B) as a whole satisfies relationships: a+b=1 and 0.2≦b≦0.8.

7. The composition for forming a metal oxide film according to claim 5a or 5c, wherein a ratio Mw/Mn (i.e., dispersity), which is a ratio of a weight average molecular weight Mw to a number average molecular weight Mn on polystyrene basis according to gel permeation chromatography, of the compound represented by one or more selected from the general formulae (3), (4) and (5) is within a range of 1.00≦Mw/Mn≦1.25 for each compound.

8. The composition for forming a metal oxide film according to claim 5b or 5c, wherein the L is a divalent organic group represented by the following general formula (10), 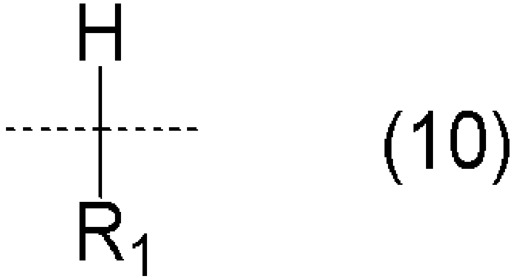 wherein R₁ is a hydrogen atom or an organic group with an aromatic ring having 6 to 20 carbon atoms, and a dashed line represents a bonding arm.

9. The composition for forming a metal oxide film according to claim 5b, 5c, or 8, wherein a weight average molecular weight on polystyrene basis according to gel permeation chromatography of the polymer represented by one or more selected from the general formulae (6), (7) and (8) is 1000 to 5000.

10. The composition for forming a metal oxide film according to any one of claims 1 to 9, wherein the (C) organic solvent is a mixture of one or more organic solvents having a boiling point of lower than 180°C and one or more organic solvents having a boiling point of 180°C or higher.

11. The composition for forming a metal oxide film according to any one of claims 1 to 10, wherein the composition for forming a metal oxide film further comprises one or more of a crosslinking agent, a surfactant, an acid generator, a plasticizer, and a blend polymer.

12. The composition for forming a metal oxide film according to any one of claims 1 to 11, wherein the blend polymer is a polymer comprising the following general formula (BP), 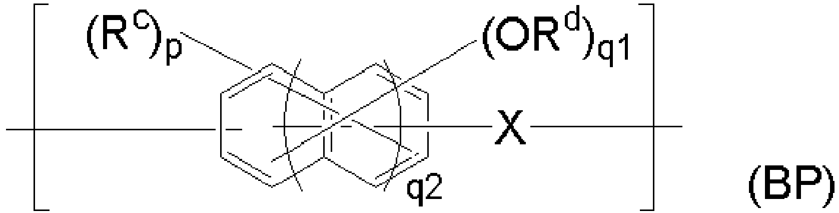 wherein R^{c} is a saturated or unsaturated monovalent organic group having 1 to 10 carbon atoms; R^{d} is a hydrogen atom, a saturated hydrocarbon group having 1 to 10 carbon atoms, or an unsaturated hydrocarbon group having 2 to 10 carbon atoms; X is a bivalent organic group having 1 to 30 carbon atoms; "p" is an integer of 0 to 5; q1 is an integer of 1 to 6; p+q1 is an integer of 1 or more and 6 or less; and q2 is 0 or 1.

13. A patterning process for forming a pattern in a substrate to be processed, comprising steps of:
a)
(I-1) applying the composition for forming a metal oxide film according to any one of claims 1 to 12 onto a substrate to be processed, followed by heating to form a metal oxide film;
(I-2) forming a resist upper layer film on the metal oxide film by using a photoresist material;
(I-3) subjecting the resist upper layer film to pattern exposure and then development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern in the substrate to be processed; or
b)
(II-1) applying the composition for forming a metal oxide film according to any one of claims 1 to 12 onto a substrate to be processed, followed by heating to form a metal oxide film;
(II-2) forming a silicon-containing resist middle layer film on the metal oxide film by using a material for a silicon-containing resist middle layer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal oxide film by dry etching while using the resist middle layer film having the transferred pattern as a mask; and
(II-7) processing the substrate to be processed while using the metal oxide film having the formed pattern as a mask to form the pattern in the substrate to be processed; or
c)
(III-1) applying the composition for forming a metal oxide film according to any one of claims 1 to 12 onto a substrate to be processed, followed by heating to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern in the substrate to be processed; or
d)
(IV-1) forming a resist underlayer film on a substrate to be processed;
(IV-2) forming a resist middle layer film, or a combination of an inorganic hard mask middle layer film selected from a silicon oxide film, a silicon nitride film, and a silicon oxynitride film and an organic thin film on the resist underlayer film;
(IV-3) forming a resist upper layer film on the resist middle layer film, or the combination of the inorganic hard mask middle layer film and the organic thin film by using a photoresist material;
(IV-4) subjecting the resist upper layer film to pattern exposure and then development with a developer to form a pattern in the resist upper layer film;
(IV-5) transferring a pattern to the resist middle layer film or the organic thin film and the inorganic hard mask middle layer film by dry etching while using the resist upper layer film having the formed pattern as a mask;
(IV-6) transferring a pattern to the resist underlayer film by dry etching while using the resist middle layer film or the inorganic hard mask middle layer film having the transferred pattern as a mask;
(IV-7) applying the composition for forming a metal oxide film according to any one of claims 1 to 12 onto the resist underlayer film having the formed pattern, followed by heating to cover the resist underlayer film with a metal oxide film, thereby filling a space between the resist underlayer film patterns with the metal oxide film;
(IV-8) etching back the metal oxide film covering the resist underlayer film having the formed pattern by a chemical stripper or dry etching to expose an upper surface of the resist underlayer film having the formed pattern;
(IV-9) removing the resist middle layer film or the hard mask middle layer film remaining on the upper surface of the resist underlayer film by dry etching;
(IV-10) removing the resist underlayer film having the formed pattern with its surface exposed by dry etching to form a reverse pattern of an original pattern on the metal oxide film;
(IV-11) processing the substrate to be processed while using the metal oxide film having the formed reversal pattern as a mask to form a tone-reversal pattern in the substrate to be processed.

14. The patterning process according to claim 13, wherein the substrate to be processed has a structure or a step with a height of 30 nm or more.

15. A method for forming a metal oxide film that serves as a planarizing film employed in a semiconductor apparatus manufacturing process, the method comprising:
a)
spin-coating a substrate to be processed with the composition for forming a metal oxide film according to any one of claims 1 to 12; and
heating the substrate coated with the composition for forming a metal oxide film at a temperature of 100°C or higher and 600°C or lower for 10 to 600 seconds to form a cured film; or
b)
spin-coating a substrate to be processed with the composition for forming a metal oxide film according to any one of claims 1 to 12; and
heating the substrate coated with the composition for forming a metal oxide film under an atmosphere with an oxygen concentration of 1 volume % or more and 21 volume % or less to form a cured film; or
c)
spin-coating a substrate to be processed with the composition for forming a metal oxide film according to any one of claims 1 to 12; and
heating the substrate coated with the composition for forming a metal oxide film under an atmosphere with an oxygen concentration of less than 1 volume % to form a cured film.
